(19) Europäisches Patentamt
European Patent Office
Office européen des brevets

(11) EP 0 737 889 A2

(12) EUROPEAN PATENT APPLICATION

(43) Date of publication:
**16.10.1996 Bulletin 1996/42**

(51) Int Cl.6: **G03C 7/30**, G03F 3/10

(21) Application number: **96105674.4**

(22) Date of filing: **11.04.1996**

(84) Designated Contracting States:
**DE FR GB IT**

(30) Priority: **13.04.1995 JP 88359/95**
**13.04.1995 JP 88360/95**
**18.05.1995 JP 119883/95**
**30.05.1995 JP 131924/95**
**13.06.1995 JP 146292/95**

(71) Applicant: **KONICA CORPORATION**
**Tokyo 160 (JP)**

(72) Inventors:
- **Tosaka, Yasuo**
**Odawara-shi, Kanagawa-ken (JP)**
- **Nonaka, Yoshiyuki**
**Odawara-shi, Kanagawa-ken (JP)**
- **Ohkawachi, Susumu**
**Odawara-shi, Kanagawa-ken (JP)**
- **Sasagawa, Masayuki**
**Odawara-shi, Kanagawa-ken (JP)**
- **Ishidai, Hiroshi**
**Odawara-shi, Kanagawa-ken (JP)**
- **Masumi, Satoshi**
**Odawara-shi, Kanagawa-ken (JP)**

(74) Representative: **Türk, Gille, Hrabal, Leifert**
**Brucknerstrasse 20**
**40593 Düsseldorf (DE)**

# (54) Silver halide color photographic light-sensitive material for preparing color proof and preparation method of color proof

(57) A silver halide color photographic light sensitive material for use in preparing color proofs based on color-separated yellow image information, magenta image information, cyan image information and black image information, in which at least a part of the halftone image information comprises a halftone image having the number of halftone dots of not less than $200x10^3$/inch$^2$ with a dot percentage of 40%, wherein the photographic material comprises a support having thereon a first layer containing a yellow image forming silver halide emulsion (Y-emulsion), a second layer containing a magenta image forming silver halide emulsion (M-emulsion) and a third layer containing a cyan image forming silver halide emulsion (C-emulsion), and a silver halide S-emulsion is contained in at least one of the first, second and third layers or another fourth layer to thereby form a black image upon exposure and processing, the Y-, M-, C- and S- emulsions each having spectral sensitivity wavelength regions respectively different from one another and having, in its spectral sensitivity region, a sensitivity at least six times higher than that of other three emulsions.

EP 0 737 889 A2

## Description

### FIELD OF THE PRESENT INVENTION

The present invention relates to a silver halide color photographic light-sensitive material suitable for use in preparing color proofs from plural pieces of halftone image information which are obtained by subjecting original images to color separation and halftone image conversion treatments in the color graphic arts and a color proof preparation method by use thereof.

### BACKGROUND OF THE INVENTION

There are methods for forming color images by using photo-polymers or diazo compounds, called the overlay method and the surprint method, which are conventionally known as methods for making color proofs from plural black-and-white halftone images prepared by subjecting originals to color separation and halftone image conversion treatments in the color plate-making/printing process.

The overlay method is very simple, inexpensive for proof preparation, and advantageous in that all what has to be done for color proof reading is to superpose film sheets for four different colors (the subtractive three primary colors plus black), but has the disadvantage that the superposition of the film sheet sresults in a glossy print, thus leading to providing an image quality different from that of the resulting print.

The surprint method is to superpose colored images on a support, and as this method, there are those for forming a colored image by toner development, utilizing the adhesion property of a photopolymerizable material, as described in U.S. Patent Nos. 3,582,327, 3,607,264 and 3,620,726.

Japanese Patent Examined Publication (hereinafter abbreviated to JP E.P.) No. 27441/1972 and Japanese Patent Open to Public Inspection (hereinafter abbreviated to Japanese Patent O.P.I. Publication) No. 501217/1981 describe another color proof making method in which a light-sensitive colored sheet is used to have its layer transferred onto a support, exposed and developed to form an image, then on the formed image layer is provided another light sensitive colored sheet's layer to be subjected to a similar process, and then repeating similar procedures, whereby a color proof is prepared.

Japanese Patent O.P.I. Publication No. 97140/1984 describes a method in which a colored light-sensitive sheet is exposed through a corresponding color-separation image film and developed to thereby form a colored image to be transferred onto a support, which is followed by forming and transferring onto the colored image in sequence other different colored images in the same manner, whereby a complete color image is formed on the support. For the toners and coloring agents for use in the formation of the above color image there may be used similar coloring materials to those for making printing inks, so that the resulting colors of the obtained color proof prepared by using them, is very near those of the actual prints.

The above-mentioned methods, however, require much labor for superposing and transferring the images onto a support in the color proof making process, so that they have the disadvantage that they take time and are costly.

For a solution to the above problems, Japanese Patent O.P.I. Publication Nos. 113139/1981, 104335/1981, 280746/1987, 280747/1987, 280748/1987, 280749/1987, 280750/1987 and 280849/1987 disclose methods for making color proofs by use of a silver halide color photographic light-sensitive material having a white support.

The method disclosed in the above publications is such that a plural number of color-separated black-and-white halftone halftone images obtained by color separation/halftone image conversion of a colored original are printed in sequence in the contact printing manner onto a single sheet of color photographic paper, which is then subjected to color development to thereby form a color image composed of dyes produced from the couplers; the thus formed color image is used as a color proof.

However, this technique has the following shortcomings. When a color proof is prepared so that a color image is brought close to that of the original print, the density of black images such as characters is insufficient compared to that of the original print, and when a color proof is prepared so that the black image density is enhanced to be close to that of the original print, closeness to the original print of the color image deteriorates. Therefore, it is difficult to obtain a color proof satisfying both image criteria.

Recently, from a viewpoint of improvement of the image quality of printed material, high definition plate-making and printing, and practical use thereof is strongly demanded. However, reproduction requirements for fine small dots are strict and improvement in repetitive reproducibility are requested. Therefore, it is a current status that high definition plate-making and printing has not been popularized widely. In addition, to obtain color proof of the high definition printing is confronting problems to be solved in the same manner as in plate-making and printing. Specifically, in color proof wherein a silver salt photographic system is applied, small dot reproducibility is desirable. However, when it is applied to high definition printing, undesirable reproduction is resulted in terms of dot reproducibility (dot gain) so that improvement is demanded. In addition, there are other problems such as that deterioration of reproduction of gray neutrality,

fluctuation of photographic processing conditions and neutrality fluctuation due to slight slippage of register marks.

With regard to a frequency modulation (FM) method, the same problems as in high definition printing occur. The FM screen method is explained in detail in "Printing Journal" 1994 (Vol. 77) No. 6, p. 49. Frequency (F) is used for describing the characteristics of wave so that the number of wave (frequency) is confirmed. In order to describe the height of wave, a concept of amplitude (A) is used. When a concept of frequency and a concept of amplitude are applied to the screening, a screen frequency (F) is regarded as the number of dots per cm and the width of dot concurrently. On the other hand, the amplitude (A) refers to as the size the dot has in terms of area. As known well, a conventional screening generates dots having different size each other and they are positioned at the same distance from each other. This can be referred to as an amplitude modulation (AM) screening. In a frequency modulation (FM) screening, though the size is always the same, the distance of each spot is different each other.

Japanese Patent O.P.I. Publication Nos. 260629/1989, 233732/1986 and 1632/1992 respectively describe a silver halide color photographic light-sensitive material having Y, M, C and black emulsion layers whose spectral sensitivity is different each other. However, they do not only describe the application of the high definition printing and the FM screening, which are high image quality printing capable of obtaining an image close to a printed material, to printing but also describe about shortcoming due to its application to the high image quality printing.

## SUMMARY OF THE INVENTION

Accordingly, an object of the present invention is to provide a silver halide color photographic light-sensitive material for preparing color proof wherein image quality such as halftone image and image density is prepared in a manner that the image quality is close to the printed material when preparing color proof base on halftone image information obtained through color separation and halftone image conversion by the use of a silver halide color photographic light-sensitive material and a preparation method of color proof.

The above-mentioned object of the present invention is attained by the following constitutions.

1. A silver halide color photographic light-sensitive material for preparing color proof which is exposed based on halftone image information composed of color-separated yellow image information, magenta image information, cyan image information and black image information, wherein at least a part of said halftone image information is converted to halftone image in such a manner that, when the dot area ratio (dot percentage) is 40%, the number of dots per 1 $inch^2$ is 200 x $10^3$ or more, said silver halide color photographic light-sensitive material comprising a support, having thereon a first layer containing a yellow image forming silver halide emulsion (Y emulsion), a second layer containing a magenta image forming silver halide emulsion (M emulsion), a third layer containing a cyan image forming silver halide emulsion (C emulsion) and a fourth layer containing a black image forming silver halide emulsion (S emulsion) and any one of the Y, M, C, and S emulsions has a spectral sensitivity wavelength region at least six times higher than the other three emulsions.

2. A preparation method of a color proof in which a silver halide color photographic material is exposed to light based on halftone image information comprised of color-separated yellow image information, magenta image information, cyan image information and black image information, wherein the silver halide color photographic material for preparing a color proof described in the above-mentioned item 1 is used.

3. The preparation method of a color proof described in item 2 above, wherein the above-mentioned halftone image information is prepared by frequency modulation.

4. The preparation method of a color proof described in item 2 or 3 above, wherein the above-mentioned halftone image information is halftone image information recorded on a film and exposure is conducted by bringing the above-mentioned film into close contact with the above-mentioned silver halide color photographic light-sensitive material and causing the light source to scan.

5. The preparation method of a color proof described in item 4 above, wherein exposure is conducted through an optical means for improving parallelity of the light from the above-mentioned light source.

## DETAILED DESCRIPTION OF THE INVENTION

The silver halide color photographic light-sensitive material for preparing color proofs of the present invention comprises a layer containing a yellow image forming silver halide emulsion (referred to as Y emulsion), a layer containing a magenta image forming silver halide emulsion (referred to as M emulsion), a layer containing a cyan image forming silver halide emulsion (referred to as C emulsion) and a layer containing a black image forming silver halide emulsion (referred to as S emulsion).

Here, the S emulsion for forming the black image may be any emulsion provided that it is capable of forming the black image upon image exposure and development. In a preferable example, the S emulsion may be used in combination with a black image layer containing a black coupler. In addition, in another preferable example, the S emulsion may be used in combination with a black image layer containing a yellow coupler, a magenta coupler and a cyan

coupler. In addition, in another preferable example, the S emulsion contributes to image forming of plural layers and the black image is formed due to combination of plural images caused by the development of the S emulsion. In one example forming the black image by the combination of plural images, for example, the S emulsion is contained in a yellow image layer for forming an yellow image, the S emulsion is also contained in the blue image (for example, when a magenta image and a cyan image is concurrently formed, a blue image is formed) which is a complementary color of a yellow image and the black image is formed by the development of the S emulsion. In addition, the S emulsion is contained in the magenta image forming layer and its complementary image forming layer, and the S emulsion is also contained in the cyan image forming layer and its complementary color image forming layer.

In the present invention, the relationship that a color image and another color image are complementary to each other preferably meets the following requirement. Thus, for example, in the case of an yellow image forming layer and a blue image forming layer, the color images of which are complementary to each other, both layers are color-developed to form a color image, which meets the following requirement represented in terms of a L*a*b* chromaticity diagram;

$$a*2 + b*2 \leqq 10^2\text{, preferably, } a^{*2} + b^{*2} \leqq 7^2.$$

With regard to the case of a magenta image and its complementary color image (a green image) or a cyan image and its complementary color image (a red image), the same requirements as above are met.

Another preferable example is that the S emulsion is contained in the yellow image forming layer, magenta image forming layer and the cyan image forming layer. As a result of the development of the S emulsion, the black image is formed. In the above-mentioned occasion, in the yellow image forming layer, the magenta image forming layer and the cyan image forming layer, the Y emulsion, the M emulsion and the C emulsion may either be contained, or may not be contained.

In more preferable embodiment of the present invention is that the S emulsion is contained in all of the yellow image forming silver halide emulsion layer, the magenta image forming silver halide emulsion layer and the cyan image forming silver halide emulsion layer.

Another more preferable embodiment of the present invention is that the S emulsion is contained in the black image forming silver halide emulsion layer.

In the present invention, the yellow image forming silver halide emulsion layer, the magenta image forming silver halide emulsion layer and the cyan image forming silver halide emulsion layer may be a single layer or plural layers. In addition, an order of coating from the support can arbitrarily be selected.

In the silver halide photographic light-sensitive material (hereinafter, referred to simply as "a light-sensitive material") for preparing color proofs, one of the Y, M, C, and S emulsions has a spectral sensitivity wavelength region at least six times higher than the other three emulsions. Namely, there is a spectral wavelength region where the sensitivity of the Y emulsion is at least six times higher than the other M, C, S emulsion. In the case of the M emulsion, C emulsion and S emulsion, there is a spectral wavelength region where the sensitivity of each emulsion is six times higher than the other three emulsions.

Preferably, in the case of the Y emulsion, the M emulsion, C emulsion and S emulsion, there is a spectral wavelength region where the sensitivity of each emulsion is at least eight times higher than the other three emulsions.

In one preferable embodiment each of the Y, M, C, and S emulsions has a maximum spectral sensitivity in a different spectral sensitivity wavelength region. When a light-sensitive material is exposed with a specific light giving around the maximum value in a spectral sensitivity wavelength region of one of Y, M, C and S emulsions, the exposed emulsion has a spectral sensitivity wavelength region at least six times higher than the other three emulsions. All of Y, M, C and S emulsions have such a spectral sensitivity region in a wavelength region giving around maximum value in the spectral sensitivity wavelength region.

In another preferable embodiment in a spectral sensitivity wavelength region of one of Y, M, C and S emulsions, a spectral sensitivity wavelength region having a sensitivity at least six times higher than the other three emulsions is present at other than a wavelength region giving around maximum value. In such case, a sensitivity difference between the emulsions of at least six times can be used.

In the preferable embodiment, Y, M, C and S emulsions have a different spectral sensitivity wavelength region and a different maximum sensitivity wavelength. The maximum sensitivity wavelength is different by preferably 20 nm or more, and more preferably by 30 nm or more.

The maximum sensitivity wavelength of the Y, M, C and S emulsions maybe any, so far as the above requirement is satisfied. The maximum sensitivity wavelength of each emulsion can be selected from the range of 350 to 900 nm. One preferable embodiment includes emulsions wherein the Y emulsion is a blue sensitive layer, the M emulsion is a green sensitive layer, the C emulsion is a red sensitive layer, and the S emulsion is an infrared sensitive layer. Another preferable embodiment includes emulsions wherein the Y emulsion has a maximum sensitivity in a wavelength region of 400 ± 30 nm, the M emulsion has a maximum sensitivity in a wavelength region of 460 ± 30 nm, the C emulsion

has a maximum sensitivity in a wavelength region of 540 ± 30 nm, and the S emulsion has a maximum sensitivity in a wavelength region of 640 ± 30 nm, and the maximum sensitivity wavelength difference between each emulsion is 20 nm or more. Still another preferable embodiment includes emulsions wherein the maximum sensitivity wavelength of the C emulsion, the Y emulsion, the M emulsion and the S emulsion are 580 nm, 660 nm, 750 nm and 850 nm, respectively. Further still another preferable embodiment includes emulsions wherein the maximum sensitivity wavelength of the Y emulsion, the M emulsion, the C emulsion and the S emulsion is 540 nm, 380 nm, 460 nm and 630 nm, respectively. However, the above samples are only exemplary examples, and the present invention is not limited thereto.

Each emulsion selected from the Y, M, C and S emulsions essentially has a spectral sensitivity wavelength region at least six times, and preferably eight times higher than a spectral sensitivity in the sensitivity wavelength of the other emulsions. The sensitivity herein referred to is represented by the reciprocal of exposure necessary to obtain a density of a maximum density minus 0.3.

The Y, M, C and S emulsions in the present invention can be sensitized with conventional sensitizers.

The light sensitive material in the present invention is preferably a positive working light sensitive material. The positive working light sensitive material includes a light sensitive material employing a direct positive process or a color reversal process, a light sensitive material employing a silver dye bleach process to obtain a positive image by bleaching a dye at the same time the silver in an imagewise formed silver image is bleached, and a light sensitive material employing a color diffusion transfer process.

In the present invention, in a process to prepare color proofs by conducting exposure to the silver halide photographic light-sensitive material based on halftone image information comprised of color-separated yellow image information, magenta image information, cyan image information and black image information, at least a part of the aforesaid halftone image information which is converted to halftone image in a manner that the number of dot per 1 inch$^2$ is 200 x10$^3$ when the dot percentage is 40% is used, and preferably 300 x10$^3$ or more , more preferably 400 x 10$^3$ and most preferably 400 x 10$^3$ through 2000 x 10$^3$.

In the present invention, the number of dots can be measured by calculating the halftone image photographed by means of an optical microscope

The halftone-image used in the present invention is specifically effective when it is a halftone image for high definition printing in conventional an AM screening method. In addition, the present invention is the most effective when it is the halftone image formed by a screening method referred to as a so-called FM screen method wherein the frequency is modulated. Namely, if a color proof is prepared from halftone image information, which was prepared by means of frequency modulation, and by means of a method other than the present invention, the average distance between each dot is kept at a distance larger than a certain distance when the dot % of the original is small. However, with an increase of the dot percentage, the average distance between each dot is progressively reduced in the case of frequency modulation compared to AM modulation. Accordingly, fluctuation of the neutrality of the dot percentage of the proof prepared compared to the dot percentage of the original is easier due to minute slippage of the register, which is a standard for processing and registration.

In the present invention, it is preferable that the above-mentioned halftone image information is a halftone image recorded on a film and that exposure is conducted by bringing with the above-mentioned film into close contact with the above-mentioned light-sensitive material and by causing the light source to scan. For the close contact, a vacuum contacting method is preferably used.

In the present invention, it is preferable to conduct exposure to light from the above-mentioned light source through an optical means for improving parallelity. As a means for improving the parallelity of light irradiated from the light source, an optical lens, a reflection mirror ora honeycomb structure wherein light other than parallel light is absorbed by a wall due to the light passing through a linear tube-type optical path, are cited. In addition, parallelity can be enhanced by means of an aggregate of optical fibers.

It is also preferable to conduct exposure by means of laser scanning based on the above-mentioned halftone image information.

Next, a reflective support used in the present invention will be explained.

It is preferable that the reflective support used in the present invention has a base paper, as base, laminated thereon with a polyolefine resin on both sides.

The raw material of the base paper used for the present invention can be selected from those ordinarily used for photographic paper. For example, natural pulp, synthetic pulp, mixtures of natural pulp and synthetic pulp and various raw materials for papering are cited. Ordinarily, conifer pulp, hard-wood pulp and natural pulp wherein a mixed pulp of a conifer pulp and a hard-wood pulp are the main component can widely be used.

In addition, in the above-mentioned support, additives used in papers ordinarily such as sizing agents, fixing agents, heavy duty strengthening agents, fillers, anti-static agents and dyes may be added. In addition, surface sizing agents, surface tension agents and anti-static agents may be coated appropriately on thesurfaces.

For the above-mentioned support, those, having a flat surface, whose weight is ordinarily 50 through 300 g/m$^2$ are preferably used. A resin, laminated on both surfaces may be selected from a single polymer such as ethylene, polyethylene terephthalate and α-olefines such as polypropylene, a copolymer of at least two kinds of the above-mentioned olefines and mixtures of at least two kinds of polymers. Speficially preferable polyolefine resins are a low density polyethylene, high density polyethylene or their admixture.

The molecular weight of the above-mentioned polyolefine resin is not specifically limited. However, normally, those within a range of 20,000 through 200,000 are preferable.

A polyolefine resin-laminated layer on one side of a photographic support used in the present invention, where a photographic emulsion is coated, is preferably 5 through 50 μm and more preferably 7 through 35 μm.

With regard to polyolefine used for laminating the rear side (an opposite side of the surface wherein emulsion layers are provided) of the support, ordinarily, a mixture of a low density polyethylene and a high density polyethylene is fused and laminated. This layer is generally subjected to matting processing.

In a polyolefine resin used for laminating the surface (on which emulsion layers are provided) of the support used in the present invention, preferably 13 through 20 weight % and more preferably 15 through 20 weight % of white pigment is dispersed and mixed.

As a white pigment, an inorganic and/or an organic white pigment can be used, including sulfate of alkaline earth metals such as barium sulfate, carbonate of alkaline earth metals such as calcium carbonate, silica such as fine powder silicic acid and synthetic silicate, calcium cilicate, alumina, alumina hydrate, titanium oxide, zinc oxide, talc and cray.

Of these, the preferable are barium sulfate, calcium carbonate and titanium oxide. The more preferable are barium sulfate and titanium oxide.

The titanium oxide may either be a rutile type or an anatase type. In addition, those laminated with a metal oxide such as alumina oxide hydrate and ferrite oxide hydrate are also used.

In addition, it is preferable to use an anti-oxidation agent, a colored pigment for improving whiteness and a fluorescent brightening agent.

When laminating the surface and a back side of the support, in order to enhance flatness of an exposed photographic paper in a normal environment, a means to increase the density of the resin layer on the surface slightly larger than the back side and a means to increase the amount of lamination of the back side greater than the surface are ordinarily adopted.

In addition, for lamination of the surface and a back side of the support ordinarily, a polyolefine resin component is formed on the support by means of a fusion extruding coating method. It addition, it is preferable that the surfaceof the support and, if necessary, both sides of the support are subjected to corona discharge processing and flame processing. In addition, it is also preferable to provide a sub-coating layer for improving adhesivity with a photographic emulsion on the surface of a surface lamination layer or to provide a backing layer for improving printing and writing property and anti-static property on the lamination layer on the back side.

It is preferable that sharpness is improved by coating a hydrophilic colloidal layer containing a white pigment on the support. As a white pigment, the same white pigment as the foregoing can be used. Titanium oxide is preferable. In a hydrophilic colloidal layer containing a white pigment, it is preferable to add a hollow fine particle polymer and a high boiling organic solvent since sharpness and/or curling resistance can be improved.

In a preferable embodiment of the present invention, it is preferable to form a protective layer on the outermost surface of the light-sensitive material and to add fine particle powder in the protective layer. As the fine particle powder (matting agent) and using method thereof, it is preferable to use a technology described in Japanese Patent O.P.I. Publication No. 95283/1994, page 4 left column, line 42th through page 4, right column, line 33.

In addition, as a reflective support used in the present invention, synthetic resin film supports such as polypropylene laminated with polyolefine on the surface can also be used.

There is no limit to the thickness of the reflective support used in the present invention. Those having thickness of 80 through 160 μm are preferably used, and those having thickness of 90 through 130 μm are more preferable.

The form of the surface of the reflective support used in the present invention may be flat or may have an appropriate surface coarseness. However, it is preferable to select a reflective support having glossiness close to a printed material. For example, it is preferable to use a white support whose average surface roughness stipulated in JIS B 0601-1976 is 0.30 through 3.0 μm.

In the present invention, surface roughness on an image forming surface is preferably 0.30 through 3.0 μm. For this purpose, a matting agent may be added in a structural layer on the image forming surface side. The matting agent may be added in the silver halide emulsion layer, the protective layer, the intermediate layer and the subbing layer. It may be added to plural layers, and preferably, to the outermost light-sensitive layer.

It is preferable that the surface on the image forming layer side of the light-sensitive material of the present invention has glossiness close to a printed material. For example, the degree of glossiness GS (60°) measured by a method stipulated in JIS-Z8741 is preferably 5 through 15, and more preferably 5 through 20.

As the silver halide emulsion used in the present invention there maybe used a surface latent image-type silver halide emulsion that is imagewise exposed to form a latent image on a surface, and further processed to thereby form a negative image. There may also be suitably used an internal latent image-type silver halide emulsion having its grain

surface previously unfogged which, after being imagewise exposed, is subjected to fogging treatment (nucleus-formation treatment) followed by surface development or which, after being imagewise exposed, is subjected to surface development while being subjected to fogging treatment to thereby obtain a direct positive image.

The above fogging treatment may be achieved by overall exposure of the emulsion to light, chemically fogged with a fogging agent, processed in a strong developing solution or subjected to heat treatment. The aforementioned internal latent image-type silver halide grain-containing emulsion is an emulsion containing silver halide crystal grains each having a light-sensitivite speck mainly there inside to form an internal latent image when exposed to light.

The previously unfogged internal latent image-type silver halide emulsion usable in the present invention is an emulsion containing silver halide grains each forming a latent image mainly within the grain and having most of sensitivity specks within the grain, and they comprise silver bromide, silver chloride, silver chlorobromide, silver chloroiodide, silver iodobromide, and silver chloroiodobromide.

The above emulsion is most preferably one which when coated on a support so that its silver coating weight is in the range of about 1 to 3.5 g/m$^2$ to prepare a sample, and when a portion of the prepared sample is subjected to light intensity scale exposure for specified periods of time ranging from 0.1 to 1.0 second and developed at 20°C for 4 minutes in the following surface developing solution A substantially not containing any silver halide solvent for developing the surface image alone of the grain, the maximum density of the thus processed piece is not more than 1/5 of the maximum density of the other part of the same sample that was obtained by being similarly exposed and developed at 20°C for 4 minutes in the following internal developing solution B capable of developing the latent image inside the grain.

| (Surface developing solution A) | |
|---|---|
| Metol | 2.5 g |
| L-ascorbic acid | 10.0 g |
| Sodium metaborate, tetrahydrate | 35.0 g |
| Potassium bromide | 1.0 g |
| Water to make | 1000 cc |

| (Internal developing solution B) | |
|---|---|
| Metol | 2.0 g |
| Anhydrous sodium sulfite | 90.0 g |
| Hydroquinone | 8.0 g |
| Sodium carbonate, monohydrate | 52.5 g |
| Potassium bromide | 5.0 g |
| Potassium iodide | 0.5 g |
| Water to make | 1000 cc |

The internal latent image-type silver halide emulsions suitably usable in the present invention include those prepared in various methods, such as the conversion-type silver halide emulsion described in U.S. Patent No. 2,592,250; the silver halide emulsion comprising internal chemically sensitized silver halide grains described in U.S. Patent Nos. 3,206,316, 3,317,322 and 3,367,778; the emulsion containing polyvalent metallic ion-incorporated silver halide grains described in U.S. Patent Nos. 3,271,157, 3,447,927 and *(it is necessary to investigate the patent) 3,53,291; the silver halide emulsion comprising weak chemically sensitized silver halide grains containing a doping agent described in U. S. Patent No. 3,761,276; the silver halide emulsion comprising grains having a multiphase structure described in Japanese Patent O.P.I. Publication Nos. 8524/1975, 38525/1975 and 2408/1978; and the silver halide emulsion described

in Japanese Patent O.P.I. Publication Nos. 156614/1977 and 127549/1980.

The internal latent image-type silver halide grain usable in the present invention may be of any arbitrary silver halide such as silver bromide, silver chloride, silver chlorobromide, silver chloroiodide, silver iodobromide or silver chloroiodobromide. The silver chloride grain is excellent in the developability and suitable for rapid processing.

The silver halide crystal grain used in the present invention may have any form such as a cubic form, an octahedral form, a tetradecahedral form comprised of a mixture of (100) and (111) faces, a form having (110) faces, a spherical form or a tabular form. Suitably usable silver halide grains are ones having an average grain diameter of 0.05 to 3 μm. The silver halide emulsion used in the present invention may be either a monodisperse emulsion comprising grains having uniform grain diameters or uniform crystal habits or a polydisperse emulsion comprising grains whose grain diameters or crystals habits are not uniform. In the present invention, the monodisperse silver halide emulsion is one in which the weight of the silver halide grains having a grain diameter within the limit of its average diameter rm ±20% accounts for preferably not less than 60%, more preferably not less than 70%, and most preferably not less than 80% of the total weight of the whole silver halide grains thereof. The average grain diameter rm herein is defined as the grain diameter ri in the instance where the product of frequency ni of the grain having a grain diameter ri and $ri^3$, i.e., ni x $ri^3$, comes to the maximum (rounded to three decimal places), wherein the grain diameter, in the case of a spherical silver halide grain, is the diameter itself, while in the case of a non-spherical grain, is the diameter of a circular image equivalent in the area to the projection image of the grain. The grain diameter can be obtained by a method in which the grain is electron microphotographically 10,000-fold to 50,000-fold enlarged, and the diameter of the enlarged grain image on its photo print or the area of the projection grain image enlarged likewise is actually measured. (The number of grains for measurement shall be 1000 or more at random.)

The most preferred high monodisperse emulsion is of silver halide grains having a grain diameter distribution broadness of not more than 20%, the distribution broadness being defined by

grain diameter standard deviation / average diameter x 100 = distribution broadness (%)

wherein the above average grain diameter and the grain diameter standard deviation are to be found from the earlier defined ri.

The monodisperse emulsion can be obtained by adding an aqueous silver salt solution and an aqueous halide solution under controlled pAg and pH conditions according to a double-jet precipitation method. For determination of the addition rate, reference can be made to Japanese Patent O.P.I. Publication Nos. 48521/1979 and 49938/1983. To obtain a high monodisperse emulsion, there can be used the method for growing the grain in the presence of a tetrazaindene compound,which was disclosed in Japanese Patent O.P.I. Publication No. 122935/1985.

In addition, it is also preferable to add two or more kinds of mono-dispersed emulsions in one sensitive layer.

The grain size in each emulsion layer of the light-sensitive material of the present invention can be determined from wide range, considering various properties including performance thereof, specifically, its sensitivity, sensitivity balance, color separation sharpness and graininess.

In the light-sensitive material of the present invention, it is preferable to contain a nitrogen-containing heterocyclic compound having a mercapto group. The preferable compounds are those represented by Formula [XI] described in Japanese Patent O.P.I. Publication No.95283/1994, page 19, right column, line 20th through 49th. The more preferable compounds are those represented by Formula [XII], Formula [XIII] and [XIV] described in the above-mentioned specification, page 20, left column, line 5th through page 20, right column, line 2nd. As practical examples of the compounds, compounds (1) through (39) described in Japanese Patent O.P.I. Publication No. 73338/1989, page 11 through page 15 are cited.

The added amount of the above-mentioned mercapto compound may be changed depending upon the kind of compounds used and the added layer. Ordinarily, when it is added to the silver halide emulsion layer, it is preferable to be $10^{-8}$ through $10^{-2}$ mol and more preferable to be $10^{-6}$ through $10^{-3}$ mol.

In one preferable embodiment of the present invention, the grain size of silver halide is preferably 0.1 through 0.6 μm for the red-sensitive layer emulsion, 0.15 μm through 0.8 μm for the green-sensitive layer emulsion and 0.3 through 1.2 μm for the blue-sensitive layer emulsion.

As a magenta coupler used in the present invention, compounds represented by [M-1] described in Japanese Patent O.P.I. Publication No. 95283/1994, page 7, right column is preferable since its spectral absorption properties of coloring dyes is superior. Practical example of preferable compounds are compound M-1 through M-19 described in the above-mentioned specification, page 8 through page 11. In addition, as other examples, compounds M-1 through M-61 described in European Patent No. 0,273,712, pp. 6 through 21 and compounds 1 through 223 described in European Patent No. 0,235,913, pp. 36 through 92 except those described above.

The magenta image forming layer of the inventive photographic light sensitive material contains preferably a magenta coupler represented by the following formula (M-I) or (M-II).

Formula (M-I)

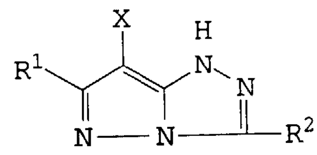

Formula (M-II)

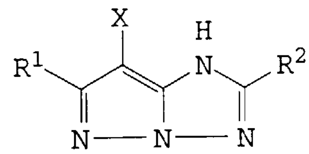

In the formulas, $R^1$ and $R^2$ each represent a hydrogen atom or a substituent, which may be the same with or different from each other or maybe combined with each other to form a ring; X represents a hydrogen atom or a group capable of being released upon coupling with an oxidation product of a color developing agent. As the substituent represented by $R^1$ and $R^2$ is preferable one represented by the following formula (S).

Formula (S)

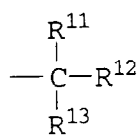

In the formula, $R^{11}$, $R^{12}$ and $R^{13}$ each represent a hydrogen atom or a substituent, which may be combined with each other to form a ring, provided that only one of $R^{11}$, $R^{12}$ and $R^{13}$ is not a hydrogen atom.

In formula (S), as the substituent represented by $R^{11}$, $R^{12}$ and $R^{13}$ is citedalkyl, alkenyl, alkynyl, cycloalkyl, aryl, acyl, amino, anilino, acylamino, carbamoyl, ureido, sulfonyl, sulfinyl, sufonamido, sulfamoyl, alkylthio, arylthio, cyano, hydroxy, alkoxy, aryloxy, acyloxy, carbamoyloxy, sulfamoyloxy, sulfonyloxy, a halogen atom or heterocyclic group. These groups may be substituted.

$R^{11}$, $R^{12}$ and $R^{13}$ each are preferably a hydrogen atom, alkyl, cycloalkyl, aryl, acyl acyloxy or sulfonyl.

In the above-described (M-I) and (M-II), as examples of a group represented by X releasable upon coupling with an oxidation product of a developing agent are cited a halogen atom, alkoxy, aryloxy, heterocyclic-oxy, acyloxy, sulfonyloxy, alkoxycarbonyl, aryloxycarbonyl, alkyloxalyloxy, alkylthio, arylthio, heterocyclic-thio, acylamino, sulfonamido and nitrogen-containing heterocyclic ring which has a bond at the nitrogen atom. Among these groups are preferable a hydrogen atom, halogen atom, alkoxy group, aryloxy group and arylthio group. More preferably, are cited a hydrogen atom and halogen atom.

The magenta coupler contained in the magenta image forming layer of the inventive photographic material has a pKa value of 10.0 or less, preferably 9.5 or less in an aqueous 80% ethanol solution. Examples of the magenta coupler are shown as below, but a magenta coupler usable in the present invention is not limited thereto.

In the present invention, "pKa value in an aqueous 80% ethanol solution" refers to a pH value of an aqueous 80% ethanol solution when a coupler is dissolved in the aqueous 80% ethanol solution and its degree of dissociation is 50%.

MCP—1

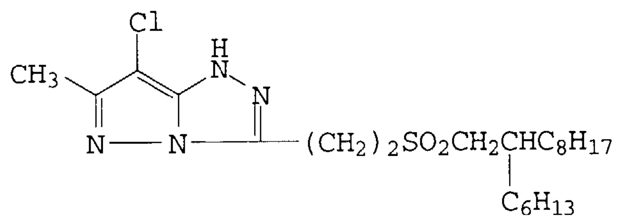

MCP—2

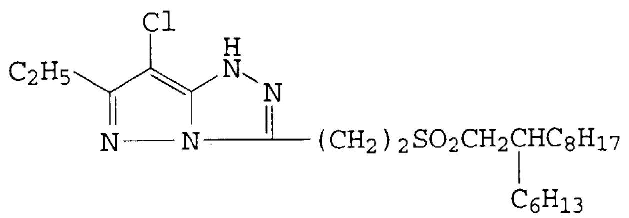

MCP—3

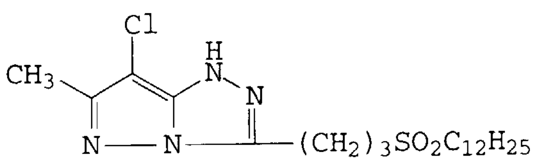

MCP—4

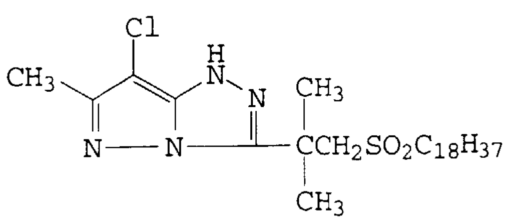

MCP—5

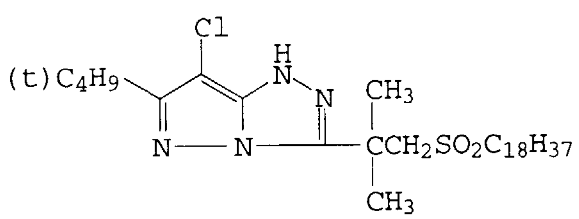

MCP-6

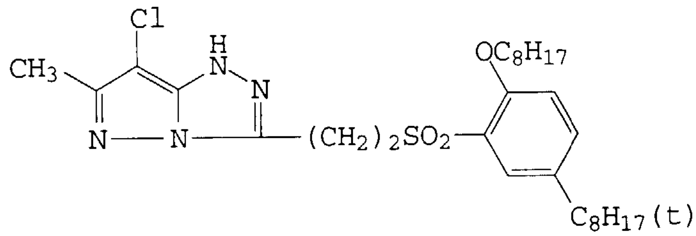

MCP-7

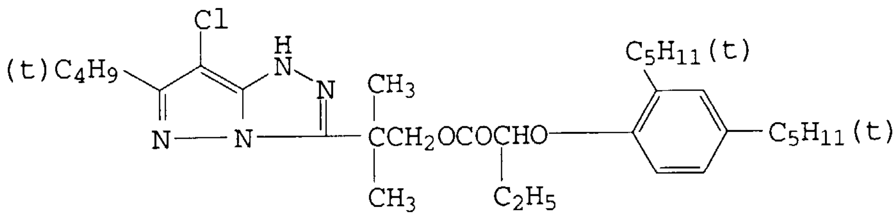

MCP-8

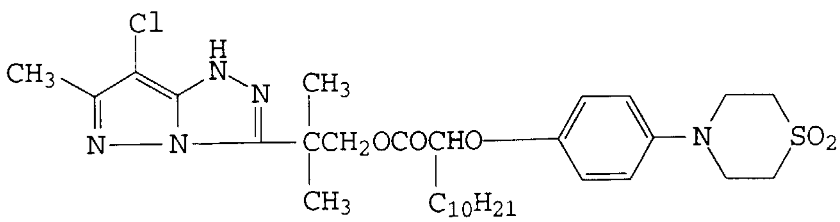

MCP-9

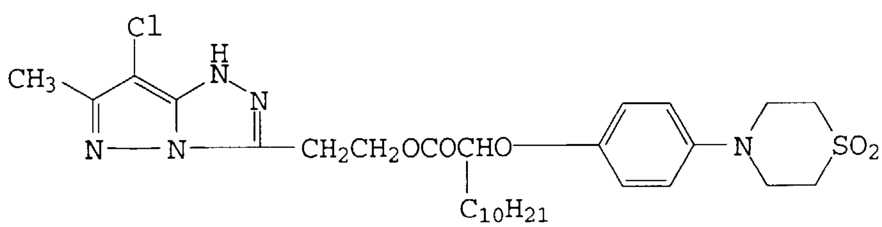

MCP-10

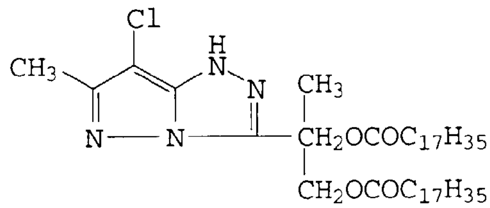

MCP-11

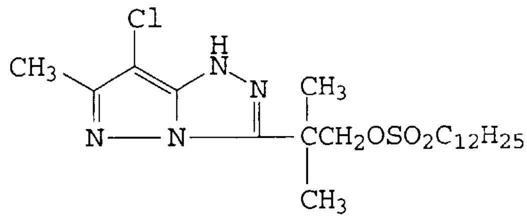

MCP-12

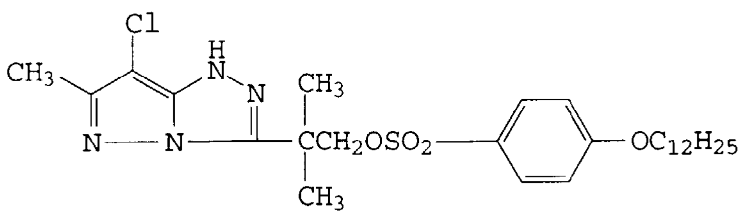

MCP-13

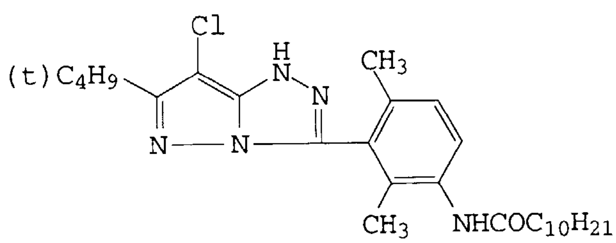

MCP-14

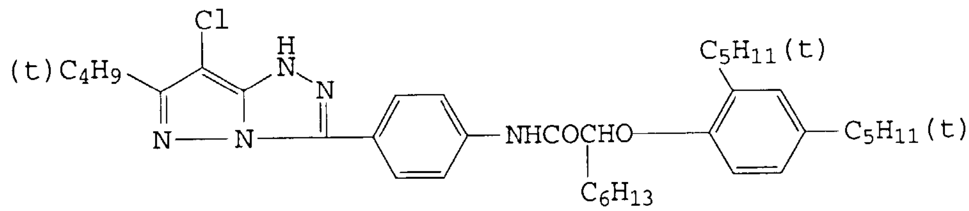

MCP-15

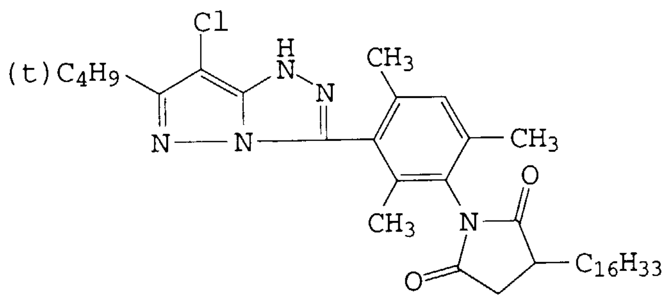

MCP-16

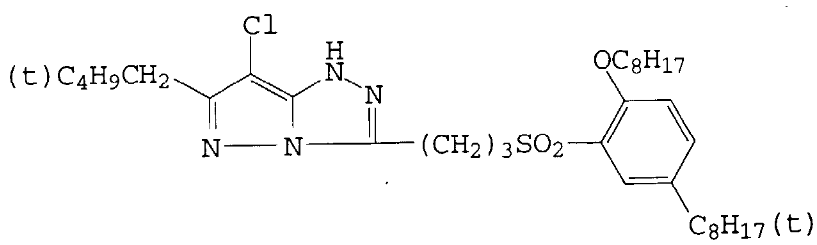

MCP-17

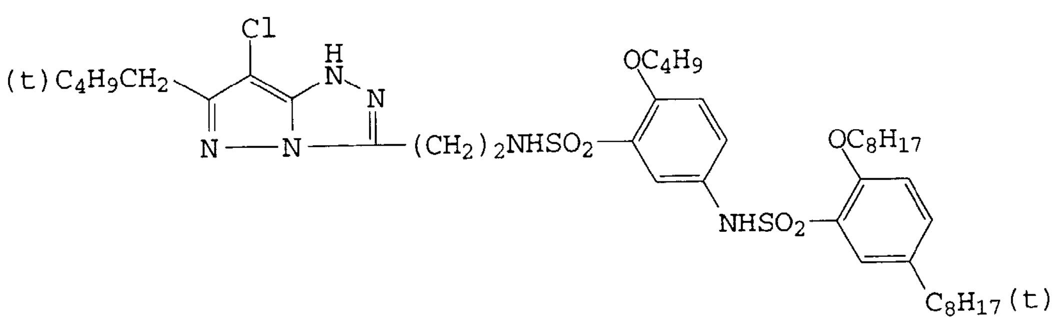

MCP-18

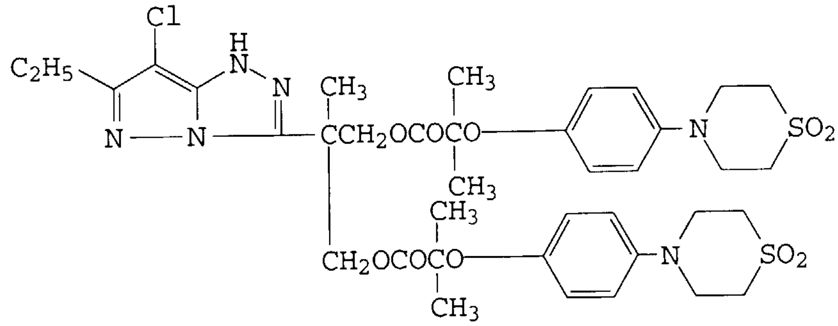

MCP-19

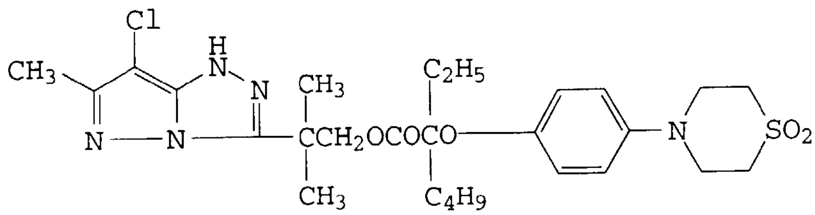

MCP-20

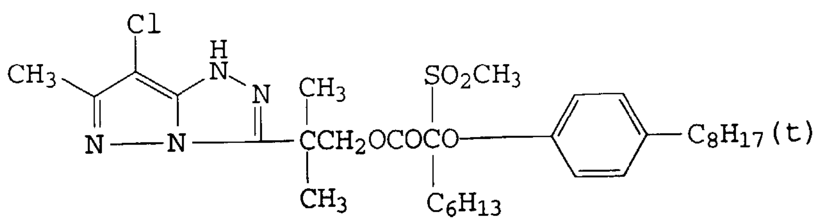

MCP-21

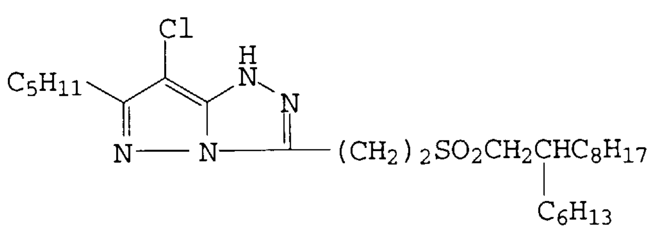

MCP-22

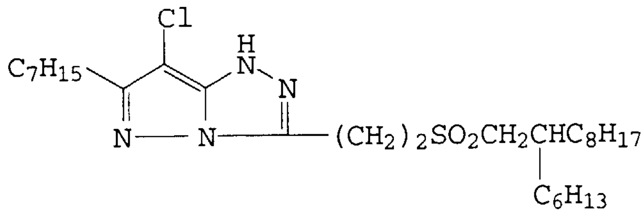

MCP-23

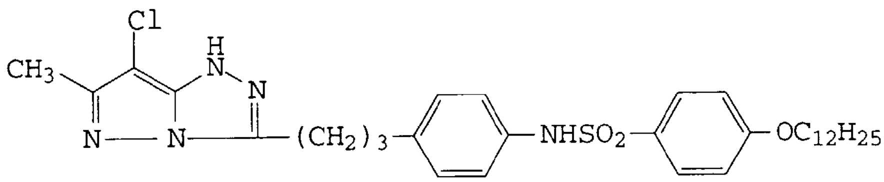

MCP-24

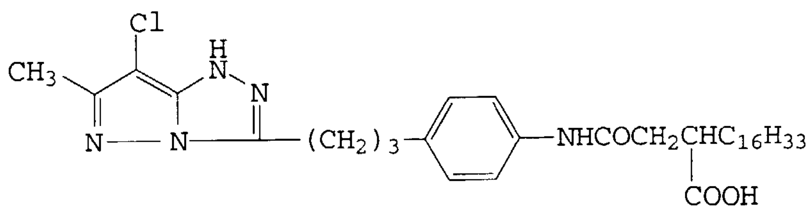

MCP-25

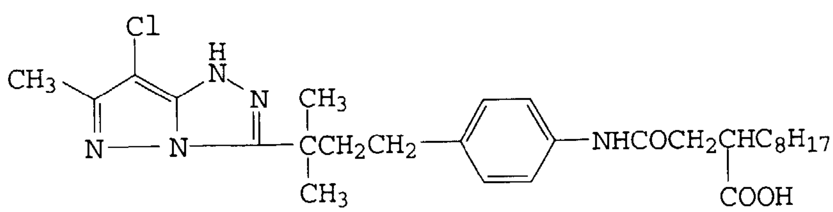

MCP-26

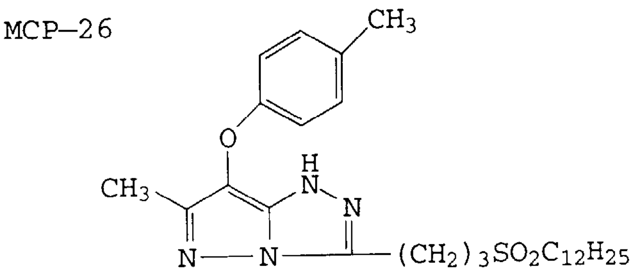

MCP-27

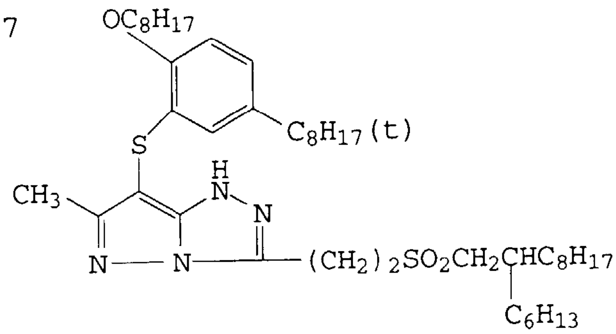

MCP-28

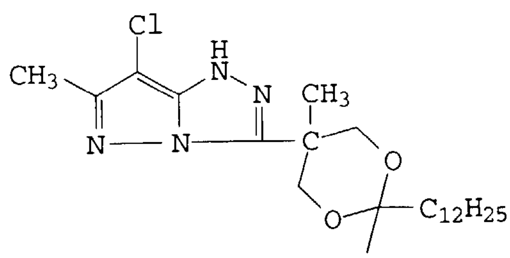

MCP-29

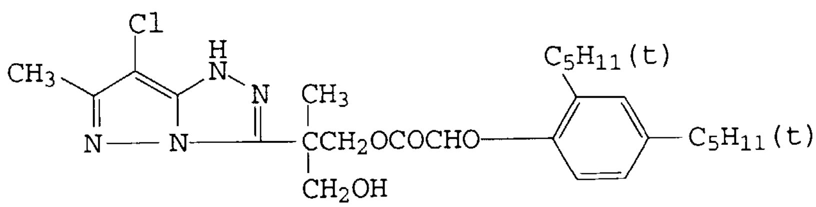

MCP-30

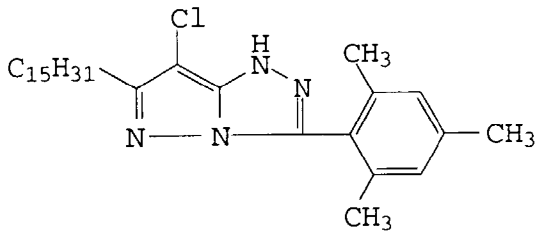

MCP-31

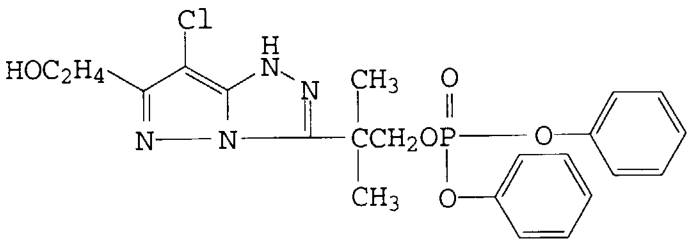

MCP-32

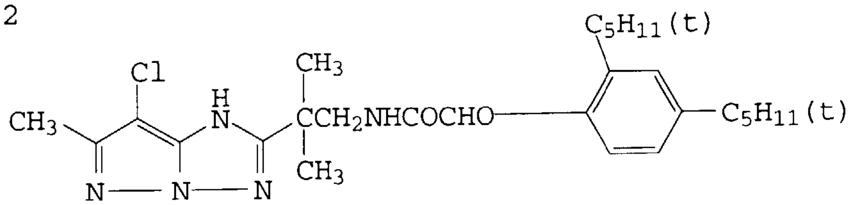

MCP-33

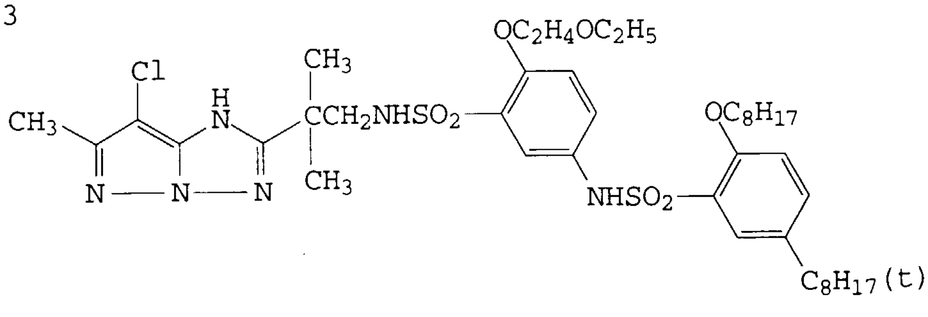

MCP-34

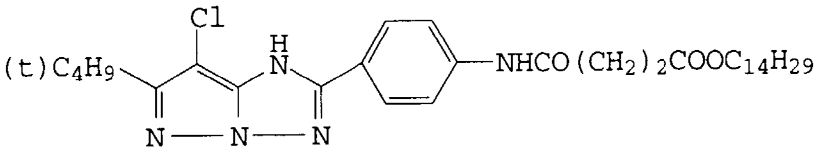

MCP-35

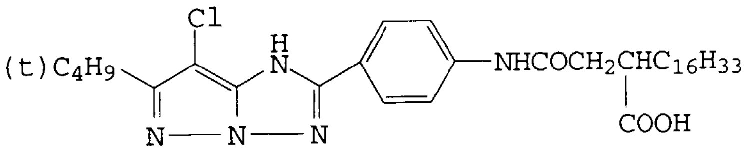

MCP-36

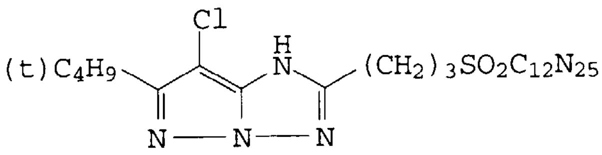

MCP-37

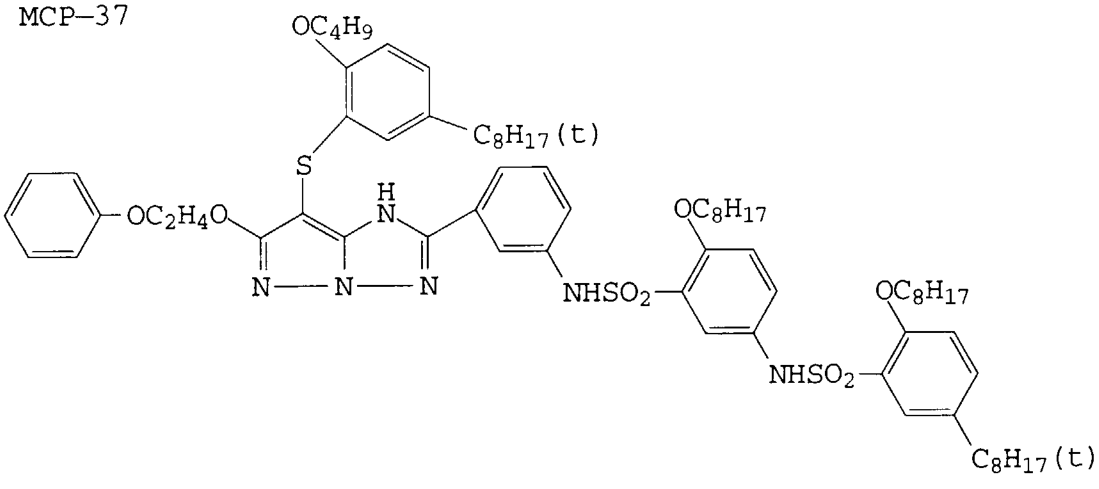

MCP−38

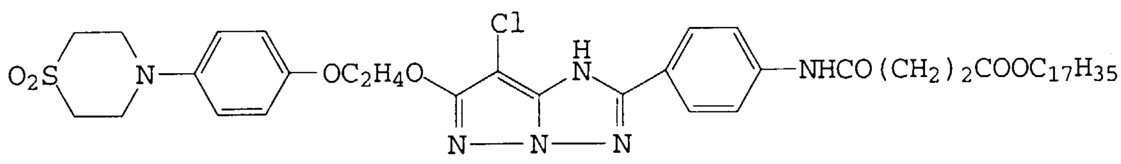

MCP−39

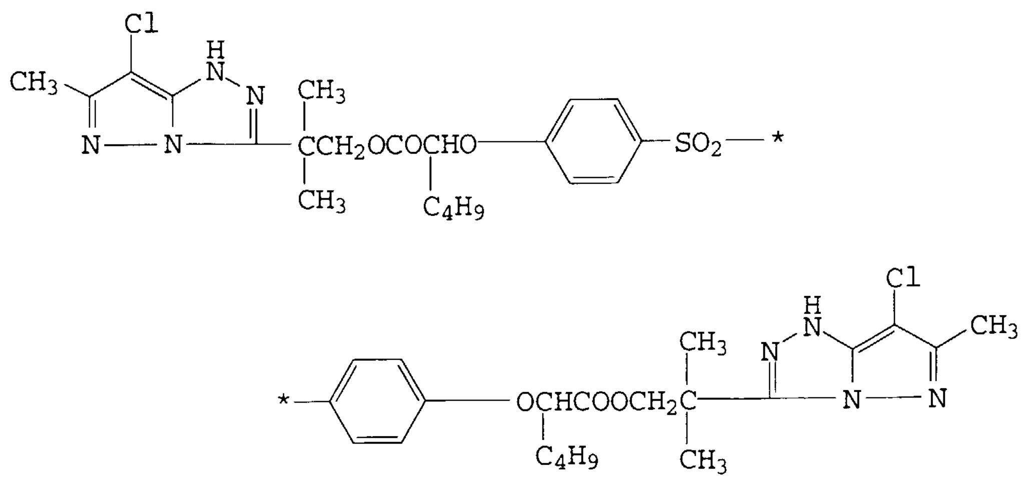

MCP−40

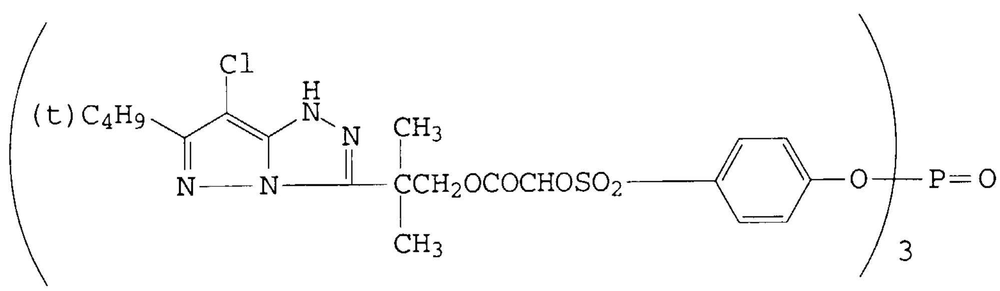

MCP-41

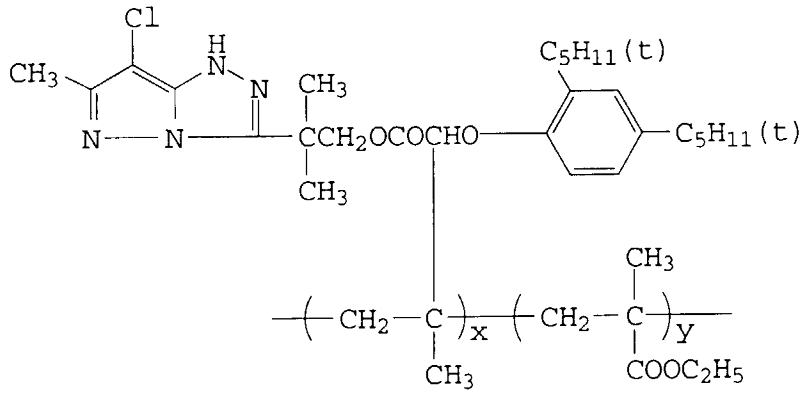

x:y = 50:50 (mole ratio)

The magenta couplers as above-described can be synthesized in accordance with the methods described in Journal of the Chemical Society, Perkin I (1977), 2047-2052, U.S. Patent No. 3,725,067, Japanese Patent OPI Publication Nos. 58-42045, 59-99437 and 59-162548.

The above-mentioned couplers may be used in combination with other kinds of magenta couplers. Ordinarily, they can be used preferably in a range of 1 x $10^{-3}$ through 1 mol and more preferably in a range of 1 x $10^{-2}$ through 8 x $10^{-1}$ mol per mol of silver halide.

In the light-sensitive material of the present invention, spectral absorption $\lambda_{L0.2}$ of the magenta image is preferably 580 through 635 nm.

In the light-sensitive materials whose $\lambda_{L0.2}$ is 580 through 635 nm, $\lambda$max of the spectral absorption of the magenta image is preferably 530 through 560 nm.

Here, $\lambda_{L0.2}$ and $\lambda$max of the spectral absorption of the magenta image of the light-sensitive material of the present invention are measured by the following methods.

(Measurement method of $\lambda_{L0.2}$ and $\lambda$max)

In the case of a positive type, the light-sensitive material of the present invention is uniformly exposed to red light having light amount capable of obtaining the minimum density of the cyan image and is also uniformly exposed to blue light having light amount capable of obtaining the minimum density of the yellow image. Following this, a white light is irradiated through an ND filter, and then, when the light-sensitive material is subjected to photographic processing, an integrating sphere is mounted to a spectrophotometer and the value to corrected to zero by means of a standard white plate made of magnesium oxide. A magenta image is prepared by adjusting the density of the ND filter in a manner that the maximum value of absorbance when spectral absorption of 500 through 700 nm is measured.

In the case of the negative type, to a light-sensitive material, a green light is irradiated through the ND filter. When the light-sensitive material is subjected to photographic processing and a magenta image is formed, the density of the ND filter is adjusted so that the same maximum absorbance as the above-mentioned positive type. $\lambda_{L0.2}$ is defined to be a wave longer than a wavelength wherein the maximum absorbance shows 1.0 in the spectral absorbance curve and its absorbance shows 0.2.

In order to adjust spectral absorption property of the magenta dye image (or a cyan and a yellow image) as described above, it is preferable to add a compound having a color tone adjusting effect. As such compounds, compounds represented by [HBS-I] and [HBS-II] described in Japanese Patent O.P.I. Publication No. 95283/1994, page 22 are preferable, and compounds represented by Formula [HBS-II] described in the above-mentioned specification, page 22 are more preferable.

It is preferable that a yellow coupler is contained, in addition to a magenta coupler, in the magenta image forming layer in the light-sensitive material of the present invention. The difference of pKa of the above-mentioned couplers is preferably within 2 and more preferably within 1.5. The preferable yellow coupler contained in the magenta image forming layer of the present invention is a coupler represented by Formula [Y-Ia] described in Japanese Patent O.P.I. Publication 95283/1994, page 12, right column. Of the couplers represented by the above-mentioned specification,

the more preferable ones are those having the pKa value which is not lower than that of a coupler represented by a combined coupler [M-1] by 3, when it is combined with a magenta coupler represented by [M-1].

Practical examples of preferable compounds are, in addition to compound Y-1 and Y-2 described in Japanese Patent O.P.I. Publication No. 95283/1994, compounds (Y-1) through (Y-58) described in Japanese Patent O.P.I. Publication No. 139542/1990, pp. 13 through 17. However, the present invention is not limited thereto.

As a cyan coupler contained in the cyan image forming layer in the present invention, conventional phenol type, naphthol type or an imidazole type couplers can be used. Typically, phenol type couplers wherein an alkyl group, an acylamino group or a ureido group is substituted, naphthol type couplers formed from a 5-aminonaphthol skeleton and a two-equivalent type couplers wherein an oxygen atom is introduced as an eliminated group. Of these, preferable compounds include those represented by Formula [C-I] and [C-II] described in Japanese Patent O.P.I. Publication No. 95283/1994, page 13.

A cyan coupler contained in the cyan image forming layer of the inventive photographic material has preferably a pKa value of 9.0 or less, more preferably 8.8 or less in an aqueous 80% ethanol solution. Examples of the cyan coupler are shown as below, but a cyan coupler usable in the present invention is not limited thereto.

CCP–1

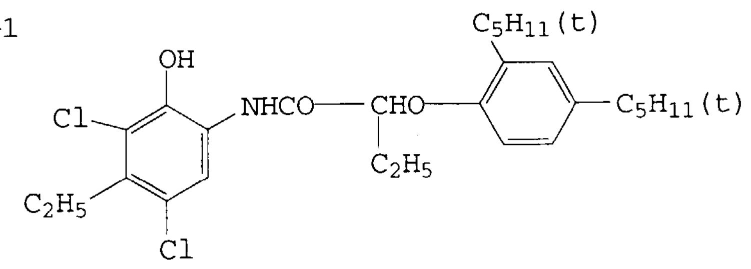

CCP–2

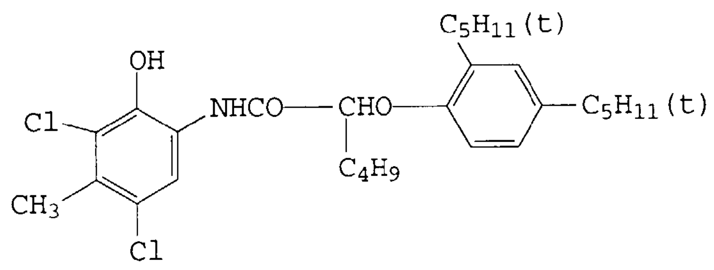

CCP–3

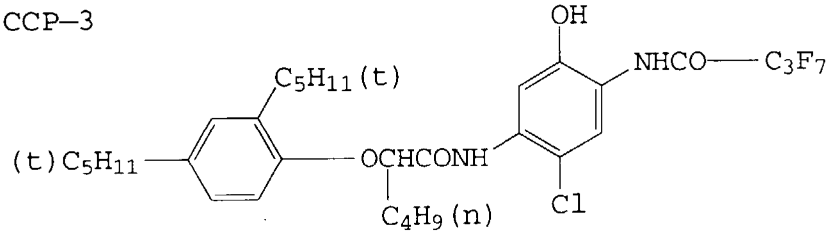

CCP-4

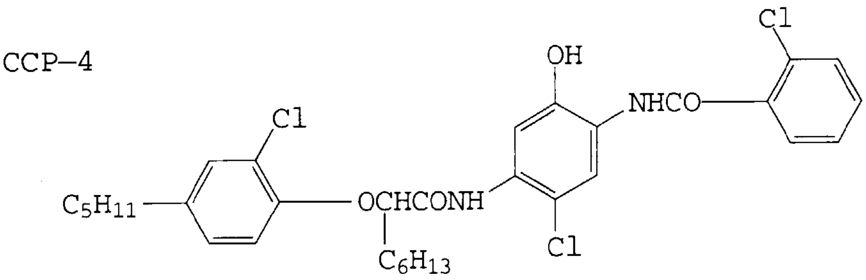

CCP-5

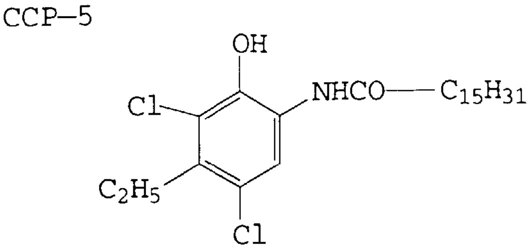

CCP-6

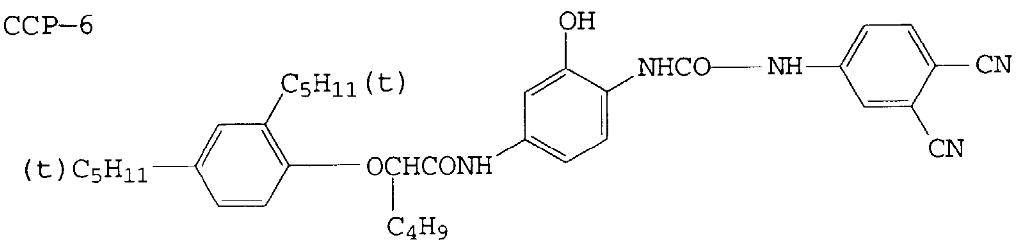

CCP-7

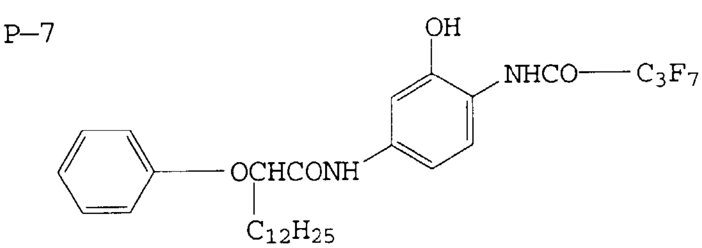

CCP-8

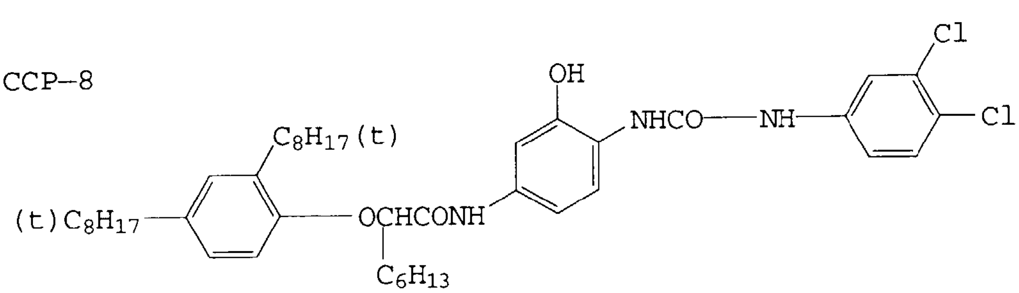

CCP-9

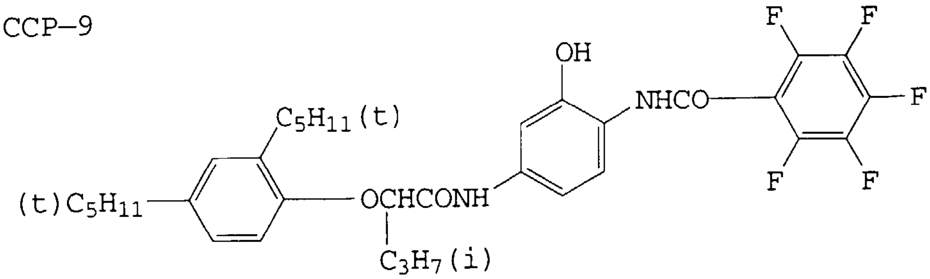

CCP-10

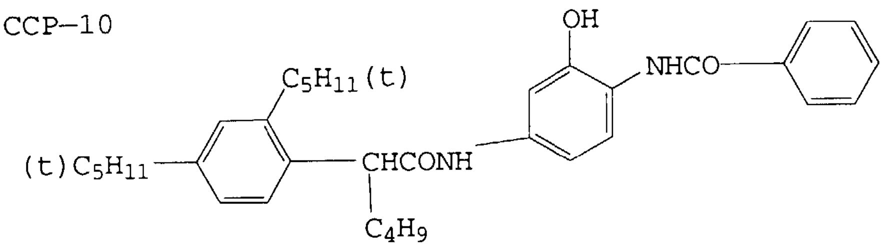

CCP-11

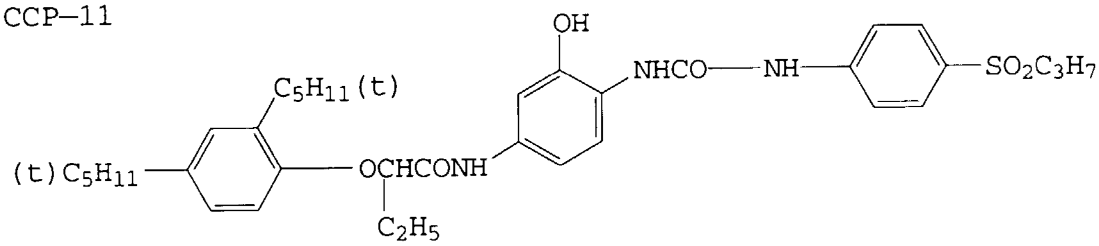

CCP-12

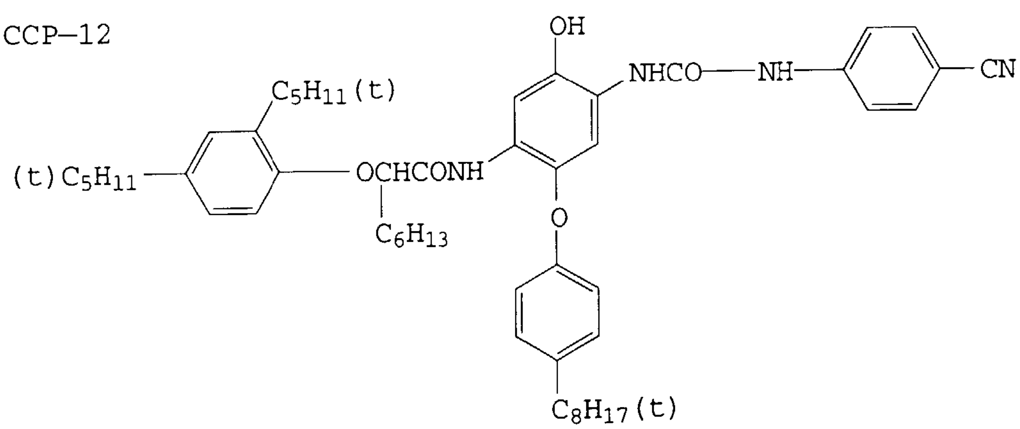

CCP-13

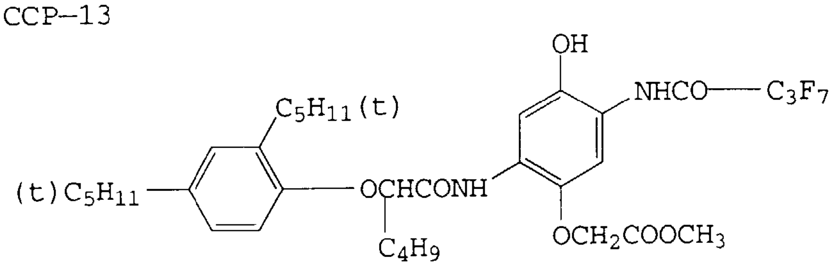

CCP-14

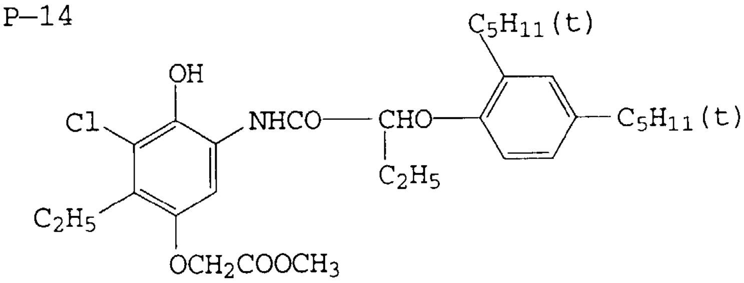

CCP-15

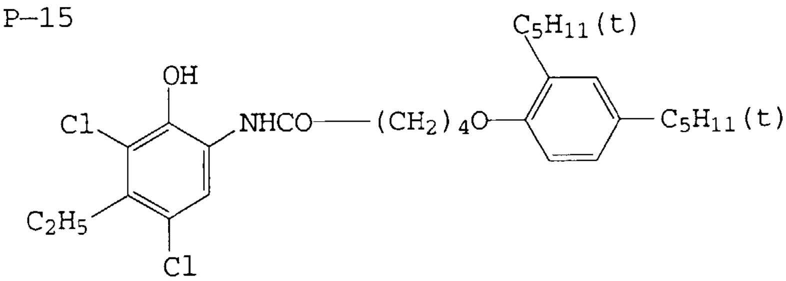

CCP-16

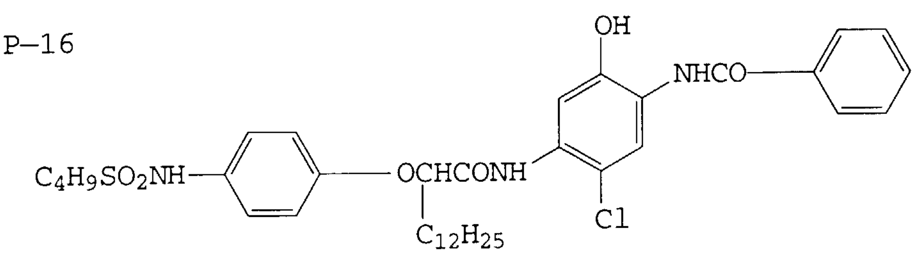

CCP-17

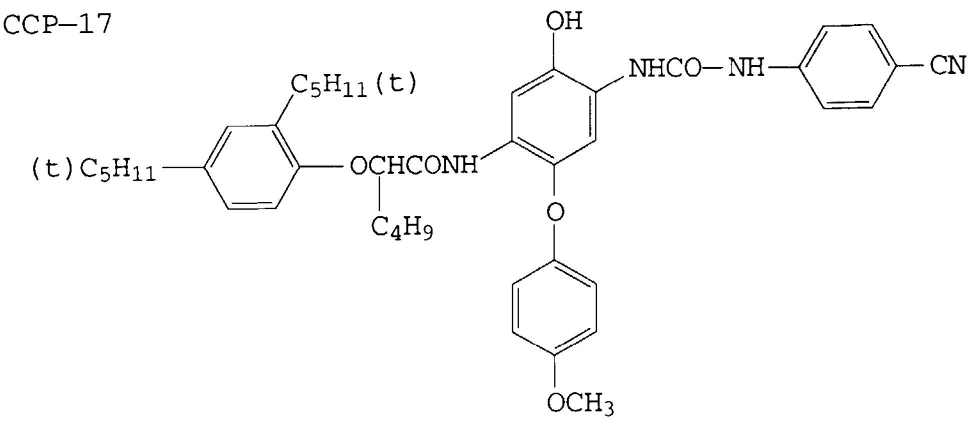

CCP-18

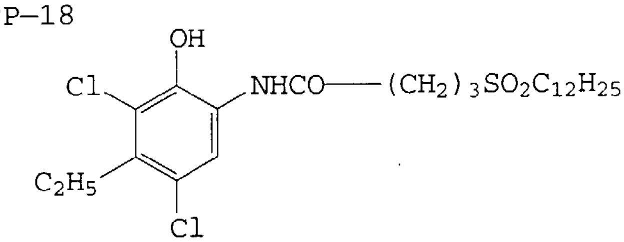

CCP-19

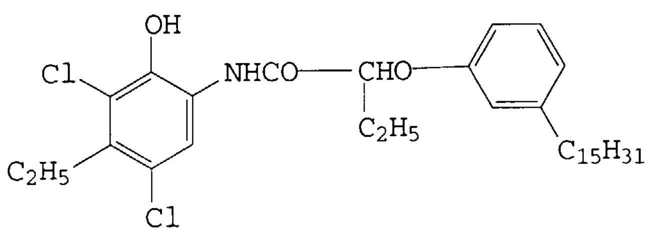

CCP-20

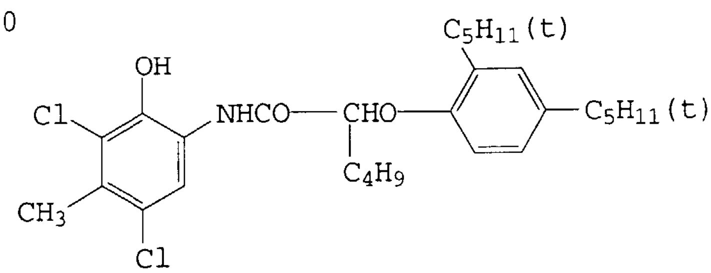

CCP-21

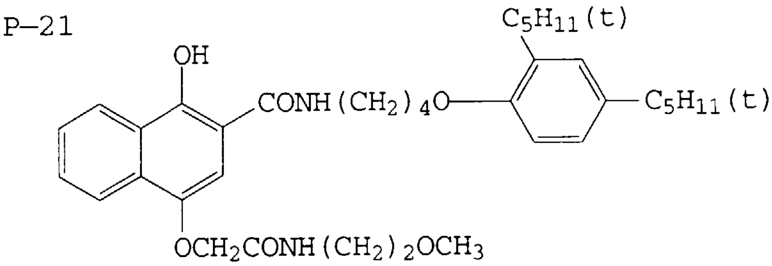

CCP-22

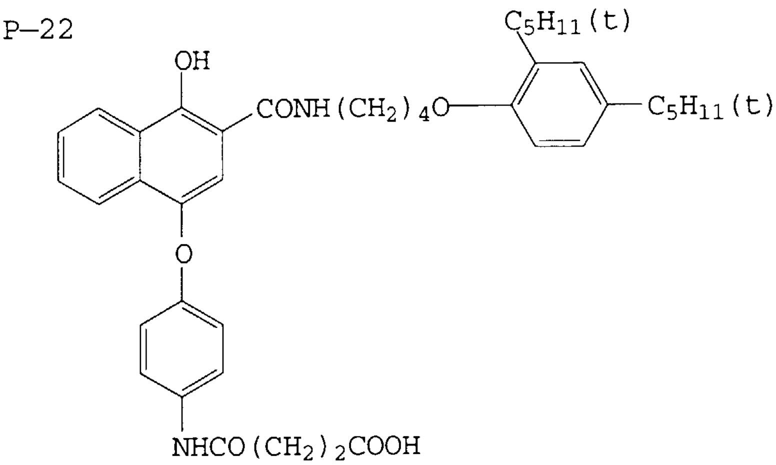

CCP-23

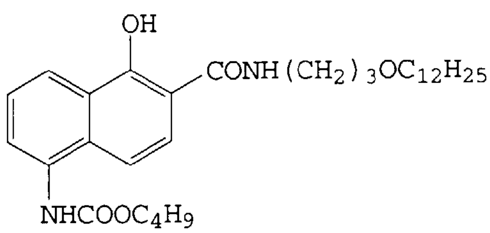

CCP-24

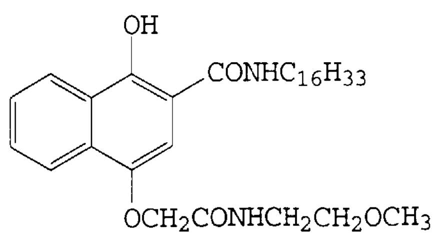

CCP-25

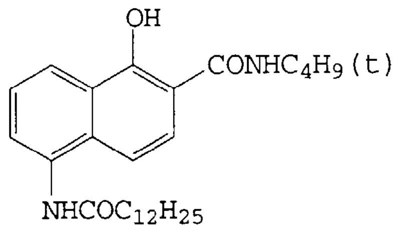

CCP-26

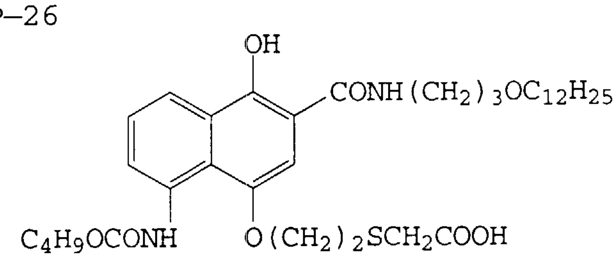

These cyan couplers can be synthesized in accordance with the method described in Japanese Patent OPI Publication Nos. 59-185335, 60-222853 and 60-225155.

As a yellow dye forming coupler, a conventional acylacetoanilide type coupler can preferably be used. Of these, a benzoylacetoanilide type and a pyvaloylacetoanilide type are profitable.

In the present invention, $\lambda_{L0.2}$ of the yellow image is preferably 515 nm or less.

$\lambda_{L0.2}$ of the present invention is defined by Japanese Patent O.P.I. Publication No. 95283/1994, page 21, right column line 1 through line 24. It refers to the size of unnecessary absorption on the long wave side in the spectral absorption property of the yellow dye image.

In the present invention, the spectral absorption of the above-mentioned yellow image is preferably $\lambda_{L0.8}$ >450 nm, and more preferably $\lambda_{L0.8}$ >455 nm. In addition, $\lambda_{L0.2}$ is preferably 510 or less. $\lambda$max is preferably 430 or more.

In the present invention, an interating sphere is mounted on a spectrophotometer HITACHI 320 for measuring spectral absorbance.

When the light-sensitive material of the present invention employs a coupler as a material which forms a yellow image, any couplers can be employed provided that they satisfy the above-mentioned conditions. The preferable couplers are those represented by Formula [Y-1] described in Japanese Patent O.P.I. Publication No. 95283/1994, page 21.

A yellow coupler contained in the yellow image forming layer of the inventive photographic material has preferably a pKa value of 9.5 or less, more preferably 9.0 or less in an aqueous 80% ethanol solution. Examples of the yellow coupler are shown as below, but a yellow coupler usable in the present invention is not limited thereto.

YCP-1

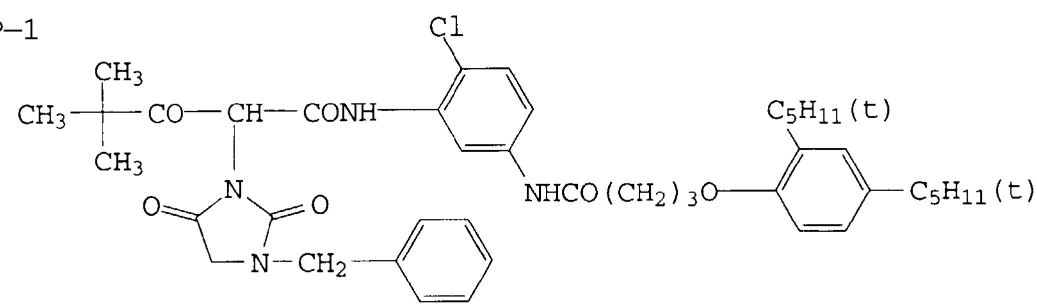

YCP-2

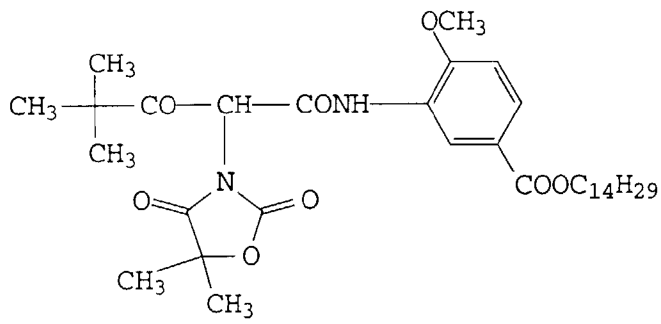

YCP-3

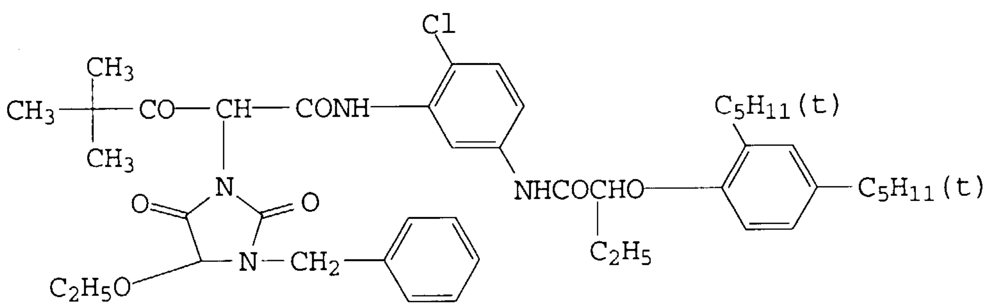

YCP-4

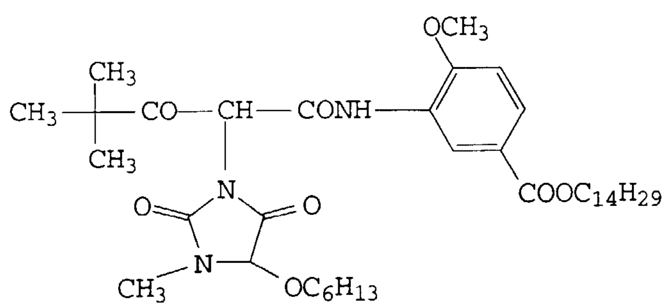

YCP-5

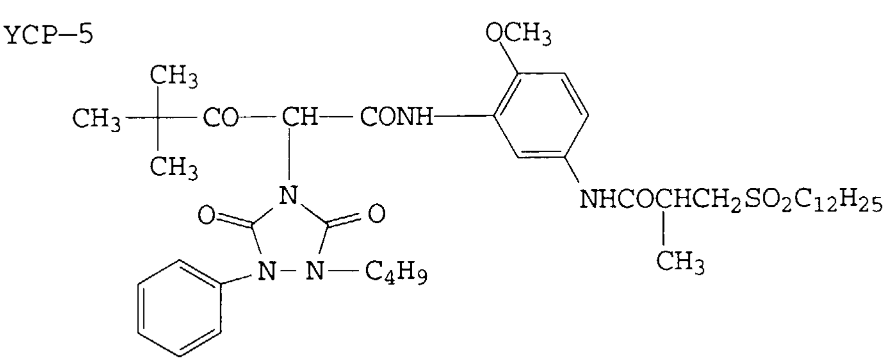

YCP–6

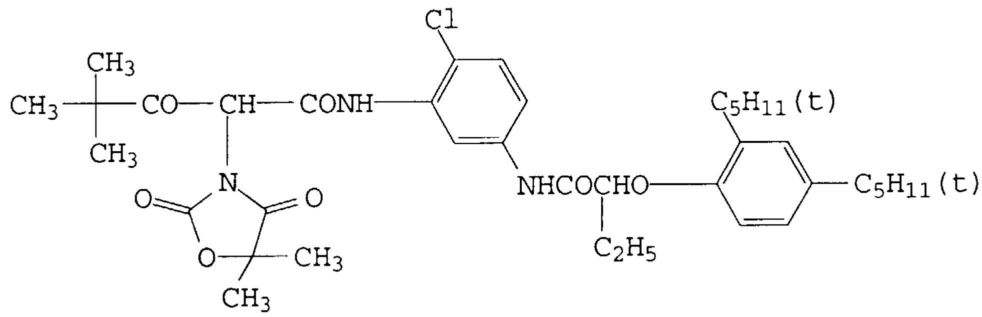

YCP–7

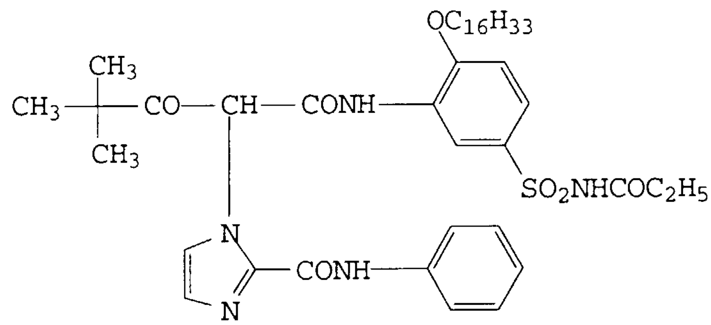

YCP–8

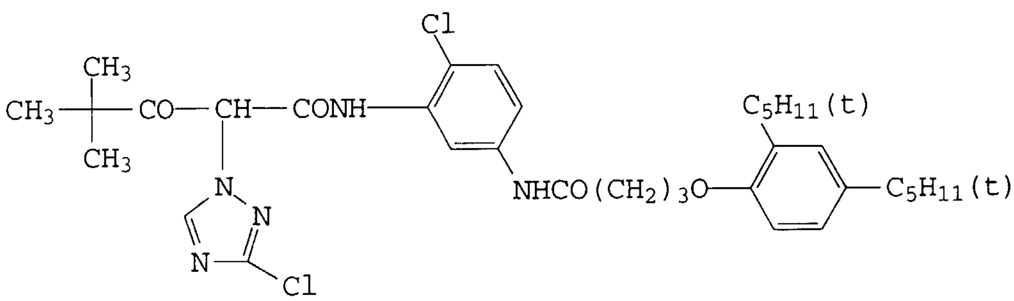

YCP–9

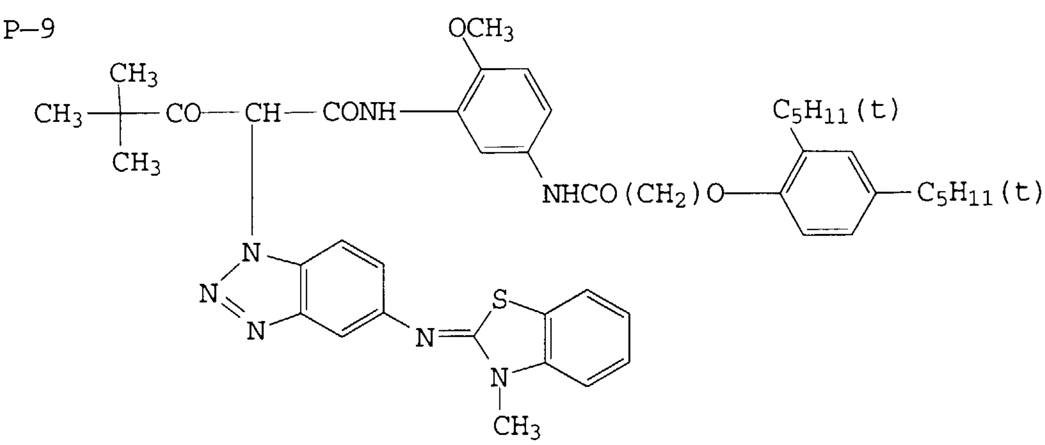

YCP—10

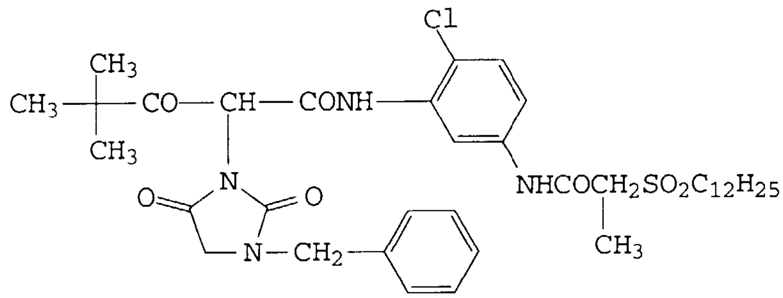

YCP—11

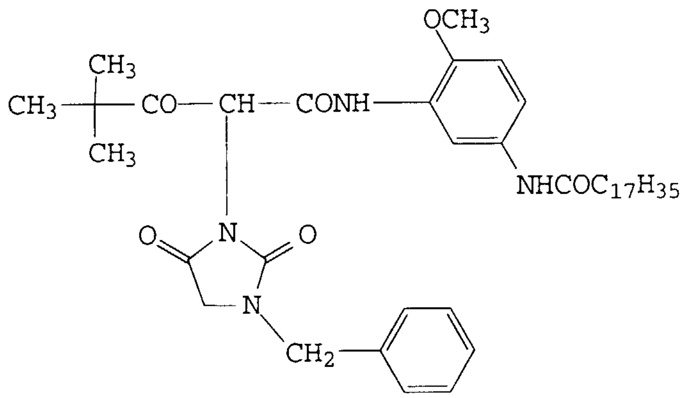

YCP—12

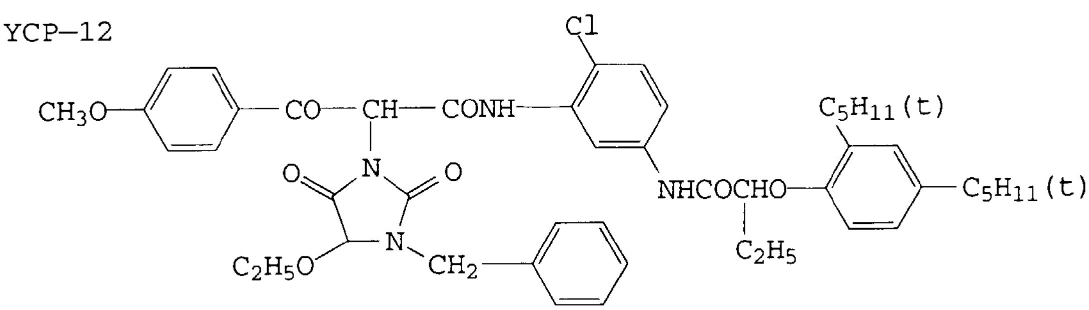

YCP—13

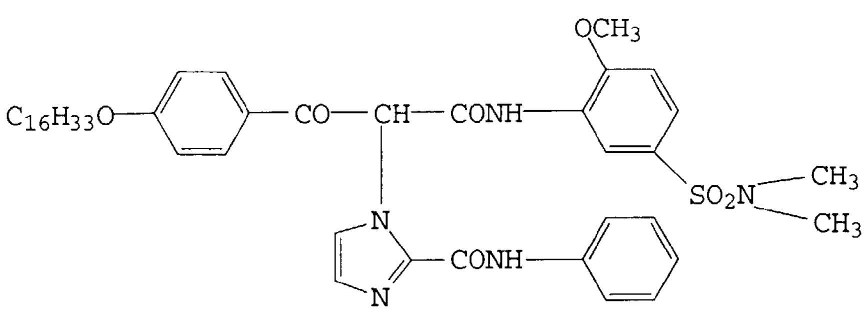

YCP-14

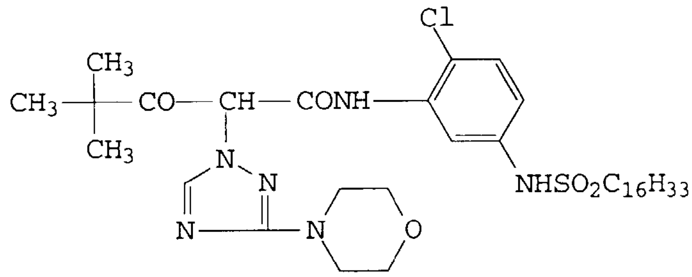

YCP-15

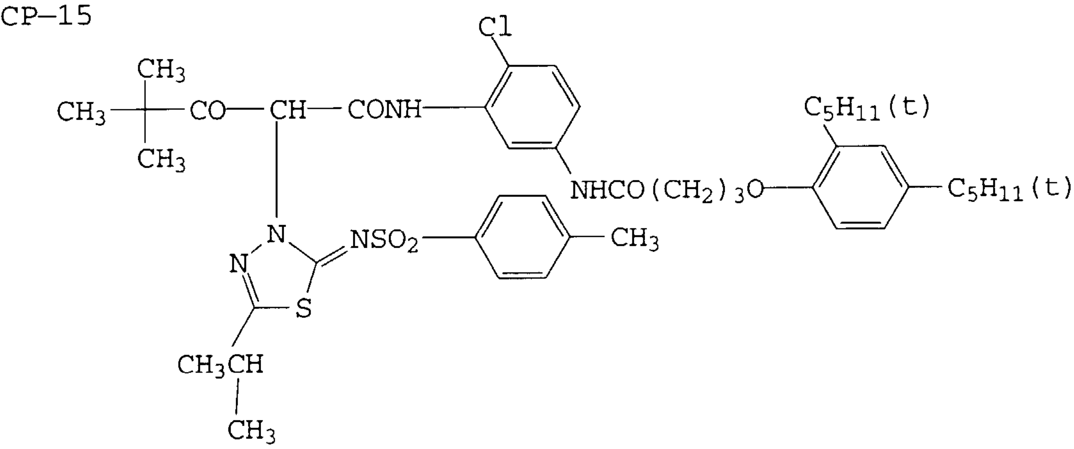

YCP-16

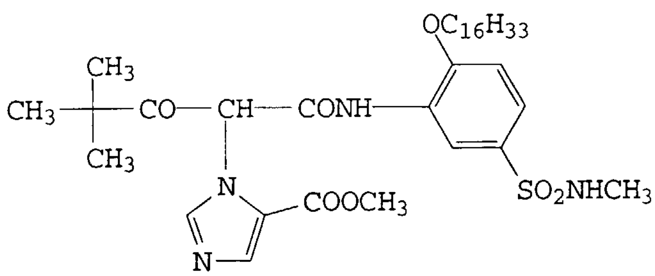

YCP-17

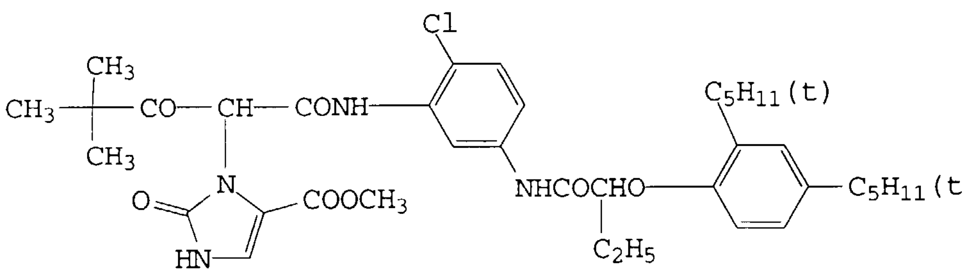

YCP−18

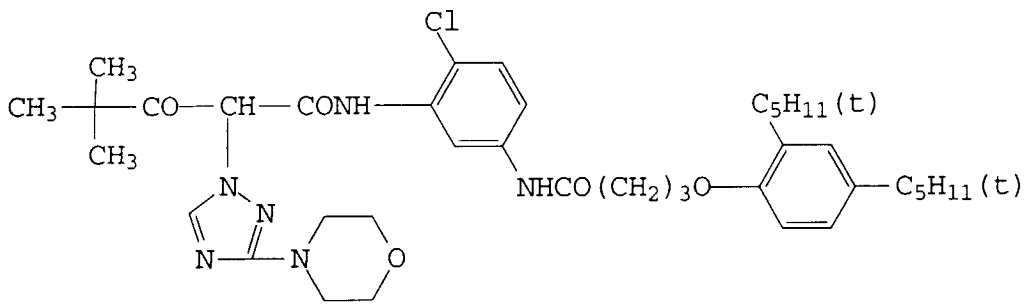

YCP−19

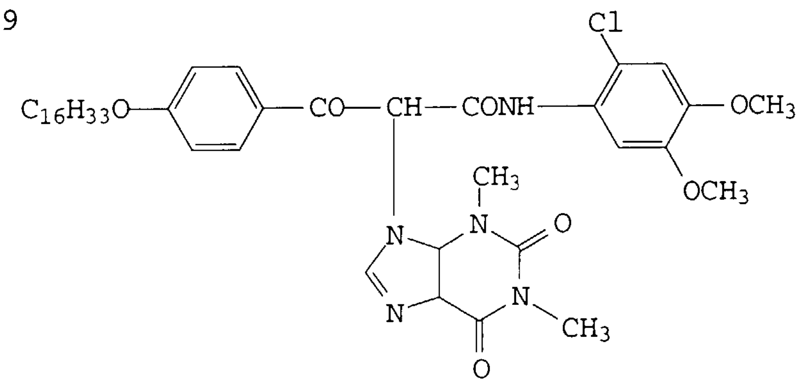

YCP−20

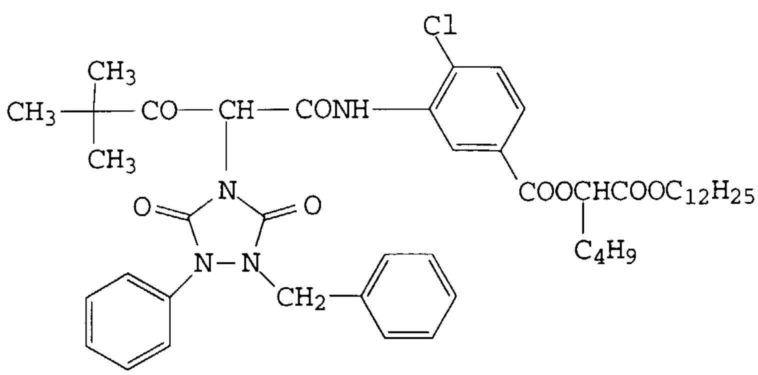

YCP−21

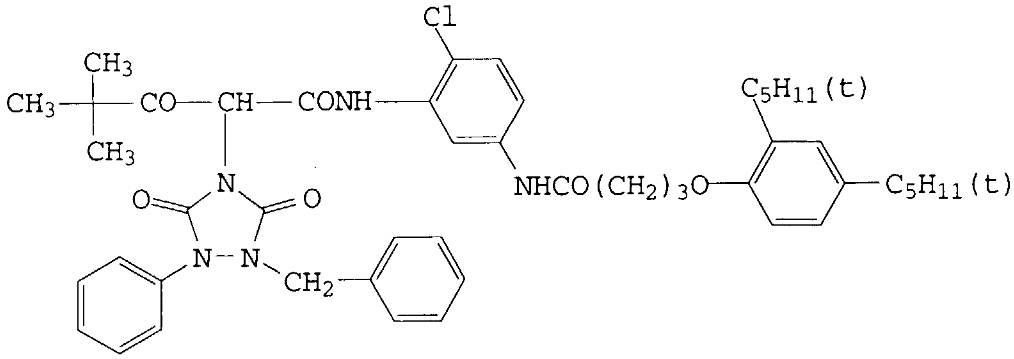

YCP–22

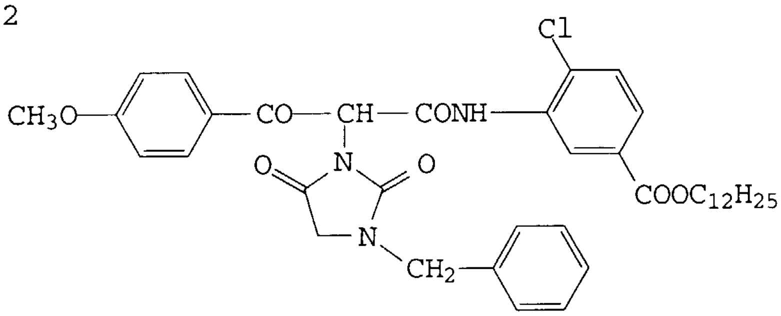

YCP–23

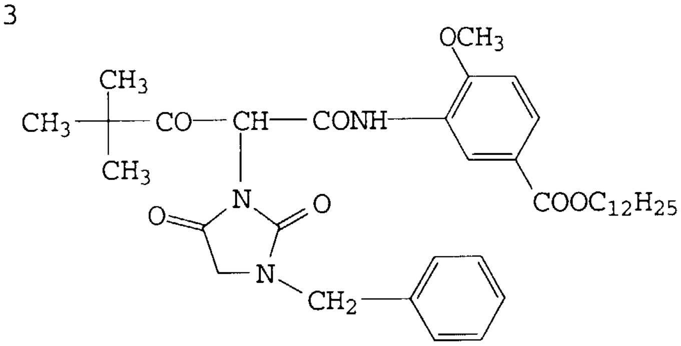

YCP–24

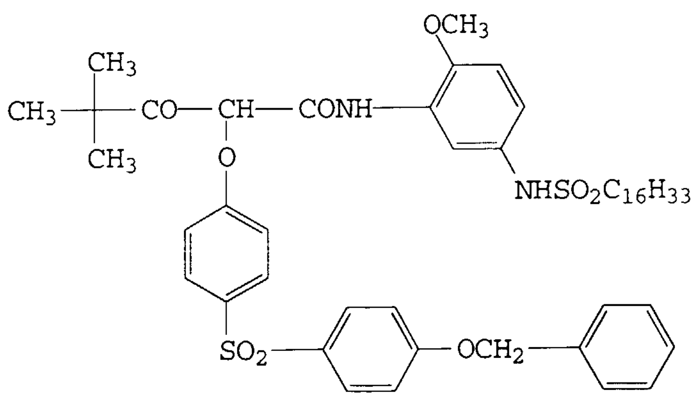

YCP–25

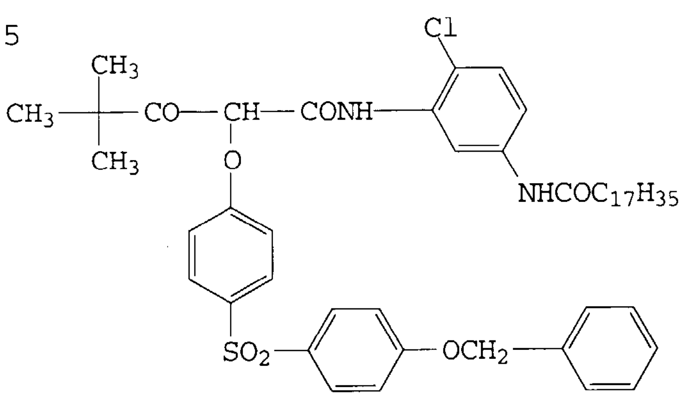

YCP–26

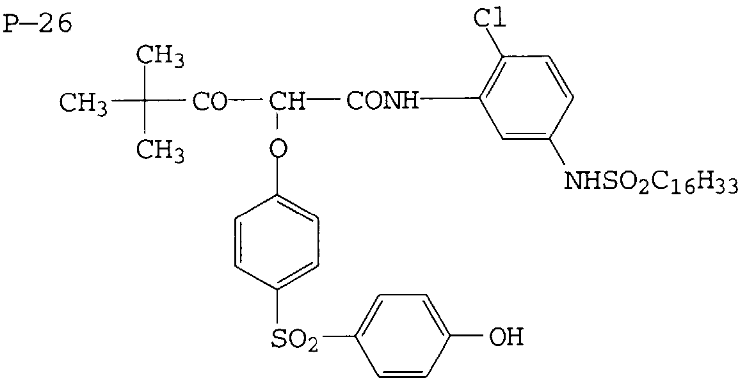

YCP–27

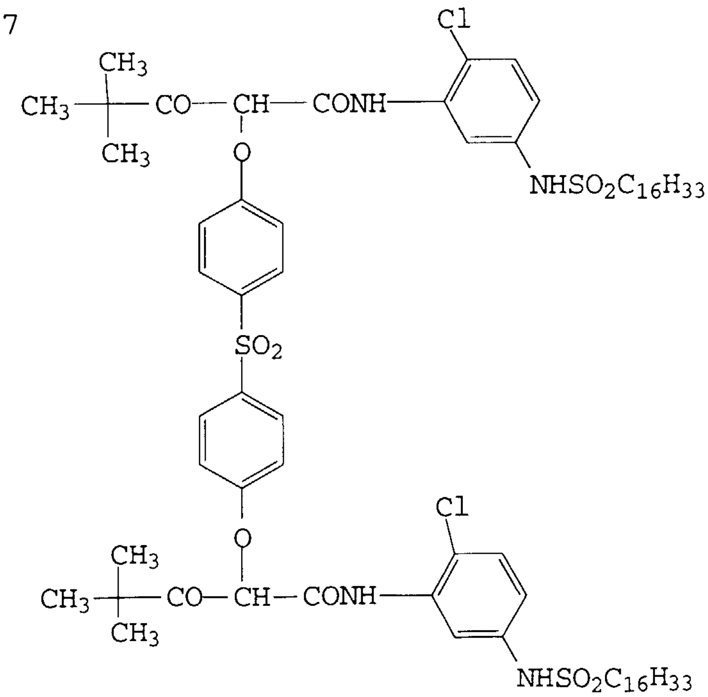

YCP–28

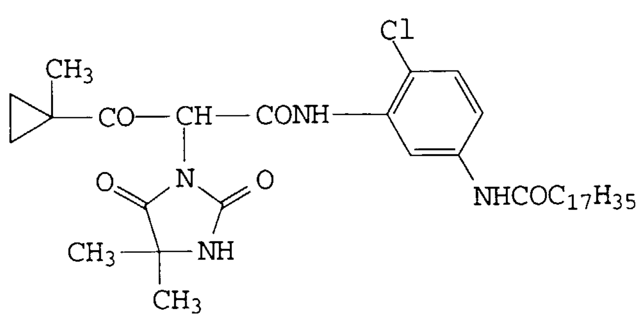

YCP-29

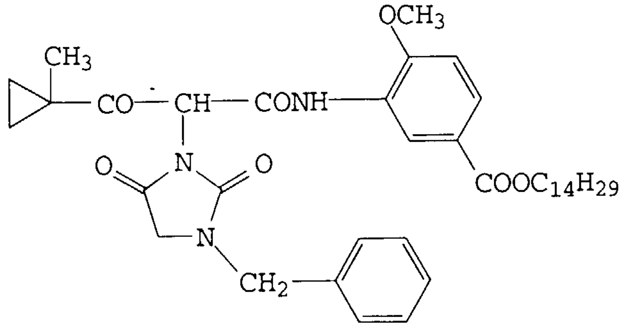

YCP-30

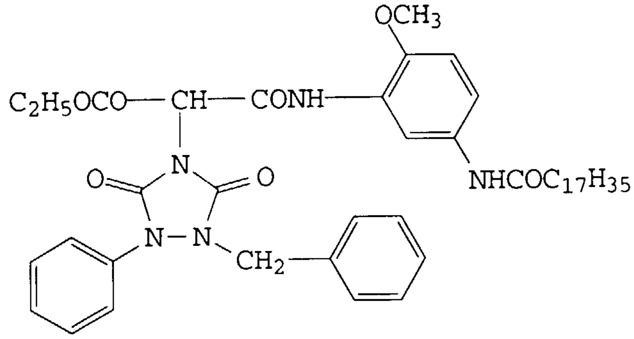

YCP-31

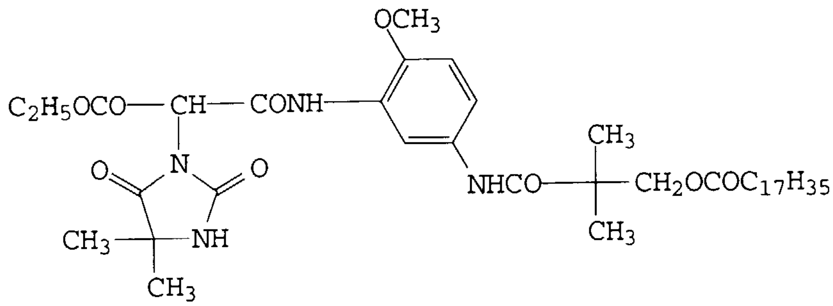

YCP-32

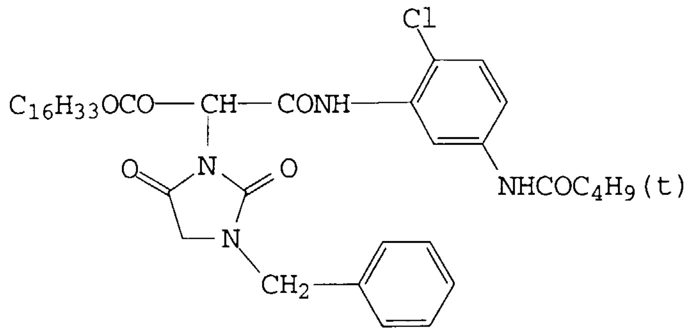

YCP-33

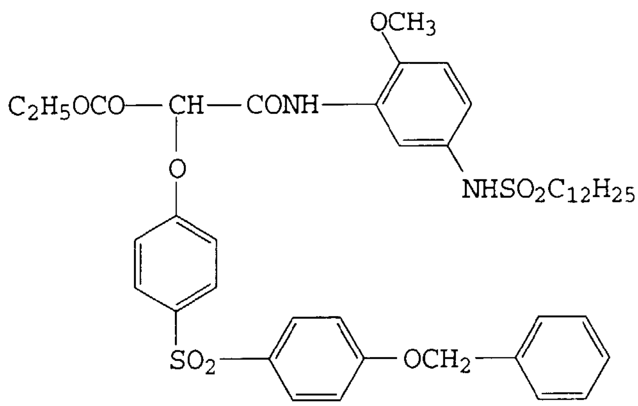

YCP-34

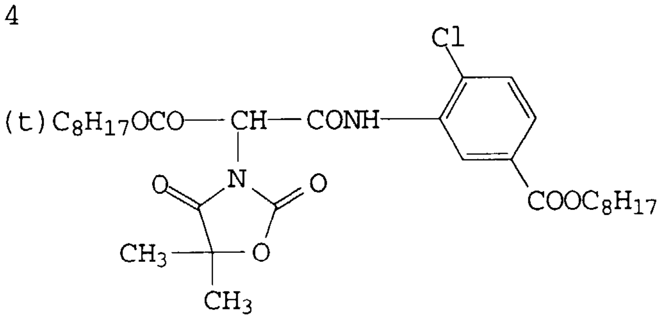

YCP-35

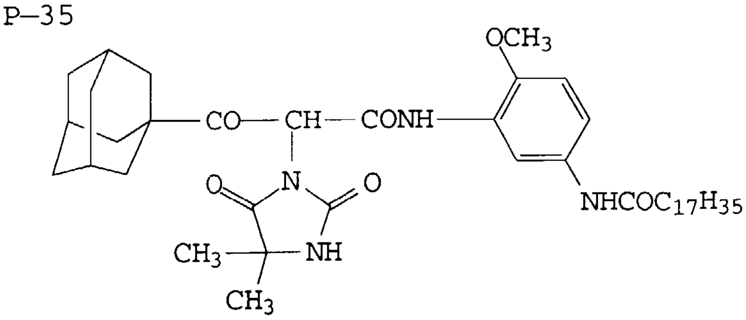

YCP-36

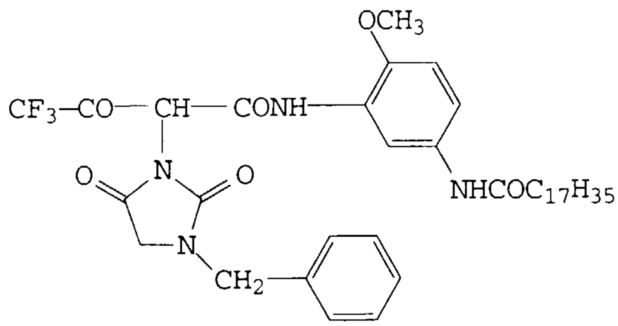

YCP-37

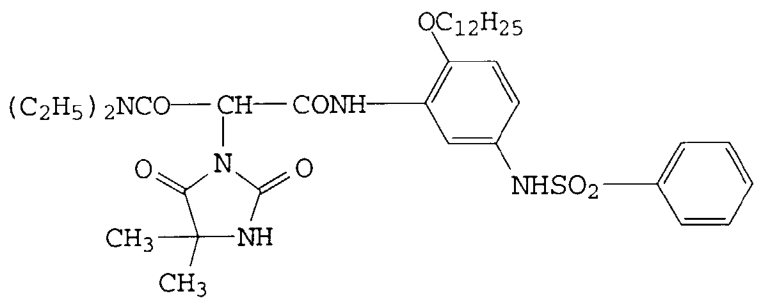

YCP-38

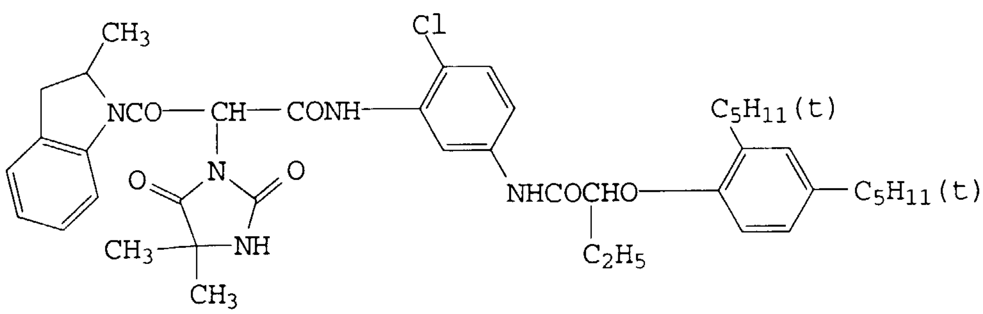

YCP–39

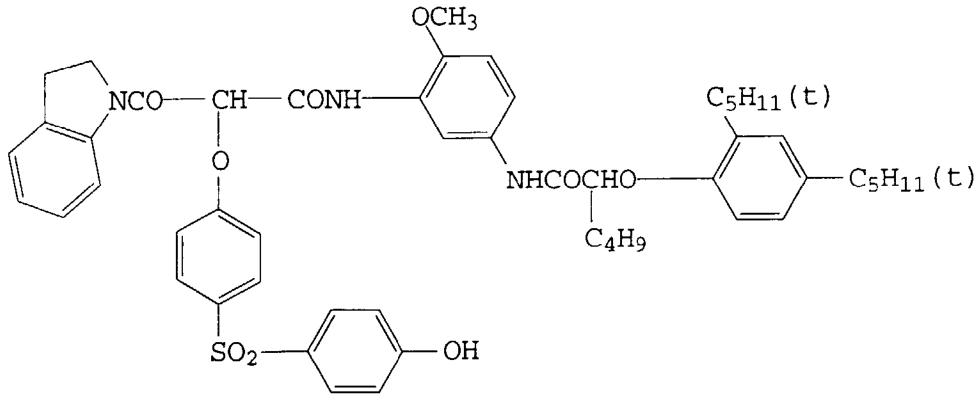

These yellow couplers can be synthesized in accordance with the method described in Japanese Patent OPI Publication Nos. 63-123047, 4-9051 and 4-124661.

Practical examples of the above-mentioned couplers are preferably compounds described in Japanese Patent O.P.I. Publication No. 241345/1991, pp. 5 through 9 and compounds represented by Y-I-1 through Y-I-55. In addition, compounds described in Japanese Patent O.P.I. Publication No. 209466/1991, pp. 11 through 14 and compounds represented by Y-1 through Y-30 are also preferably used.

The above-mentioned yellow couplers are preferably 1 x $10^{-3}$ through 1 mol, and more preferably 1 x $10^{-2}$ through 8 x $10^{-1}$ mol per mol of silver halide in the silver halide emulsion layer.

The couplers used in the present invention are respectively preferably lx $10^{-3}$ through 1 mol, and more preferably 1 x $10^{-2}$ through 8 x $10^{-1}$ mol per mol of silver halide in the silver halide emulsion layer.

When an oil-in-water emulsification dispersion method is employed for adding couplers and other organic compounds used for the light-sensitive material of the present invention, in a water-insoluble high boiling organic solvent whose boiling point is 150°C or more, a low boiling and/or water-soluble organic solvent are combined if necessary and dissolved. In a hydrophilic binder such as an aqueous gelatin solution, the above-mentioned solutions are emulsified and dispersed by the use of a surfactant. As a dispersing means, a stirrer, a homogenizer, a colloidal mill, a flow jet mixer and a supersonic dispersing machine may be used.

After dispersion, concurrently with dispersion, a step to remove a low boiling organic solvent may be added. As the high boiling organic solvent capable of being used for dissoluting a coupler for dispersion, phthalic acid esters such as dioctylphthalate, diisodecylphthalate and dibutylphthalate, photsphoric acid ester such as tricresylphosphate and trioctylphosphate and phosphineoxides such as trioctylphosphie oxide are preferable used. The dielectric constant of the high boiling organic solvent is preferably 3.5 through 7. In addition, two or more kinds of the high boiling organic solvent may be used in combination.

As the high boiling organic solvent, the specifically preferable compounds are those represented by [HBS-I] and [HBS-II] described in Japanese Patent O.P.I. Publication No. 95283/1994, page 22, and more specifically preferable compounds are those represented by [HBS-II]. Practical compounds are compounds I-1 through II-95 described in Japanese Patent O.P.I. Publication No. 124568/1990, page 53 through 68.

As a surfactant used for adjusting surface tension when dispersing or coating photographic additives, the preferable compounds are those containing a hydrophobic group having 8 through 30 carbon atoms in a molecule and a sulfonic acid group or its salts. Practically, A-1 through A-11 described in Japanese Patent O.P.I. Publication No. 26854/1989 are cited. In addition, surfactants wherein a fluorine atom is substituted to an alkyl group are also preferably used. The above-mentioned dispersing solutions are added to a coating solution ordinarily containing a silver halide emulsion. Time from dispersion until addition to the coating solution and the time from addition to the coating solution until coating are preferable to be short. They are respectively preferably within 10 hours, more preferably within 3 hours and the most preferably within 20 minutes.

To each of the above-mentioned couplers, for preventing color fading of the dye image formed due to light, heat and humidity, an anti-fading agent may be added in combination. The preferable compounds for a magenta dye are phenyleter type compounds represented by Formulas I and II in Japanese Patent O.P.I. Publication No. 66541/1990, phenol type compounds represented by Formula IIIB described in Japanese Patent O.P.I. Publication No. 174150/1991, amine type compounds represented by Formula A described in Japanese Patent O.P.I. Publication No. 90445/1989 and metallic complexes represented by Formulas XII, XIII, XIV and XV described in Japanese Patent O.P.I. Publication

No. 182741/1987. The preferable compounds for a yellow dye and a cyan dye are compounds represented by Formula I' described in Japanese Patent O.P.I. Publication No. 196049/1989 and compounds represented by Formula II described in Japanese Patent O.P.I. Publication No. 11417/1993.

It is preferable that a compound reacting with the oxidation product of a color developing agent is added to a layer located between light-sensitive layer and a light-sensitive layer for preventing color staining and that the compound is added to the silver halide emulsion layer for improving fogging. As a compound for such purposes, hydroquinone derivatives are preferable, and dialkylhydroquinone such as 2,5-di-t-octyl hydroquinone are more preferable. The specifically compound is a compound represented by Formula II described in Japanese Patent O.P.I. Publication No. 133056/1992, and compounds II-1 through II-14 described in the above-mentioned specification pp. 13 through 14 and compound 1 described on page 17.

In the light-sensitive material of the present invention, it is preferable that static fogging is prevented and light-durability of the dye image is improved by adding a UV absorber. The preferable UV absorber is benzotriazoles. The specifically preferable compounds are those represented by Formula III-3 in Japanese Patent O.P.I. Publication No. 250944/1989, those represented by Formula III described in Japanese Patent O.P.I. Publication No. 66646/1989, UV-1L through UV-27L described in Japanese Patent O.P.I. Publication No. 187240/1988, those represented by Formula I described in Japanese Patent O.P.I. Publication No. 1633/1992 and those represented by Formulas (I) and (II) described in Japanese Patent O.P.I. Publication No. 165144/1993.

When an oil-soluble dye and a pigment are contained, in the light-sensitive material of the present invention, it is so preferable because white background is improved. Typical practical examples of the oil-soluble dye are compounds 1 through 27 described in Japanese Patent O.P.I. Publication No 842/1990, pp. (8) through (9).

In the light-sensitive material of the present invention, gelatin is preferably used as a binder. Specifically, gelatin wherein hydrogen peroxide processing is provided to a gelatin extraction solution for removing colored component of gelatin, raw material ossein was subjected to hydrogen peroxide processing for extraction and permeability have been improved by the use of ossein manufactured from uncolored raw bone.

Gelatin used for the present invention may be any of an alkaline-processed ossein gelatin, an acid-processed gelatin, gelatin derivatives and denauted gelatin. Specifically, the alkaline-processed ossein gelatin is preferable.

It is preferable that the permeability of the gelatin used in the light-sensitive material of the present invention is 70% or more, when a 10% solution is prepared and its permeability for 420 nm is measured by the use of a spectrophotometer.

The strength of jelly of the gelatin used in the present invention (by means of a Baggy method) is preferably 250 or more and more preferably 270 g or more.

The total weight of gelatin contained on the image forming surface side of the light-sensitive material of the present invention is preferably less than 11 $g/m^2$. With regard to the lower limit, there is no specific limit. However, 3.0 $g/m^2$ or more is preferable from a viewpoint of photographic performance. The amount of gelatin is calculated in conversion to the weight of gelatin that contains water of 11.0% when measured through a water measurement method described in the Baggy method.

As a hardener for the above-mentioned binders, a vinylsulfone type hardener and a chlorotriadine type hardener are preferably used independently or two or more of them are used in combination. Compounds described in Japanese Patent O.P.I. Publication Nos. 249054/1986 and 245153/1986 are preferably employed. It is also preferable to add antiseptics and anti-mildew agents described in Japanese Patent O.P.I. Publication No. 157646/1991 in a colloidal layer for preventing propagation of mildew and bacteria which adversely affect photographic performance and image storage stability.

The yellow image forming layer, the magenta image forming layer and the cyan image forming layer of the present invention are laminated and coated on a support. Any order of laminating /coating from the support are allowed. One preferable embodiment is that, from the support, the cyan image forming layer, the magenta image forming layer and the yellow image forming layer. In addition, if necessary, a black image forming layer, an intermediate layer, a filter layer and a protective layer may be provided.

In the light-sensitive material of the present invention, the reflective density of raw sample at the maximum wavelength of the spectral sensitivity in the cyan image forming silver halide emulsion layer is preferably 0.7 or more.

The light-sensitive material of the present invention is obtained by incorporating a colored material such as a dye having absorption at the above-mentioned wavelength and black colloidal silver in any of photographic structural layers of the present invention. In the light-sensitive material of the present invention, a water-soluble dye may be added to an arbitrary silver halide emulsion layer and/or other hydrophilic colloid photographic structural layer. In addition, in the light-sensitive material of the present invention, a dye having at least one of a carboxyl group, a sulfonamide group and a sulfamoyl group may be incorporated by solid-dispersion in an arbitrary silver halide emulsion layer and/or other hydrophilic colloid photographic structural layer.

As a dye having at least one of a carboxyl group, a sulfonamide group and a sulfamoyl group, compounds represented by Formulas [I] through [IX] described in Japanese Patent O.P.I. Publication No. 95283/1994, pp. 14 through

16 may be cited.

As practical examples of dyes represented by the above-mentioned Formula [I} through {VIII}, I-1 through VIII-7 described in Japanese Patent O.P.I. Publication No. 18545/1992 are cited. However, the present invention is not limited thereto.

There is no limit to a layer to which the above-mentioned dyes and colloidal silver are added. However, it is preferable that they are added to a non-sensitive hydrophilic colloidal layer between the support and an emulsion layer closest to the support.

The silver halide in the present invention may be optically sensitized by means of a conventional sensitizing dye. combination use of sensitizing dyes used for super sensitization of an internal latent image type silver halide emulsion and a negative type silver halide emulsion is also useful for the silver halide emulsion of the present invention. With regard to sensitizing dyes, see Research Disclosure (hereinafter, abbreviated as RD) 15162 and 17643.

In the present invention, a monochromatic image formed on processing has an average gradient between a density of 0.3 plus a minimum density and a density of 0.8 plus a minimum density of not less than 2.0, preferably not less than 2.6.

The higher average gradient, the more preferable. In view of actual photographic emulsions and processing, however, the gradient up to 15 is practically used. The gradient exceeding 15 may be usable.

The word, "monochromatic image" refers to a yellow image, magenta image or cyan image. In a photographic material having a black image forming layer, a black image formed in the black image forming layer is also included. At least one of these monochromatic images has the average gradient as above and preferably, all of them have the average gradient as above.

To the light-sensitive material of the present invention, it is preferable to add compounds which regulate the gradation of a leg portion. The preferable compounds are those represented by Formula [AO-II] described in Japanese Patent O.P.I. Publication No. 95283/1994, page 17. As an example of preferable compounds, compounds II-1 through II-8 described on page 18 of the above-mentioned specification are given.

Formula (AO-II)

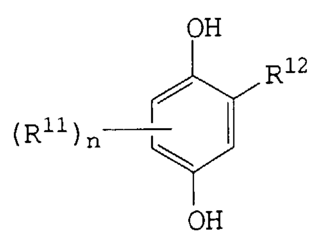

In the formula, $R^{11}$ and $R^{12}$ is a hydrogen atom or an alkyl group having 5 or less carbon atoms such as methyl, ethyl, i-propyl, butyl, t-butyl, pentyl t-pentyl or neo-pentyl; n is an integer of 1 to 3.

Exemplary examples of a compound represented by formula (AO-II) are shown as below, but the compound is not limited thereto.

II-1

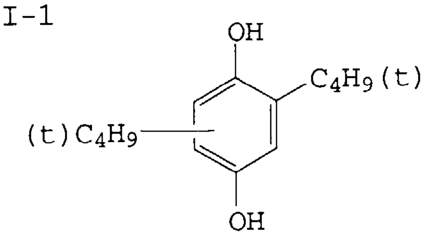

II-2

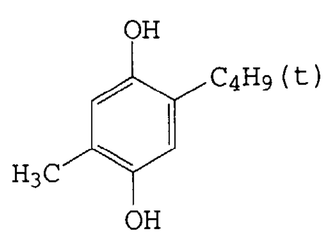

II-3

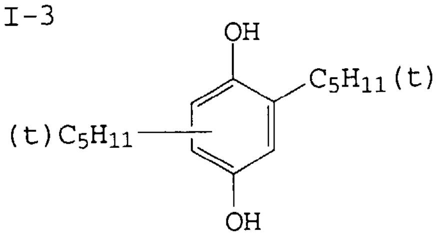

II-4

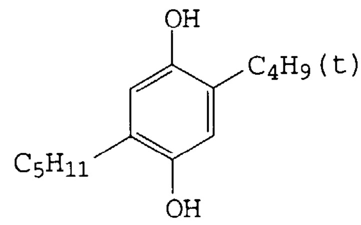

II-5

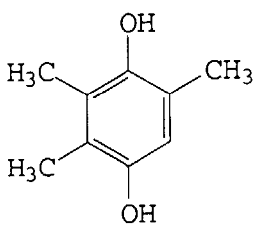

II-6

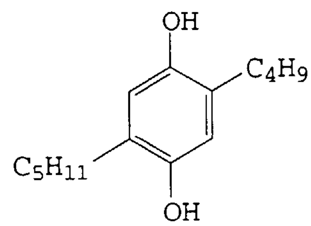

II-7

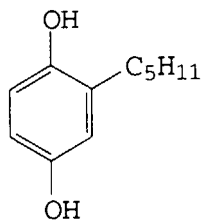

II-8

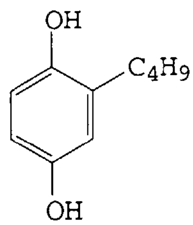

The added amount of the above-mentioned [AO-II] is preferably 0.001 through 0.50 g/$m^2$, and more preferably 0.005 through 0.20 g/$m^2$. The compound may be used independently, or two or more thereof may be used in combination. In addition, a quinone derivative having a carbon number of 5 or more may be added to the compound of [AO-II] to be used. However, in any cases, the amount used is preferably in a range of 0.001 through 0.50 g/$m^2$ as a whole.

Fogging processing in the internal latent image type direct positive type image formation used in the present invention preferably may be conducted by providing entire exposure or by the use of a compound producing a fogging nucleus, i.e., a fogging agent.

The entire exposure is conducted by exposing a light-sensitive material uniformly and overwhelmingly after immersing the light-sensitive material subjected to image exposure in a developing solution or other aqueous solutions or wetting. Here, as a light source used, any light source may be used provided that has a light of light-sensitive wavelength region of the above-mentioned photographic light-sensitive material. In addition, high illuminance beam such as a flash light may be given for a short time. A faint light may be given for a long time. In addition, the time of entire exposure can be varied widely depending upon the kind of the above-mentioned photographic light-sensitive material, photographic processing conditions and the kind of light source used so as that the most superior positive image can be obtained.

It is the most preferable that the exposure amount of the entire exposure gives a certain range of exposure amount depending a combination with the light-sensitive material. Ordinarily, when excessive exposure amount is given, the increase of the minimum density and desensitization is resulted in, which tends to cause the reduction of image quality.

As a technology of a fogging agent capable of being used in the present invention, a technology described in Japanese Patent O.P.I. Publication No. 95283/1994, page 18, right column, line 39 through page 19, left column, line 41 is preferably used.

It is preferable to incorporate a fluorescent brightening agent in a light-sensitive material of the present invention and/or a processing solution which processes the light-sensitive material of the present invention in terms of improving white background.

The developing solution, the bleach-fixing solution and the stabilizing solution can process a light-sensitive material continuously while replenishing the developing solution for replenishing, the bleaching solution for replenishing, the bleach-fixing solution for replenishing and the stabilizing solution for replenishing. In the present invention, the replenishing amount of the developing solution is preferably 700 cc or less and more preferably 500 cc or less per 1 $m^2$ of the light-sensitive material. In such cases, the present invention can provide effective result. In the case of other processing solutions too, the replenishing amount of the developing solution is preferably 700 cc or less and more preferably 500 cc or less per 1 $m^2$ of the light-sensitive material. In such cases, the present invention can provide effective result.

The developing agent usable in the developing solution for use in developing the light-sensitive material of the present invention include ordinary silver halide developing agents such as hydroquinone, hydroxybenzenes, aminophenols, 3-pyrazolones, ascorbic acid and its derivatives, reductones, phenylenediamines, and mixtures thereof.

Specifically, are cited hydroquinone, aminophenol, N-methylaminophenol, 1-phenyl-3-pyrazolidone, 1-phenyl-4,4-dimethyl-3-pyrazolidone, 1-phenyl-4-methyl-4-hydroxymethyl-3-pyrazolidone, ascorbic acid, N.N-diethylaminotoluidine, 4-amino-3-methyl-N-ethyl-N-(p-methanesulfonamidoethyl)-aniline, 4-amino-3-methyl-N-ethyl-N-(β-hydroxyethyl)aniline, 4-amino-N-ethyl-N-(β-hydroxyethyl)aniline and 4-amino-3-methyl-N-ethyl-N-(γ-hydroxypropyl)aniline.

Furthermore, in the present invention, it is preferable to use a developing agent represented by the following formula (D).

Formula (D)

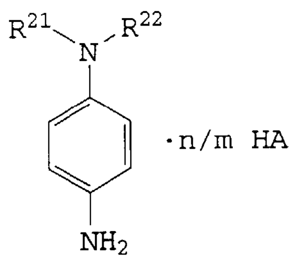

In the formula, $R^{21}$ and $R^{22}$ each represent a substituent, which may be the same with or different from each other and may be combined with each other to form a ring; HA represents an organic or inorganic acid; m is an integer except for 0 and n is an integer. $R^{21}$ and $R^{22}$ each are preferably an alkyl group, aryl group or cycloalkyl group, more preferably an alkyl group. These groups may be substituted. Further preferably, $R^{22}$ is a hydroxy alkyl group or alkoxyalkyl group.

Examples of the compound represented by formula (D) are shown as below.

D-1

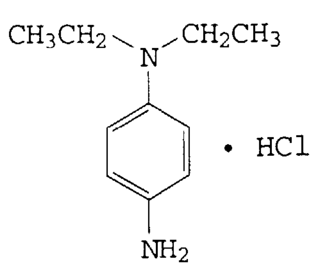

D-2

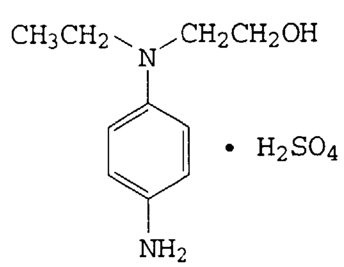

D-3

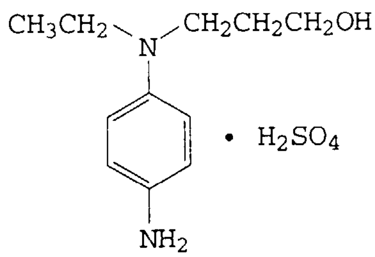

D-4

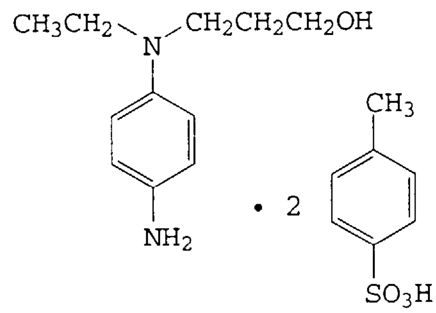

D-5

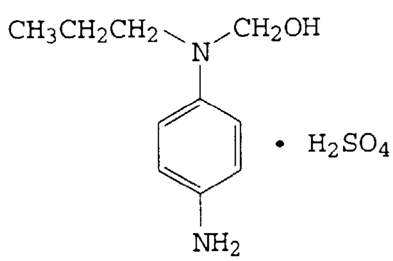

D-6

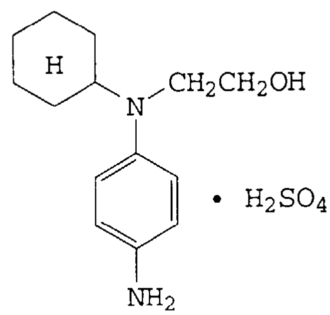

D-7

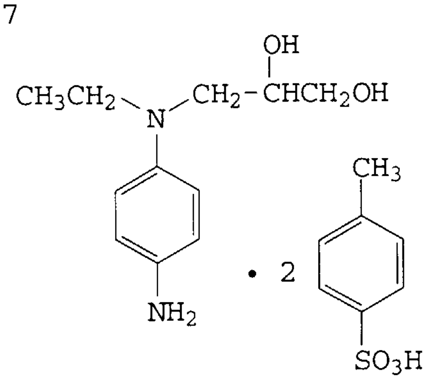

D-8

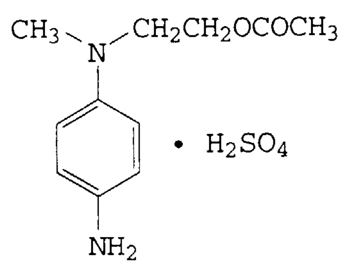

D-9

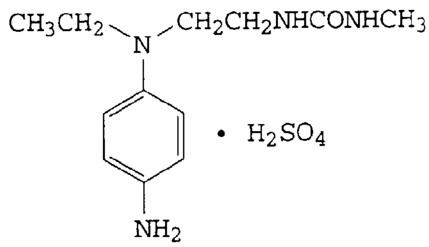

D-10

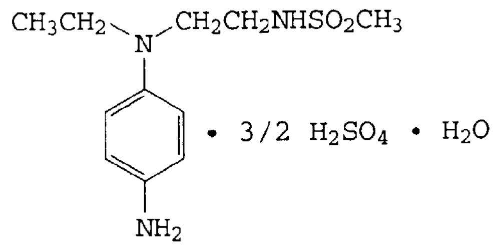

D-11

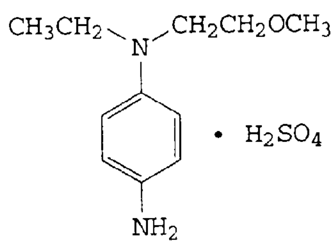

D-12

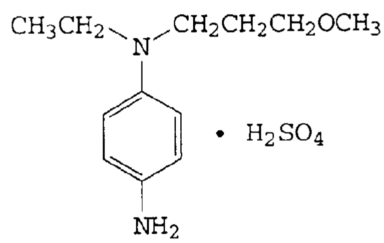

D-13

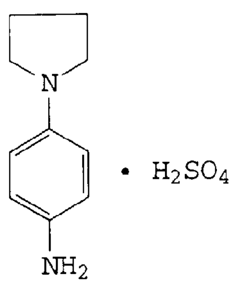

D-14

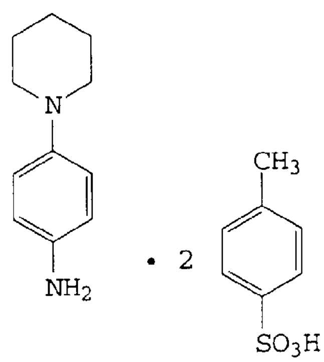

D-15

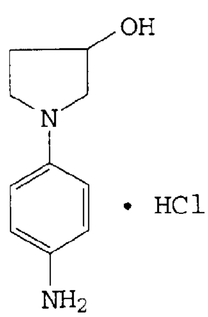

D-16

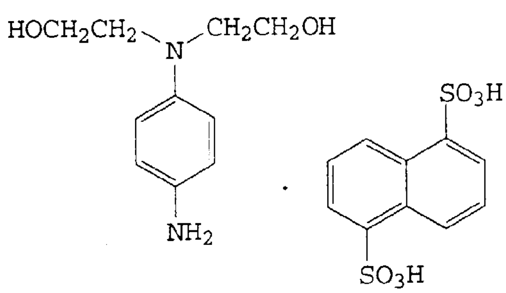

D-17

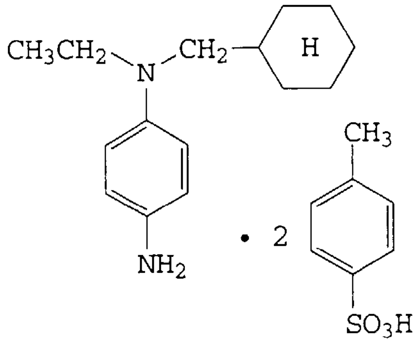

D-18

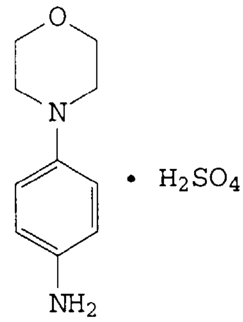

It is possible to incorporate any of these anti-fogging agents into the silver halide emulsion so as to have the anti-fogging agent react with the silver halide while being immersed in a high pH aqueous solution.

The developing solution used in the present invention may further contain a specific fogging agent and the development restrainer. Alternatively, it is possible to arbitrarily incorporate such photographic additives for a developing solution into the component layer(s) of the photographic light-sensitive material.

For the silver halide photographic light-sensitive material in the present invention there may be used known photographic additives.

The above-mentioned known photographic additives include the following compounds described in Research Disclosure RD 17643 and RD 18716.

| | RD 17643 | | RD 18716 | |
|---|---|---|---|---|
| Additives | Page | Section | Page | Section |
| Chemical sensitizer | 23 | III | 648 | upper right |
| Sensitizing dye | 23 | IV | 648 | upper right |
| Development accelarator | 29 | XXI | 648 | upper right |
| Antifoggant | 24 | VI | 649 | lower right |
| Stabilizer | 24 | VI | 649 | lower right |
| Antistaining agent | 25 | VII | 650 | left to right |
| Image stabilizer | 25 | VII | | |
| UV absorbent | 25-26 | VII | 649<br>650 | right to<br>left |
| Filter dye | 25-26 | VII | 649<br>650 | right to<br>left |
| Brightening agent | 24 | V | | |
| Hardener | 26 | X | 651 | right |
| Coating aid | 26-27 | XI | 650 | right |
| Surfactant | 26-27 | XI | 650 | right |
| Plasticizer | 27 | XII | 650 | right |
| Slippage agent | 27 | XII | 650 | right |
| Antistatic agent | 27 | XII | 650 | right |
| Matting agent | 28 | XVI | 650 | right |
| Binder | 29 | IX | 651 | right |

As a support usable in the light-sensitive invention of the present invention, those described in the above-mentioned RD 17643, page 28 and RD 18716, page 647 are cited. Suitable supports include polymer films and papers. These may be provided with additional processing for enhancing adhesivity and anti-static property.

For forming an image by the use of the light-sensitive material of the present invention, it is preferable to employ a light source unit scanning exposure type automatic processing machine. As practical example of an equipment or

system for forming a specifically preferable image, KonsensusL, Konsensus570 and KonsensusII are cited.

It is preferable to apply the present invention to a light-sensitive material wherein a developing agent is not incorporated in the light-sensitive material. Specifically, it is preferable to apply the present invention to the light-sensitive material, having a reflective support, for forming an image for direct appreciation. For example, the light-sensitive material for color proof is cited.

## EXAMPLES

The present invention is illustrated in further detail by the following examples, but the present invention is not limited thereto.

Example 1

(Preparation of emulsion EM-P1)

To an aqueous ossein gelatin solution at a controlled temperature of 40°C were added both an aqueous ammoniacal silver nitrate solution and an aqueous potassium bromide and a sodium chloride solution (at a molar KBr:NaCl ratio of 95:5) simultaneously in a controlled double-jet precipitation process, whereby a cubic silver chlorobromide core emulsion having an average grain diameter of 0.30 μm was obtained. During the above process, pH and pAg were controlled so as to enable the obtaining of cubic crystal grains.

The obtained core emulsion further had an aqueous ammoniacal silver nitrate solution and an aqueous potassium bromide and sodium chloride solution (at a molar KBr:NaCl ratio of 40:60) added simultaneously thereto in the controlled double-jet precipitation process to continue formation of a shell phase to cover over the core grain of the above emulsion until the average grain diameter was 0.42 μm. In this instance, pH and pAg were controlled so that cubic grains wereobtained.

To the above emulsion, after washingto remove all water-soluble salts, gelatin was added to obtain emulsion EM-P1. The distribution broadness of the grain diameters of the emulsion EM-1 was 8%.

(Preparation of emulsion EM-P2)

To an aqueous ossein gelatin solution at a controlled temperature of 40°C, were added both an aqueous ammoniacal silver nitrate solution and an aqueous potassium bromide and a sodium chloride solution (at a molar KBr:NaCl ratio of 95:5) simultaneously using the controlled double-jet precipitation process, whereby a cubic silver chlorobromide emulsion of an average grain diameter of 0.18 μm was obtained. In this instance, pH and pAg were also controlled so that cubic silver halide grains can be obtained.

The core emulsion thus produced had further an aqueous ammonical silver nitrate solution and an aqueous potassium bromide and a sodium chloride solution (at a molar KBr:NaCl ratio of 40:60) added simultaneously employing the controlled double-jet precipitation process to continue formation of a shell phase to cover over the above core grain to an average grain diameter of 0.25 μm, during which process pH and pAg were controlled so that cubic silver halide grains can be obtained.

To the above prepared emulsion, after washing to remove the water-soluble salts, gelatin was added to obtain emulsion EM-P2. The distribution broadness of the grain diameters of the emulsion EM-P2 was 8%.

(Preparation of blue-sensitive emulsion)

Emulsion EM-P1 was spectrally sensitized most suitably by adding a sensitizing dye BS-1, and compound T-1 was added in an amount of 600 mg per mol of silver, whereby a blue-sensitive emulsion EM-B1 was prepared.

(Preparation of green-sensitive emulsion)

A green-sensitive emulsion EM-G1 was prepared in the same manner as in blue-sensitive emulsion Em-B1 except that sensitizing dye GS-1 was added to emulsion EM-P2 for most suitable color sensitization.

(Preparation of red-sensitive emulsion)

A red-sensitive emulsion EM-R1 was prepared in the same manner as in blue-sensitive emulsion Em-B1 except that sensitizing dyes RS-1 and RS-2 were added to emulsion EM-P2 for most suitable color sensitization.

(Preparation of infrared-sensitive emulsion)

An infrared-sensitive emulsion EM-IR was prepared in the same manner as in blue-sensitive emulsion Em-B1 except that sensitizing dyes IRS-1 was added to emulsion EM-P1 for most suitable color sensitization.

T-1: 4-hydroxy-6-methyl-1,3,3a,7-tetrazaindene

On a paper pulp reflective support of 110 µm thickness wherein a high density was laminated on one side and a fused polyethylene containing a dispersed anatase type titanium oxide at a content amount of 15 weight % on the other side, the above-mentioned each emulsion of Em-B1, Em-G1, Em-R1 and Em-IR and each layer having the following constitution were coated on a side having the polyethylene layer containing titanium oxide, and on the opposite side therefrom, 6.00 g/$m^2$ of gelatin and 0.65 g/$m^2$ of a silica matting agent were coated. Thus, multi-layered silver halide color photographic light-sensitive material sample-1 was prepared. Incidentally, as a hardener, H-1 and H-2 were added. As a coating aid and a dispersion aid, surfactants SU-1, SU-2 and SU-3 were added and prepared.

SU-1: Sodium sulfo-di-2-ethylhexylsuccinate
SU-2: Sodium sulfo-di(2,2,3,3,4,4,5,5-octafluoropentylsuccinate
SU-3: Sodium tri-i-propylnaphthalenesulfonate
H-1: Sodium 2,4-dichloro-6-hydroxy-s-triazine
H-2: Tetrakis(vinylsulfonylmethyl)methane

| Layer | Constitution | Coating wt(g/$m^2$) |
|---|---|---|
| Layer 9 | Gelatin | 1.60 |
| (UV absorbing | UV absorbent (UV-1) | 0.070 |
| layer) | UV absorbent (UV-2) | 0.025 |
| | UV absorbent (UV-3) | 0.120 |
| | Silica matting agent | 0.01 |
| Layer 8 | Gelatin | 1.10 |
| (Blue-sensitive | Blue-sensitive emulsion (EM-B1) | 0.36 |
| layer) | Yellow coupler (Y-1) | 0.19 |
| | Yellow coupler (Y-2) | 0.19 |
| | Restrainers (T-1, T-2, T-3)(mol ratio 1:1:1) | |

| | | |
|---|---|---|
| | | 0.004 |
| | Antistain agent (HQ-1) | 0.004 |
| | High boiling organic solvent (SO-1) | 0.30 |
| Layer 7 | Gelatin | 0.94 |
| (Intermediate | Anti-color-mixing agent | |
| layer) | (HQ-2 and HQ-3)(in equal amount) | 0.02 |
| | High boiling organic solvent (SO-2) | 0.05 |
| | Anti-irradiation dye (AI-3) | 0.03 |
| Layer 6 | Gelatin | 0.45 |
| (Yellow colloidal | Yellow colloidal silver | 0.11 |
| layer) | Anti-color-mixing agent (HQ-1) | 0.03 |
| | High boiling organic solvent (SO-2) | 0.008 |
| | Polyvinyl pyrrolidone | 0.04 |
| Layer 5 | Gelatin | 0.45 |
| (Intermediate | Anti-color-mixing agent (HQ-2) | 0.014 |
| layer) | Anti-color-mixing agent (HQ-3) | 0.014 |
| | High boiling organic solvent (SO-2) | 0.006 |
| Layer 4 | Gelatin | 1.25 |
| (Green-sensitive | Green-sensitive emulsion (EM-G1) | 0.32 |
| | Magenta coupler (M-1) | 0.25 |
| | Yellow coupler (YC-3) | 0.06 |
| | Antistain agent (HQ-1) | 0.035 |
| | Restrainers (T-1, T-2, T-3)(mol ratio 1:1:1) | |

| | | |
|---|---|---|
| | | 0.0036 |
| | High boiling organic solvent (SO-1) | 0.38 |
| Layer 3 (Intermediate layer) | Gelatin | 0.80 |
| | Anti-color-mixing agent (HQ-2) | 0.03 |
| | Anti-color-mixing agent (HQ-3) | 0.01 |
| | Antiirradiation dye (AI-1) | 0.04 |
| | High boiling organic solvent (SO-2) | 0.10 |
| Layer 2 (Red sensitive layer) | Gelatin | 0.90 |
| | Red-sensitive emulsion (EM-R1) | 0.27 |
| | Cyan coupler (C-1) | 0.35 |
| | Antistain agent (HQ-1) | 0.02 |
| | Strainers (T-1, T-2, T-3)(mol ratio 1:1:1) | 0.002 |
| | High boiling organic solvent (SO-1) | 0.18 |
| Layer 1 (White pigment containing layer) | Gelatin | 1.20 |
| | Fluid paraffin | 0.55 |
| | Anti-irradiation dye (AI-2) | 0.055 |
| | Titanium oxide | 0.50 |
| Support | Polyethylene laminated paper (containing minute amount of colorant) | |

The silver coating weight in above is in silver equivalents.

BS–1

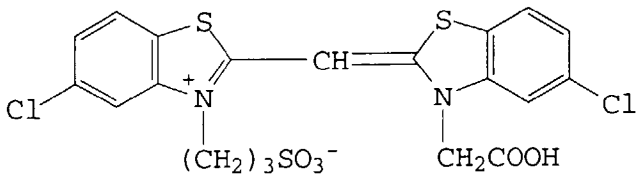

GS–1

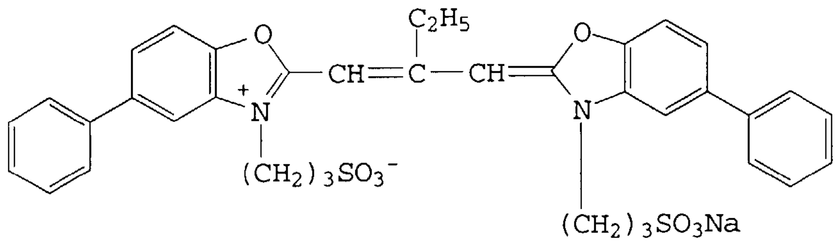

RS–1

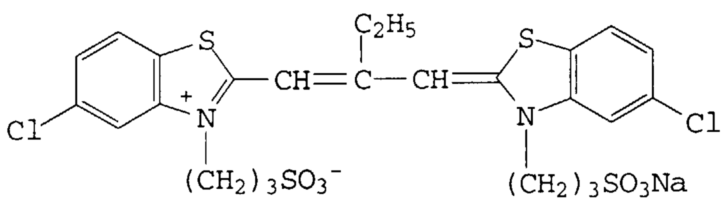

RS–2

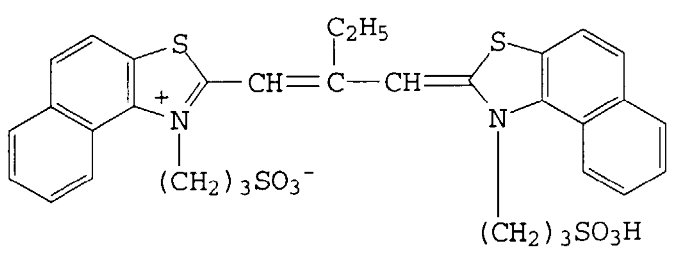

IRS-1

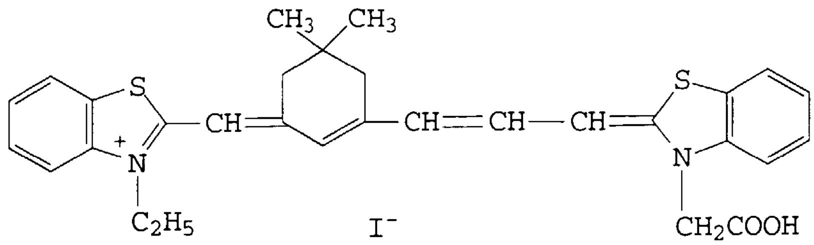

Y-1

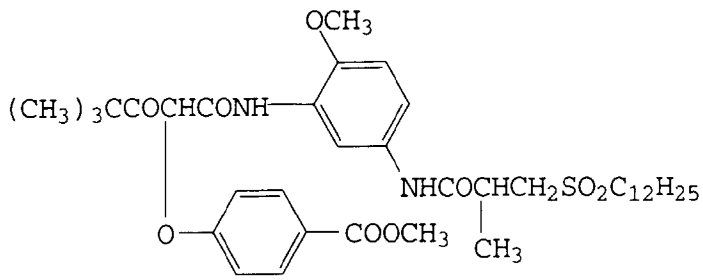

Y-2

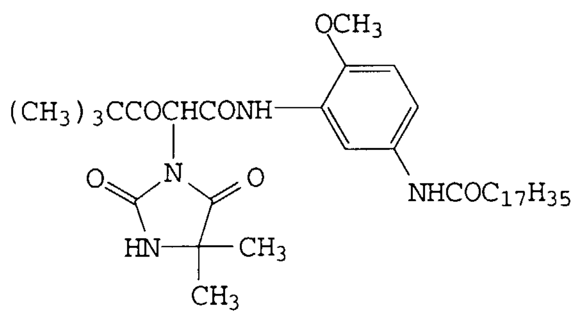

Y-3

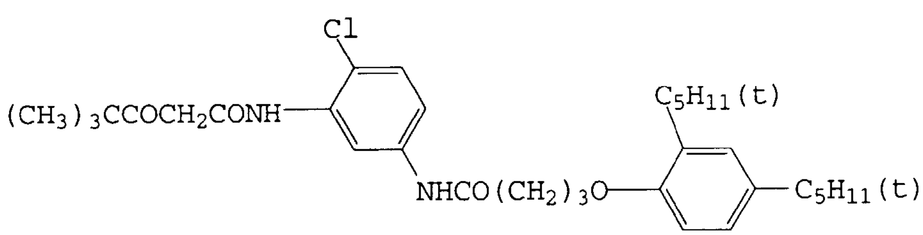

M-1

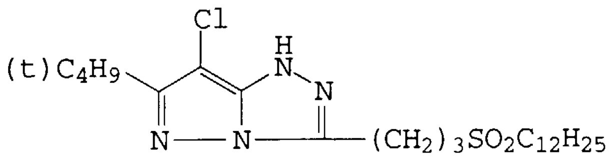

C-1

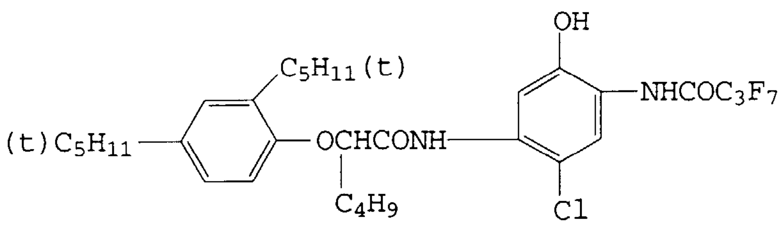

UV-1

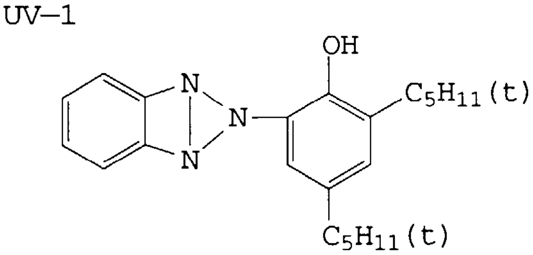

UV-2

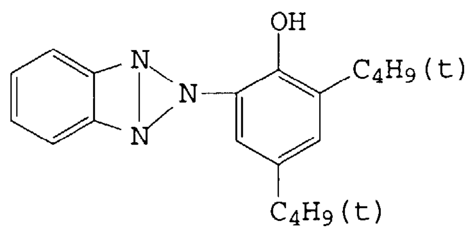

UV-3

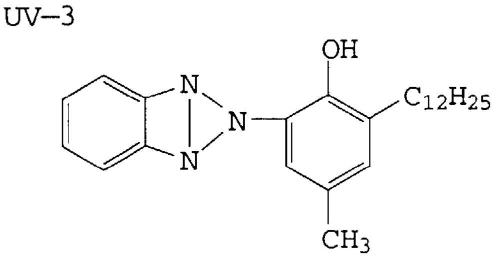

AI-1

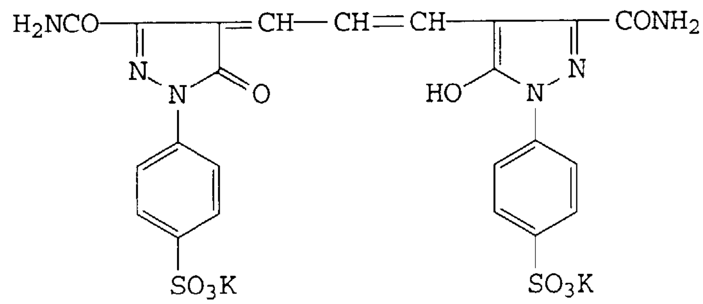

AI-2

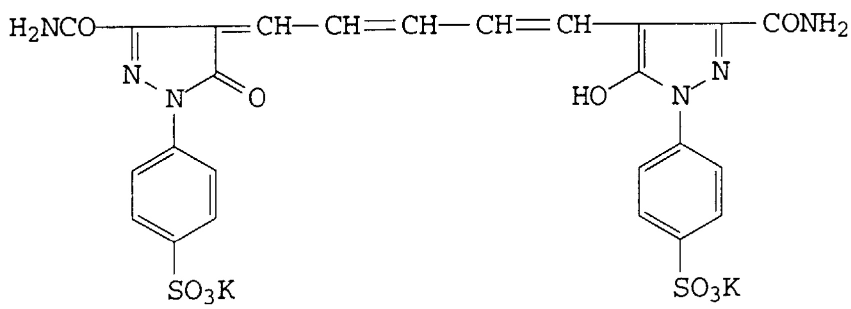

AI-3

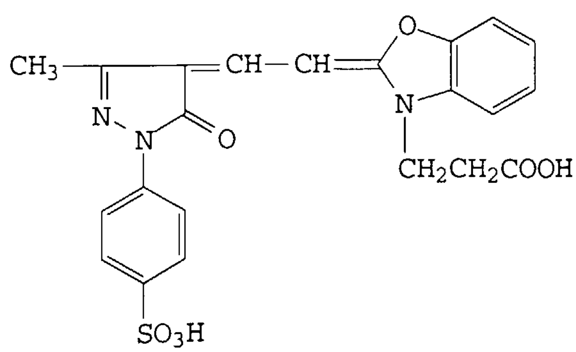

SO-1: Tri(n-octyl)phosphine oxide
SO-2: Di (o-decyl)phthalate
HQ-1: 2,5-di(t-butyl)hydroquinone
HQ-2: 2,5-di[(1,1-dimethyl-4-hexyloxycarbonyl)butyl)butyl] hydroquinone
HQ-3: A mixture of 2,5-di-sec-dodecylhydroquinone, 2,5-di-sectetradecylhydroquinone and 2-sec-dodecyl-5-sec-tetradecyl hydroquinone at weight ratio of 1:1:2.
T-2: 1-(3-acetoamidephenyl)-5-mercapto tetrazole
T-3: N-benzyladenine

Next, sample 1-2 was prepared in the same manner as in Sample 1-1.

In Sample 1-2, the 10th layer and the 11th layer were coated in this order from a support side between the 1st layer and the 2nd layer of Sample 1-1.

| | | Coating weight ($g/m^2$) |
|---|---|---|
| Layer 11 | Gelatin | 0.80 |
| (Intermediate | Anti-color-mixing agent (HQ-2) | 0.03 |
| layer) | Anti-color-mixing agent (HQ-3) | 0.01 |
| | High boiling solvent (SO-2) | 0.01 |
| Layer 10 | Gelatin | 1.25 |
| (Infrared- | Infrared-sensitive silver bromochloride | |
| sensitive layer) | emulsion (EM-IR) | 1.00 |
| | Yellow coupler (Y-2) | 0.50 |
| | Magenta coupler (M-1) | 0.20 |
| | Cyan coupler (C-1) | 0.35 |
| | Anti-color-mixing agent (HQ-1) | 0.04 |
| | High boiling solvent (SO-1) | 2.00 |
| | Strainers (T-1, T-2, T-3)(mol ratio 1:1:1) | 0.005 |

Incidentally, in Sample 1-2, when sensitivity of wavelengths showing the maximum of each spectral sensitivity of the blue-sensitive emulsion, the green-sensitive emulsion, the red-sensitive emulsion and the infrared-sensitive emulsion was measured, the sensitivity of each emulsion was higher than that of other three emulsions by 6 times or more.

The above-obtained Sample 1-1 was exposed to light under the following exposure condition-1 through a black halftone original and a cyan halftone original in close contact therewith, then exposed to light under the following exposure condition-2 through a black halftone original and a magenta halftone original in close contact therewith, and then further exposed to light under the following exposure condition-3 through a black image original and a yellow image original in close contact therewith.

The above-obtained Sample 1-2 was exposed to light under the following exposure condition-1 through and a cyan halftone original in contact therewith, then exposed to light under the following exposure condition-2 through a magenta halftone original in contact therewith, then exposed to light under the following exposure condition-3 through and a yellow halftone original in contact therewith and then exposed to light under the following exposure condition-4 through and a black halftone original in contact therewith.

As a halftone original, an original, prepared by means of the AM screen method, composed of dots of 300 lines per 1 inch was used. In addition, another original, prepared by means of the FM screening method, wherein dot size is almost 20 μm was used in combination. The number of dot per 1 $inch^2$ when the dot area ratio (dot percentage) is 40% was 90 x $10^3$ for the former original and 645 x $10^3$ for the latter original.

Each light-sensitive material subjected to the above-mentioned exposure was processed by means of the photographic processing process shown below for obtaining dye images composed of dots.

Exposure condition-1

Each light-sensitive material was exposed through a red filter (Wratten No. 26) and an ND filter to a white light for 0.5 seconds at a minimum exposure giving a minimum value of red density after development by adjusting the density of the ND filter. Exposure condition-2

Each light-sensitive material was exposed through a green filter (Wratten No. 58) and an ND filter to a white light for 0.5 seconds at a minimum exposure giving a minimum value of green density after development by regulating the density of the ND filter. Exposure condition-3

Each light-sensitive material was exposed through a blue filter (Wratten No. 47B) and an ND filter to a white light for 0.5 seconds at a minimum exposure giving a minimum value of blue density after development by regulating the density of the ND filter. Exposure condition-4

Each light-sensitive material was exposed through an infrared filter and an ND filter to a white light for 0.5 seconds at a minimum exposure giving a minimum value of black density after development by regulating the density of the ND filter.

The light source utilized for the above exposure conditions 1 to 3 was a daylight-type fluorescent lamp. In addition, the light source utilized for the above exposure condition 4 was a xenon lamp.

The resulting sample was processed according to the following process-1 (fresh solution processing). The fog exposure was carried out as follows. The sample was immersed in a 3 mm thick developing solution and subjected to uniform overall exposure.

A part of another sample was exposed to light under the same conditions as in the fresh solution processing, and processed in the same manner as in Processing-1. Sample 1-1 was running-processed till the replenishing amount of a developing solution replenisher reached three times the content of the developing solution tank in Process-1. Thereafter, samples were processed using the developing solution, bleach-fixing solution and stabilizing solution (running solution processing).

Among the obtained images, with regard to an image based on the black image original, the quality of dots whose dot is 5% and 40% were visually evaluated through a magnifier observation, and ranked by means of a 5-ranks method. In addition, the neutrality of the black image based on the black image original was measured by the use of a densitometer. Namely, blue density DB, green density DG and red density DR, obtained through the densitometer, at dot area of 40% were measured, and then, DB/DG and DR/DG were calculated. The calculated values of DB/DG and DR/DG are shown as values relative to 100 which is a value of an fresh solution.

| Processing procedure-1 | Temperature | Time |
|---|---|---|
| Immersing in developing solution | 37°C | 12 seconds |
| Light fogging | - | 12 seconds |
| Developing | 37°C | 95 seconds |
| Bleach-fixing | 35°C | 45 seconds |
| Stabilizing | 25-30°C | 90 seconds |
| Drying | 60-85°C | 40 seconds |

Compositions of the processing solutions

| (Color developing solution) | |
|---|---|
| Benzyl alcohol | 15.0 ml |
| Ceric sulfate | 0.015 g |
| Ethylene glycol | 8.0 ml |
| Potassium sulfite | 2.5 g |
| Potassium bromide | 0.6 g |
| Sodium chloride | 0.2 g |
| Potassium carbonate | 25.0 g |
| T-1 | 0.1 g |
| Hydroxylamine sulfate | 5.0 g |

(continued)

| (Color developing solution) | |
|---|---|
| Sodium diethylenetriaminepentaacetate | 2.0 g |
| 4-amino-N-ethyl-N-(β-hydroxyethyl)aniline sulfate | 4.5 g |
| Brightening agent (4,4'-diaminostilbenedisulfonic acid derivative) | 1.0 g |
| Potassium hydroxide | 2.0 g |
| Diethyl glycol | 15.0 ml |
| Water to make 100 ml, pH adjusted to 10.15. | |

Bleach-fixing solution

| | |
|---|---|
| Ferric ammonium diethylenetriaminepentaacetate | 90.0 g |
| Diethylenetrimainepentaacetic acid | 3.0 g |
| Ammonium thiosulfate (70% aqueous solution) | 180.0 ml |
| Ammonium sulfite (40% aqueous solution) | 27.5 ml |
| 3-mercapto-1,2,4-triazole | 0.15 g |

Adjust pH to 7.1 with potassium carbonate or glacial acetic acid, Water to make 1000 ml.

Stabilizing solution

| | |
|---|---|
| O-Phenylphenol | 0.3 g |
| Potassium sulfite (50% aqueous solution) | 12 ml |
| Ethylene glycol | 10.0 g |
| 1-hydroxyethylidene-1,1-diphosphonic acid | 2.5 g |
| Bismuth chloride | 0.2 g |
| Zinc sulfate, heptahydrate | 0.7 g |
| Ammonium hydroxide (28% aqueous solution) | 2.0 g |
| Polyvinylpyrrolidone K-17 | 0.2 g |
| Brightening agent (4,4'-diaminostilbenedisulfonic acid derivative) | 2.0 g |
| Water to make 1 liter. | |

Adjust pH to 7.5 with ammonium hydroxide or sulfuric acid.

The stabilization treatment used the double bath countercurrent system.

The following are the prescriptions of replenishers necessary for conducting a continuous run of processing.

Color developing solution replenisher

| | |
|---|---|
| Benzyl alcohol | 18.5 ml |
| Ceric sulfate | 0.015 g |

| | |
|---|---|
| Ethylene glycol | 10.0 ml |
| Potassium sulfite | 2.5 g |
| Potassium bromide | 0.3 g |
| Sodium chloride | 0.2 g |
| Potassium carbonate | 25.0 g |
| T-1 | 0.1 g |
| Hydroxylamine sulfate | 5.0 g |
| Sodium diethylenetriaminepentaacetate | 2.0 g |
| 4-Amino-N-ethyl-N-(p-hydroxyethyl)aniline sulfate | 5.4 g |
| Brightening agent (4,42-diaminostilbene-disulfonic acid derivative) | 1.0 g |
| Potassium hydroxide | 2.0 g |
| Diethylene glycol | 18.0 ml |
| Water to make 1 liter, | |
| Adjust pH to 10.35. | |

Bleach-fixing solution replenisher

The same as the foregoing bleach-fixing bath.

Stabilizing solution replenisher

The same as the foregoing stabilizing bath.

The replenishing amount of each of the developing solution replenisher, bleach-fixing solution replenisher and stabilizing solution replenisher was 320 ml per $m^2$ of light-sensitive material.

By the use of Konsensus570 produced by Konica Corporation, color proof composed of halftone images were prepared. Incidentally, the processing was continuously conducted until the total amount of color developing solution replenisher replenished reaches an amount that is 3 times the solution amount of the color developing tank.

With regard to the dot quality, the dots were relatively evaluated in a manner that the most excellent dots were ranked as "5", and the most inferior dots were ranked as "1".

With regard to neutrality, the values of DB/DG and DR/Dgare shown to be relative to 100 which is a value of an initial solution.

Table 1

| Sample | Processing | AM screen | | | | FM screen | | | |
|---|---|---|---|---|---|---|---|---|---|
| | | Dot quality | | Neutrality | | Dot quality | | Neutrality | |
| | | 5% | 40% | 40% | | 5% | 40% | 40% | |
| | | | | DB/DG | DR/DG | | | DB/DG | DR/DG |
| 1-1 | Fresh solution | 3 | 4 | 100 | 100 | 3 | 2 | 100 | 100 |
| | Running-solution | 3 | 4 | 94 | 107 | 3 | 1 | 82 | 118 |
| 1-2 | Fresh solution | 4 | 4 | 100 | 100 | 4 | 4 | 100 | 100 |
| | Running-solution | 4 | 4 | 97 | 101 | 4 | 4 | 96 | 102 |

From Table 1, it can be understood that the sample of the present invention has excellent dot quality of the black image and little fluctuation caused by the processing of neutrality so that it is stable and excellent.

Example-2

Sample-2 was prepared in the same manner as in Sample 1-1 prepared in Example 1, provided that the following emulsion was additionally added in the layer 8, a blue-sensitive layer in Sample 1-1. In addition, the following emulsion was additionally added in the layer 4, a green-sensitive layer in Sample 1-1. In addition, the following emulsion was additionally added in the layer 2, a red-sensitive layer in Sample 1-1 are shown in Table 21. Except the foregoing, Sample-2 was prepared in the same manner as in Sample 1-1.

| | | Coating weight (g/m$^2$) |
|---|---|---|
| Layer 8 (Blue-sensitive layer) | Infrared-sensitive bromochloride emulsion (EM-IR) | 0.3 |
| Layer 4 (Green-sensitive layer) | Infrared-sensitive silver bromochloride emulsion (EM-IR) | 0.28 |
| Layer 2 (Red-sensitive layer) | Infrared-sensitive silver bromochloride emulsion (EM-IR) | 0.25 |

In Sample 2, when wavelengths showing the maximum of each spectral sensitivity of the blue-sensitive emulsion, the green-sensitive emulsion, the red-sensitive emulsion and the infrared-sensitive emulsion were measured, the sensitivity of each emulsion was higher than that of other three emulsions by 6 times or more.

The above-obtained Sample 2 was exposed to light under the following exposure condition-1 through and a cyan halftone image original in contact therewith, then exposed to light under the following exposure condition-2 through a magenta halftone image original in contact therewith, then exposed to light under the following exposure condition-3 through and a yellow halftone image original in contact therewith and then exposed to light under the following exposure condition-4 through and a black halftone image original in contact therewith.

The Sample 1-1 prepared in Example 1 was exposed to light under the following exposure condition-1 through a black halftone image original and a cyan halftone image original in contact therewith, then exposed to light under the following exposure condition-2 through a black halftone image original and a magenta halftone image original in contact therewith, and then exposed to light under the following exposure condition-3 through a black halftone image original and a yellow halftone image original in contact therewith.

With regard to the halftone original, the same original as one used in Example 1 was employed.

When conducting the exposure, a light from the light source was irradiated to the overall surface to be exposed (simultaneous overall exposure).

Next, in front of the light source, a slit-shaped window for exposure was installed. An exposure was conducted through this window, wherein the exposure unit was scanned on the light-sensitive material (scanning exposure).

On the light-sensitive material side of the above-mentioned window for exposure, a honeycomb-structured means was provided for improving parallelity of the light, and then, the above-mentioned scanning exposure was conducted again (honeycomb scanning exposure).

When conducting the above-mentioned overall exposure, scanning exposure and honeycomb scanning exposure, the yellow halftone original, the magenta halftone original, the cyan halftone original and the black halftone original were slipped from the position of the register mark showing the bench mark of the position of original by 20 μm respectively for exposure.

The neutrality of each of the resulting images wherein the yellow original, the magenta original, the cyan original and the black original were by 50% halftone image, respectively, was measured. Here, as an index of the neutrality, DR/DB was measured. The following Table shows the results thereof, provided that the DR/DB when the register of the dot is the normal position is defined to be 100, respectively.

Table 2

| | | AM (Register mark) | | FM (Register mark) | |
|---|---|---|---|---|---|
| Sample | Exposure means | Nomal position | Slippage position | Nomal position | Slippage position |
| 1-1 | Simultaneous overall exposure | 100 | 93 | 100 | 87 |
| | Scanning exposure | 100 | 93 | 100 | 87 |
| | Honeycomb scanning exposure | 100 | 93 | 100 | 87 |
| 2 | Simultaneous overall exposure | 100 | 94 | 100 | 90 |
| | Scanning exposure | 100 | 95 | 100 | 93 |
| | Honeycomb scanning exposure | 100 | 97 | 100 | 97 |

As is apparent from Table 2, in the case of Sample 1-1 which is out of the present invention, when a FM screen original was used, the neutrality was noticeably deteriorated when a fine slippage of the register occurred. On the contrary, in Sample 2 of the present invention, the deterioration of neutrality was reduced to be small. In other words, it can be seen that improvement is noticeable. Still more, the neutrality was improved in the scanning exposure compared to the entire exposure. In addition, when a means for improving parallelity was used, the neutrality was improved additionally so that a stable image was obtained against the disparity of the register.

Example 3

A photographic material sample 301 was prepared in a manner similar to sample 1-2 of Example 1, provided that the following silver halide emulsion (EM-IR) was further added to Layer 8 and the composition of Layer-10 was changed to the following.

| Layer | Constitution | Coating wt ($g/m^2$) |
|---|---|---|
| Layer 8 | Infrared-sensitive silver chlorobromide emulsion (EM-IR) | 0.34 |
| Layer 10 | Gelatin | 0.85 |
| (IR-sensitive layer) | Infrared-sensitive silver chlorobromide emulsion (EM-IR) | 0.66 |
| | Magenta coupler (M-1) | 0.20 |
| | Cyan coupler (C-1) | 0.35 |
| | Antistaining agent (HQ-1) | 0.04 |
| | High boiling solvent (SO-1) | 0.70 |
| | Restrainer (T-1:T-2:T-3 = 1:1:1) | 0.005 |

Sample 301 was subjected to exposure and processing and evaluated in the same manner as in Example 1. Results are shown in Table 3.

Table 3

| Sample | Processing | AM screen | | | | FM screen | | | |
|---|---|---|---|---|---|---|---|---|---|
| | | Dot quality | | Neutrality | | Dot quality | | Neutrality | |
| | | 5% | 40% | 40% | | 5% | 40% | 40% | |
| | | | | DB/DG | DR/DG | | | DB/DG | DR/DG |
| 3-1 | Fresh solution<br>Running-solution | 4<br>4 | 4<br>4 | 100<br>97 | 100<br>101 | 4<br>4 | 4<br>4 | 100<br>96 | 100<br>102 |

As can be seen from Table 3, the sample was excellent in dot quality of the black image and little in fluctuation caused by the processing of neutrality so that it was stable and excellent. It was proved that the black image formed met the following requirement represented in terms of L*a*b* chromaticity diagram.

$$a^{*2} + b^{*2} \leqq 10^2$$

Example 4

Preparation of UV-sensitive silver halide emulsion (Em-U1)

To an aqueous ossein gelatin maintained at 40°C were added an aqueous silver nitrate solution and an aqueous solution containing potassium bromide and sodium chloride (molar ratio, KBr:NaCl=1:99) by the controlled double jet method to prepare a silver bromochloride core emulsion comprised of cubic grains having an average size of 0.35 µm. The emulsion was chemically ripened at 70°C over a period of 80 min. by adding 2.5 mg of sodium thiosulfate, 2.0 mg of potassium chloroaurate and 10.0 mg of 1-phenyl-5-mercaptotetrazole, each per mol of silver. Subsequently, to this core emulsion were added an aqueous silver nitrate solution and an aqueous solution containing potassium bromide and sodium chloride (molar ratio, KBr:NaCl=1:99) by the controlled double jet method to form core/shell grains having an average size of 0.5 µm. After being washed to remove soluble salts, the emulsion was chemically ripened at 60°C over a period of 50 min. by adding 1 mg of sodium thiosulfate, 0.8 mg of potassium chloroaurate and 5.0 mg of 1-phenyl-5-mercaptotetrazole, each per mol of silver to obtain a UV-sensitive silver halide emulsion Em-U1.

Using this emulsion (Em-U1) and emulsions Em-B1, Em-G1 and Em-R1 which were used in Example 1, the following photographic component layers were coated on a polyethylene-laminated paper support to prepare a silver halide photographic light sensitive material sample 401.

| Layer | Constitution | Coating wt($g/m^2$) |
|---|---|---|
| Layer 11 | Gelatin | 1.60 |
| (protective layer) | Silica matting agent | 0.01 |

| | | |
|---|---|---|
| Layer 10 | Gelatin | 1.50 |
| (UV-sensitive | UV-sensitive emulsion (EM-U1) | 0.60 |
| layer) | Yellow coupler (Y-1) | 0.26 |
| | Magenta coupler (M-1) | 0.18 |
| | Cyan coupler (C-1) | 0.25 |
| | Antistaining agent (HQ-1) | 0.008 |
| | High boiling organic solvent (SQ-1) | 0.60 |
| Layer 9 | Gelatin | 1.60 |
| (UV absorbing | UV absorbent (UV-1) | 0.35 |
| layer) | UV absorbent (UV-2) | 0.12 |
| | UV absorbent (UV-3) | 0.60 |
| Layer 8 | Gelatin | 1.10 |
| (Blue-sensitive | Blue-sensitive emulsion (EM-B1) | 0.36 |
| layer) | Yellow coupler (Y-1) | 0.34 |
| | Restrainers (T-2, T-3)(mol ratio 1:1) | 0.0004 |
| | Antistaining agent (HQ-1) | 0.004 |
| | High boiling organic solvent (SO-1) | 0.27 |
| Layer 7 | Gelatin | 0.94 |
| (Inter-layer) | Anti-color-mixing agent (HQ-2 and HQ-3 in equal amount) | 0.02 |
| | High boiling organic solvent (SO-2) | 0.05 |
| | Anti-irradiation dye (AI-3) | 0.03 |

| | | |
|---|---|---|
| Layer 6 | Gelatin | 0.45 |
| (Yellow filter | Yellow colloidal silver | 0.11 |
| layer) | Anti-color-mixing agent (HQ-1) | 0.03 |
| | High boiling organic solvent (SO-2) | 0.008 |
| | Polyvinyl pyrrolidone | 0.04 |
| Layer 5 | Gelatin | 0.45 |
| (Inter-layer) | Anti-color-mixing agent (HQ-2) | 0.014 |
| | Anti-color-mixing agent (HQ-3) | 0.014 |
| | High boiling organic solvent (SO-2) | 0.006 |
| Layer 4 | Gelatin | 1.25 |
| (Green-sensitive) | Green-sensitive emulsion (EM-G1) | 0.32 |
| | Magenta coupler (M-1) | 0.22 |
| | Yellow coupler (Y-3) | 0.05 |
| | Antistain agent (HQ-1) | 0.035 |
| | Restrainers (T-2, T-3, mol ratio 1:1) | 0.00036 |
| | High boiling organic solvent (SO-1) | 0.33 |
| Layer 3 | Gelatin | 0.80 |
| (Intermediate | Anti-color-mixing agent (HQ-2) | 0.03 |
| layer) | Anti-color-mixing agent (HQ-3) | 0.01 |
| | High boiling organic solvent (SO-2) | 0.007 |
| | Antiirradiation dye (AI-1) | 0.04 |

| | | |
|---|---|---|
| Layer 2 | Gelatin | 0.90 |
| (Red sensitive | Red-sensitive emulsion (EM-R1) | 0.27 |
| layer) | Cyan coupler (C-1) | 0.27 |
| | Antistain agent (HQ-1) | 0.02 |
| | Restrainers (T-2, T-3, mol ratio 1:1) | 0.0002 |
| | High boiling organic solvent (SO-1) | 0.14 |
| Layer 1 | Gelatin | 1.20 |
| (Antihalation layer) | Antiirradiation dye (AI-2) | 0.055 |
| Layer 12 | Gelatin | 7.50 |
| (Back-side layer) | Silica matting agent | 0.65 |

The amount of silver halide emulsion in above is in silver equivalents. The coating weight of gelatin includes that of the silver halide emulsion.

Samples 402 to 414 were prepared in the same manner as Sample 401, except that a magenta coupler contained in Layer 4 was replaced by equimolar amount of a coupler as shown in Table 4. The yellow coupler was optimally selected in view of the coupling speed of the magenta coupler. Thus prepared samples were exposed in accordance with exposure conditions of Sample 1-2 of Example 1 and continuously processed in the same manner as in Example 1, provided that exposure condition-4 was replaced by the following exposure condition-4'.

Exposure condition-4'

Each light sensitive material was exposed through an ND filter to white light for 0.5 sec.in a minimum amount giving a minimum value of black density after development by adjusting the density of the Nd filter.

In addition thereto, Sample 401 was exposed according to the following exposure conditions, processed according to afore-described process-1 and subjected to sensitometry by use of a densitometer type PDA-84 (produced by Konica) to determine the sensitivity of each silver halide emulsion layer.

Exposure condition-A

Sample 401 was exposed to white light through a red filter (Wratten No. 25) and optical wedge, for 0.5 sec. and then exposed, through ND filter, to a black light fluorescent lamp (produced by Toshiba) for 0.5 sec. in a minimum amount that gave the background a minimum red density after development processing by adjusting the density of the ND filter.

Exposure condition-B

Another Sample 401 was exposed to white light through a green filter (Wratten No. 58) and optical wedge, for 0.5 sec. and then exposed, through ND filter, to a black light fluorescent lamp (produced by Toshiba) for 0.5 sec. in a minimum amount that gave the background a minimum green density after development processing by adjusting the density of the ND filter.

Exposure condition-C

Further, another Sample 401 was exposed to white light through a blue filter (Wratten No. 47B) and optical wedge, for 0.5 sec. and then exposed, through ND filter, to a black light fluorescent lamp (produced by Toshiba) for 0.5 sec. in a minimum amount that gave the background a minimum blue density after processing by adjusting the density of the ND filter.

Exposure condition-D

Furthermore, another Sample 401 was exposed through an optical wedge to a black light fluorescent lamp (produced by Toshiba) and then exposed through a red filter (Wratten No. 25) and ND filter. The sample was further exposed through a green filter (Wratten No. 58) and ND filter and then exposed through a blue filter (Wratten No. 47B) and ND filter. Each exposure was made for 0.5 in a minimum amount that gave the background a minimum a minimum density after development processing by adjusting the density of the ND filter.

As a source of the white light was used a daylight fluorescent lamp.

When exposed in accordance with the condition-A, the sensitivity of the red-sensitive layer was set to be a relative value of 100. Sensitivities of other sensitive layers were as follows.

Green-sensitive layer: 12.2
Blue-sensitive layer: 9.1
UV-sensitive layer: 5.9

When exposed in accordance with the condition-B, the sensitivity of the green-sensitive layer was set to be a relative value of 100. Sensitivities of other sensitive layers were as follows.

Red-sensitive layer: 14.1
Blue-sensitive layer: 13.2
UV-sensitive layer: 7.6

When exposed in accordance with the condition-C, the sensitivity of the blue-sensitive layer was set to be a relative value of 100. Sensitivities of other sensitive layers were as follows.

Red-sensitive layer: 8.2
Green-sensitive layer: 11.5
UV-sensitive layer: 14.8

When exposed in accordance with the condition-D, the sensitivity of the UV-sensitive layer was set to be a relative value of 100. Sensitivities of other sensitive layers were as follows.

Red-sensitive layer: 5.1
Green-sensitive layer: 11.3
Blue-sensitive layer: 15.9

Using a halftone original having the 40% dot number of $90x10^3$/inch$^2$ and a halftone original having the 40% dot number of $645x10^3$/inch$^2$, the photographic material samples were exposed and processed with fresh solutions. Separately, exposed samples were subjected to continuous processing. Thus processed samples were visually evaluated through magnifier observation with respect to the dot quality and ranked by means of a 5-ranks method. Closeness of hue of a magenta monochromatic image to that of printing ink was also evaluated visually based on 5-ranks method. Results thereof are shown in Table 4.

Table 4

| Sample | Magenta coupler | $90\times10^3$ dots/inch$^2$ | | $645\times10^3$ dots/inch$^2$ | | Hue | |
|---|---|---|---|---|---|---|---|
| | | *1 | *2 | *1 | *2 | *1 | *2 |
| 401 | M-1 | 3 | 2 | 2 | 1 | 2 | 2 |

*1: Fresh solution processing
*2: Running-solution processing

Table 4 (continued)

| Sample | Magenta coupler | $90\times10^3$ dots/inch$^2$ | | $645\times10^3$ dots/inch$^2$ | | Hue | |
|---|---|---|---|---|---|---|---|
| | | *1 | *2 | *1 | *2 | *1 | *2 |
| 402 | MCP-1 | 4 | 4 | 4 | 3 | 3 | 3 |
| 403 | MCP-3 | 4 | 4 | 4 | 3 | 4 | 3 |
| 404 | MCP-5 | 4 | 4 | 4 | 4 | 3 | 3 |
| 405 | MCP-8 | 5 | 5 | 5 | 4 | 5 | 4 |
| 406 | MCP-9 | 4 | 4 | 4 | 4 | 4 | 3 |
| 407 | MCP-15 | 4 | 4 | 4 | 4 | 4 | 4 |
| 408 | MCP-17 | 4 | 4 | 4 | 3 | 5 | 4 |
| 409 | MCP-21 | 5 | 4 | 5 | 4 | 4 | 4 |
| 410 | MCP-24 | 5 | 5 | 5 | 5 | 5 | 5 |
| 411 | MCP-25 | 5 | 5 | 5 | 5 | 5 | 5 |
| 412 | MCP-29 | 5 | 4 | 4 | 4 | 4 | 3 |
| 413 | MCP-34 | 4 | 4 | 4 | 3 | 4 | 4 |
| 414 | MCP-37 | 4 | 3 | 3 | 3 | 3 | 3 |

*1: Fresh solution processing
*2: Running-solution processing

In the Table, the dot quality and closeness of hue each were e-relatively evaluated, based on the most excellent one ranking 5 and the poorest one, 1.

As can be seen from Table 1, color images of the inventive samples which were obtained using originals prepared by the FM screening methodwere excellent in dot quality and close to printing ink in hue. It was further shown that stable color images were obtained even when continuously development-processed.

Example 5

Preparation of infrared-sensitive silver halide emulsion

A infrared-sensitive emulsion Rm-IR was prepared in the same manner as a blue-sensitive emulsion, Em-B1, except that an emulsion Em-P1 was spectrally sensitized by adding a sensitizing dye (IRS-1).

IRS-1

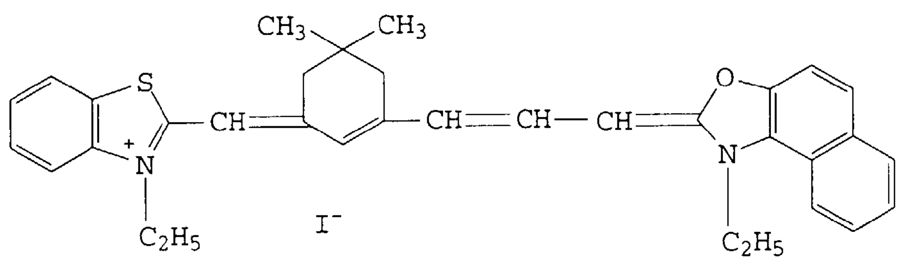

Using Em-IR and afore-described emulsions Em-B1, Em-G1 and Em-R1, the following photographic component layers were coated in a similar manner to Sample 401 of Example 4 to obtain sample 501.

| Layer | Constitution | Coating wt(g/$m^2$) |
|---|---|---|
| Layer 12 | Gelatin | 1.60 |
| (protective layer) | Silica matting agent | 0.01 |
| Layer 11 | Gelatin | 1.60 |
| (UV absorbing | UV absorbent (UV-1) | 0.35 |
| layer) | UV absorbent (UV-2) | 0.12 |
| | UV absorbent (UV-3) | 0.60 |

| | | |
|---|---|---|
| Layer 10 | Gelatin | 1.10 |
| (Blue-sensitive | Blue-sensitive emulsion (EM-B1) | 0.36 |
| layer) | Yellow coupler (Y-1) | 0.34 |
| | Restrainers (T-2, T-3)(mol ratio 1:1) | 0.0004 |
| | Antistaining agent (HQ-1) | 0.004 |
| | High boiling organic solvent (SO-1) | 0.27 |
| Layer 9 | Gelatin | 0.94 |
| (Inter-layer) | Anti-color-mixing agent (HQ-2 and HQ-3 in equal amount) | 0.02 |
| | High boiling organic solvent (SO-2) | 0.05 |
| | Anti-irradiation dye (AI-3) | 0.03 |
| Layer 8 | Gelatin | 0.45 |
| (Yellow filter | Yellow colloidal silver | 0.11 |
| layer) | Anti-color-mixing agent (HQ-1) | 0.03 |
| | High boiling organic solvent (SO-2) | 0.008 |
| | Polyvinyl pyrrolidone | 0.04 |
| Layer 7 | Gelatin | 0.45 |
| (Inter-layer) | Anti-color-mixing agent (HQ-2) | 0.014 |
| | Anti-color-mixing agent (HQ-3) | 0.014 |
| | High boiling organic solvent (SO-2) | 0.006 |
| Layer 6 | Gelatin | 1.25 |
| (Green-sensitive) | Green-sensitive emulsion (EM-G1) | 0.32 |

| | | |
|---|---|---|
| | Magenta coupler (M-1) | 0.22 |
| | Yellow coupler (Y-3) | 0.05 |
| | Antistain agent (HQ-1) | 0.035 |
| | Restrainers (T-2, T-3, mol ratio 1:1) | 0.00036 |
| | High boiling organic solvent (SO-1) | 0.33 |
| Layer 5 (Inter-layer) | Gelatin | 0.80 |
| | Anti-color-mixing agent (HQ-2) | 0.03 |
| | Anti-color-mixing agent (HQ-3) | 0.01 |
| | High boiling organic solvent (SO-2) | 0.007 |
| | Antiirradiation dye (AI-1) | 0.04 |
| Layer 4 (Red sensitive layer) | Gelatin | 0.90 |
| | Red-sensitive emulsion (EM-R1) | 0.27 |
| | Cyan coupler (C-1) | 0.27 |
| | Antistain agent (HQ-1) | 0.02 |
| | Restrainers (T-2, T-3, mol ratio 1:1) | 0.0002 |
| | High boiling organic solvent (SO-1) | 0.14 |
| Layer 3 (Inter-layer) | Gelatin | 0.80 |
| | Antistaining agent (HQ-2) | 0.03 |
| | Antistaining agent (HQ-3) | 0.01 |
| | High boiling organic solvent (SO-2) | 0.01 |

| | | |
|---|---|---|
| Layer 2 | Gelatin | 1.25 |
| (Infrared- | Infrared-sensitive emulsion (Em-IR) | 1.00 |
| sensitive layer) | Yellow coupler (Y-1) | 0.50 |
| | Magenta coupler (M-1) | 0.20 |
| | Cyan coupler (C-1) | 0.35 |
| | Antistaining agent (HQ-1) | 0.04 |
| | High boiling organic solvent (SO-1) | 2.00 |
| | Restrainers | |
| | (T-1, T-2, T-3, Mol ratio 1:1:1) | 0.005 |
| Layer 1 | Gelatin | 1.20 |
| (Antihalation | Antiirradiation dye (AI-2) | 0.055 |
| layer) | | |
| Layer 12 | Gelatin | 7.50 |
| (Back-side layer) | Silica matting agent | 0.65 |

Samples 502 to 510 were prepared in the same manner as Sample 501, except that a magenta coupler contained in Layer 6 was replaced by equimolar amount of a coupler as shown in Table 5. The yellow coupler was optimally selected in view of the coupling speed of the magenta coupler.

Thus prepared Samples 501 to 510 each were exposed to light according to the condition-1 of Example 1 through a cyan halftone original in close contact with the sample, then exposed according to the condition-2 of Example 1 through a magenta halftone original in close contact to the sample. The samples each further exposed according to the condition-3 of Example 1 through a yellow halftone original in close contact with the sample and then further exposed according to the condition-4 of Example 1 in close contact with the sample. The halftone originals used were the same ones as used in Example 1.

Preparation of a panchromatic silver halide emulsion

A panchromatic silver halide emulsion Em-K was prepared in the same manner as emulsion Em-B1, except that emulsion Em-P1 was spectrally sensitized by adding sensitizing dyes BS-1, GS-1, RS-1 and RS-2.

Using Em-K and afore-described emulsions Em-B1, Em-G1 and Em-R1, the following photographic component layers were coated in a similar manner to Sample 401 of Example 4 to obtain sample 551.

| Layer | Constitution | Coating wt(g/$m^2$) |
| --- | --- | --- |
| Layer 11 | Gelatin | 1.60 |
| (protective | Silica matting agent | 0.01 |
| layer) | | |
| Layer 10 | Gelatin | 1.60 |
| (UV absorbing | UV absorbent (UV-1) | 0.35 |
| layer) | UV absorbent (UV-2) | 0.12 |
| | UV absorbent (UV-3) | 0.60 |

| | | |
|---|---|---|
| Layer 9 | Gelatin | 1.10 |
| (Blue-sensitive | Blue-sensitive emulsion (EM-B1) | 0.36 |
| layer) | Yellow coupler (Y-1) | 0.34 |
| | Restrainers (T-2, T-3 mol ratio 1:1) | 0.0004 |
| | Antistaining agent (HQ-1) | 0.004 |
| | High boiling organic solvent (SO-1) | 0.27 |
| Layer 8 | Gelatin | 0.94 |
| (Inter-layer) | Anti-color-mixing agent | |
| | (HQ-2 and HQ-3)(in equal amount) | 0.02 |
| | High boiling organic solvent (SO-2) | 0.05 |
| | Anti-irradiation dye (AI-3) | 0.03 |
| Layer 7 | Gelatin | 0.45 |
| (Yellow filter | Yellow colloidal silver | 0.11 |
| layer) | Anti-color-mixing agent (HQ-1) | 0.03 |
| | High boiling organic solvent (SO-2) | 0.008 |
| | Polyvinyl pyrrolidone | 0.04 |
| Layer 6 | Gelatin | 0.45 |
| (Inter-layer) | Anti-color-mixing agent (HQ-2) | 0.014 |
| | Anti-color-mixing agent (HQ-3) | 0.014 |
| | High boiling organic solvent (SO-2) | 0.006 |
| Layer 5 | Gelatin | 1.25 |
| (Green-sensitive | Green-sensitive emulsion (EM-G1) | 0.32 |

| | | |
|---|---|---|
| | Panchromatic emulsion (Em-K) | 0.05 |
| | Magenta coupler (M-1) | 0.22 |
| | Yellow coupler (Y-3) | 0.05 |
| | Antistain agent (HQ-1) | 0.035 |
| | Restrainers (T-2, T-3, mol ratio 1:1) | 0.00036 |
| | High boiling organic solvent (SO-1) | 0.33 |
| Layer 4 | Gelatin | 0.80 |
| (Inter-layer) | Anti-color-mixing agent (HQ-2) | 0.03 |
| | Anti-color-mixing agent (HQ-3) | 0.01 |
| | High boiling organic solvent (SO-2) | 0.007 |
| | Antiirradiation dye (AI-1) | 0.04 |
| Layer 3 | Gelatin | 0.90 |
| (Red sensitive | Red-sensitive emulsion (EM-R1) | 0.27 |
| layer) | Panchromatic emulsion (Em-K) | 0.075 |
| | Cyan coupler (C-1) | 0.27 |
| | Antistain agent (HQ-1) | 0.02 |
| | Restrainers (T-2, T-3, mol ratio 1:1) | 0.0002 |
| | High boiling organic solvent (SO-1) | 0.14 |
| Layer 2 | Gelatin | 0.80 |
| (Inter-layer) | Antistaining agent (HQ-2) | 0.03 |
| | Antistaining agent (HQ-3) | 0.01 |

| | | |
|---|---|---|
| | High boiling organic solvent (SO-2) | 0.01 |
| Layer 1 (Antihalation layer) | Gelatin | 1.20 |
| | Antiirradiation dye (AI-2) | 0.055 |
| Layer 12 (Back-side layer) | Gelatin | 7.50 |
| | Silica matting agent | 0.65 |

Samples 552 to 558 were prepared in the same manner as Sample 501, except that a magenta coupler contained in Layer 6 was replaced by equimolar amount of a coupler as shown in Table 5. The yellow coupler was optimally selected in view of the coupling speed of the magenta coupler.

Thus prepared Samples 551 to 558 each were exposed in the same manner as in Sample 1-1 of Example 1

Exposed samples were processed with fresh processing solutions used in Example 1 according to the process-1. results thereof are shown in Table 5

In addition thereto, Sample 501 was exposed according to the following exposure conditions, processed according to afore-described process-1 and subjected to sensitometry by use of a densitometer type PDA-84 (produced by Konica) to determine the sensitivity of each silver halide emulsion layer.

Exposure condition-E

Sample 501 was exposed to white light through a red filter (Wratten No. 25) and optical wedge, for 0.5 sec. and then exposed, through a infrared filter and ND filter, to a xenon lamp for 0.5 sec. in a minimum amount that gave the background a minimum red density after development processing by adjusting the density of the ND filter.

Exposure condition-F

Another Sample 401 was exposed to white light through a green filter (Wratten No. 58) and optical wedge, for 0.5 sec. and then exposed, through a infrared filter and ND filter, to a xenon lamp for 0.5 sec. in a minimum amount that gave the background a minimum green density after development processing by adjusting the density of the ND filter.

Exposure condition-G

Further, another Sample 401 was exposed to white light through a blue filter (Wratten No. 47B) and optical wedge, for 0.5 sec. and then exposed, through a infrared filter and ND filter, to a xenon lamp for 0.5 sec. in a minimum amount that gave the background a minimum blue density after processing by adjusting the density of the ND filter.

Exposure condition-H

Furthermore, another Sample 401 was exposed through an optical wedge to a xenon lamp and then exposed through a red filter (Wratten No. 25) and ND filter. The sample was further exposed through a green filter (Wratten No. 58) and ND filter and then exposed through a blue filter (Wratten No. 47B) and ND filter. Each exposure was made for 0.5 in a minimum amount that gave the background a minimum a minimum density after development processing by adjusting the density of the ND filter.

As a source of the white light was used a daylight fluorescent lamp.

When exposed in accordance with the condition-A, the sensitivity of the red-sensitive layer was set to be a relative value of 100. Sensitivities of other sensitive layers were as follows.

Infrared-sensitive layer: 10.2

Green-sensitive layer: 12.9
Blue-sensitive layer: 9.1

When exposed in accordance with the condition-B, the sensitivity of the green-sensitive layer was set to be a relative value of 100. Sensitivities of other sensitive layers were as follows.

Infrared-sensitive layer: 6.4
Red-sensitive layer: 14.1
Blue-sensitive layer: 13.2

When exposed in accordance with the condition-C, the sensitivity of the blue-sensitive layer was set to be a relative value of 100. Sensitivities of other sensitive layers were as follows.

Infrared-sensitive layer: 5.8
Red-sensitive layer: 8.2
Green-sensitive layer: 11.5

When exposed in accordance with the condition-D, the sensitivity of the UV-sensitive layer was set to be a relative value of 100. Sensitivities of other sensitive layers were as follows.

Red-sensitive layer: 8.5
Green-sensitive layer: 5.0
Blue-sensitive layer: 3.4

Using a halftone original having the 40% dot number of $90x10^3$/inch$^2$ and a halftone original having the 40% dot number of $645x10^3$/inch$^2$, the photographic material samples were exposed and processed with fresh solutions. Separately, exposed samples were subjected to continuous processing. Thus processed samples were visually evaluated through magnifier observation with respect to the dot quality and ranked by means of a 5-ranks method. Closeness of hue of a magenta monochromatic image to that of printing ink was also evaluated visually based on 5-ranks method. Results thereof are shown in Table 5.

Table 5

| Sample | Magenta coupler | $90\times10^3$ dots/inch$^2$ | | $645\times10^3$ dots/inch$^2$ | | Hue | |
|---|---|---|---|---|---|---|---|
| | | *1 | *2 | *1 | *2 | *1 | *2 |
| 501 | M-1 | 3 | 2 | 2 | 1 | 2 | 2 |
| 551 | M-1 | 3 | 2 | 1 | 1 | 2 | 1 |
| 502 | MCP-8 | 5 | 5 | 5 | 5 | 4 | 4 |
| 552 | MCP-8 | 4 | 4 | 3 | 2 | 4 | 3 |
| 503 | MCP-11 | 4 | 4 | 4 | 4 | 4 | 4 |
| 553 | MCP-11 | 4 | 4 | 3 | 2 | 4 | 4 |
| 504 | MCP-21 | 5 | 4 | 5 | 4 | 4 | 4 |
| 554 | MCP-21 | 4 | 4 | 3 | 3 | 3 | 3 |
| 505 | MCP-24 | 5 | 5 | 5 | 5 | 5 | 4 |
| 555 | MCP-24 | 4 | 4 | 3 | 3 | 5 | 4 |
| 506 | MCP-25 | 5 | 5 | 5 | 5 | 5 | 4 |
| 556 | MCP-25 | 4 | 4 | 4 | 3 | 4 | 4 |
| 507 | MCP-32 | 4 | 4 | 4 | 3 | 4 | 3 |
| 557 | MCP-32 | 3 | 3 | 2 | 2 | 3 | 3 |
| 508 | MCP-39 | 5 | 4 | 5 | 4 | 4 | 4 |
| 558 | MCP-39 | 4 | 4 | 3 | 2 | 3 | 3 |

*1: Fresh solution processing
*2: Running-solution processing

In the Table, the dot quality and closeness of hue each were e-relatively evaluated, based on the most excellent one ranking 5 and the poorest one, 1.

As can be seen from Table 5, color images of the inventive samples which were obtained using originals prepared by the FM screening method were excellent in dot quality and close to printing ink in hue. It was further shown that stable color images were obtained even when continuously development-processed. Example 6

Samples 501 to 508 and 551 to 558 were subjected to exposure and processing and evaluated in the same manner as in Example 5, except that a developing agent, 4-amo=ino-3-methyl-N-ethyl-n-(β -methanesulfonamidoethyl)-aniline which was used in a developing solution and its replenisher was replaced by a exemplified compound D-2. Results thereof are summarized in Table 6.

Table 6

| Sample | Magenta coupler | $90\times10^3$ dots/inch$^2$ | | $645\times10^3$ dots/inch$^2$ | | Hue | |
|---|---|---|---|---|---|---|---|
| | | *1 | *2 | *1 | *2 | *1 | *2 |
| 501 | M-1 | 3 | 2 | 3 | 1 | 3 | 2 |
| 551 | M-1 | 3 | 2 | 1 | 1 | 3 | 2 |
| 502 | MCP-8 | 5 | 5 | 5 | 5 | 5 | 4 |
| 552 | MCP-8 | 5 | 4 | 3 | 3 | 4 | 3 |
| 503 | MCP-11 | 5 | 4 | 5 | 4 | 5 | 4 |
| 553 | MCP-11 | 4 | 4 | 3 | 3 | 4 | 4 |
| 504 | MCP-21 | 5 | 4 | 5 | 4 | 5 | 4 |
| 554 | MCP-21 | 5 | 4 | 3 | 3 | 4 | 4 |
| 505 | MCP-24 | 5 | 5 | 5 | 5 | 5 | 5 |
| 555 | MCP-24 | 4 | 4 | 3 | 3 | 5 | 4 |
| 506 | MCP-25 | 5 | 5 | 5 | 5 | 5 | 5 |
| 556 | MCP-25 | 4 | 4 | 4 | 3 | 5 | 4 |
| 507 | MCP-32 | 4 | 4 | 4 | 4 | 4 | 4 |
| 557 | MCP-32 | 3 | 3 | 2 | 2 | 4 | 3 |
| 508 | MCP-39 | 5 | 5 | 5 | 4 | 5 | 4 |
| 558 | MCP-39 | 4 | 4 | 3 | 3 | 4 | 4 |

*1: Fresh solution processing

*2: Running-solution processing

As can be seen from Table, color images of the inventive samples which were obtained using originals prepared by the FM screening method were excellent in dot quality and close to printing ink in hue. It was further shown that stable color images were obtained even when continuously development-processed.

## Claims

1. A silver halide color photographic light sensitive material for use in preparing color proofs by a process comprising

   exposing the photographic material based on halftone image information comprised of color-separated yellow image information, magenta image information, cyan image information and black image information and processing the exposed photographic material, in which at least a part of the halftone image information comprises a halftone image having the number of halftone dots of not less than $200x10^3$/inch$^2$ with a dot percentage of 40%,

   wherein said photographic material comprises a support having thereon a first layer containing a yellow image forming silver halide emulsion (Y-emulsion), a second layer containing a magenta image forming silver halide emulsion (M-emulsion) and a third layer containing a cyan image forming silver halide emulsion (C-emulsion), and a silver halide S-emulsion is contained in at least one of the first, second and third layers or another fourth layer to thereby form a black image upon exposure and processing, said Y-, M-, C-and S- emulsions having spectral sensitivity wavelength regions respectively different from one another and each of said Y, M, C and S emulsions having a spectral sensitivity region with a sensitivity at least six times higher than that of other three emulsions.

2. The silver halide photographic material of claim 1, wherein said S-emulsion is contained in said fourth layer to form a black image upon exposure and processing.

3. The silver halide photographic material of claim 1, wherein said S-emulsion is contained in each of the first, second and third layers to thereby form a black image.

4. The silver halide photographic material of claim 1, wherein said S-emulsion is contained in said fourth layer which is capable of forming a color image complementary to any one of yellow, magenta and cyan images.

5. The silver halide photographic material of claims 1 to 4 wherein each of said Y-, M-, C- and S-emulsions has a maximum spectral sensitivity at a wavelength different from that of the maximum spectral sensitivity of the other emulsions, a sensitivity at the wavelength ($\lambda$ max) of the maximum spectral sensitivity of any one of said Y-, M-, C- and S-emulsions being at least six times higher than that of the other emulsions at the wavelength ($\lambda$ max).

6. The silver halide photographic material of claims 1 to 5 wherein said second layer contains a magenta coupler represented by the following formula (M-I) or (M-II),

formula (M-I)

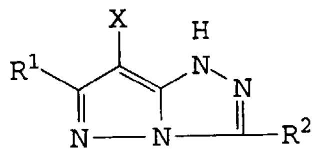

formula (M-II)

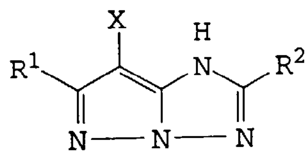

wherein $R^1$ and $R^2$ each are a hydrogen atom or a substituent; X is a group capable of being released upon reaction with an oxidation product of a developing agent

7. The silver halide photographic material of claims 1 to 6 wherein each of said Y-, M-, C- and S-emulsions comprises a previously-unfogged internal latent image silver halide emulsion.

8. A method for preparing color proofs comprising the steps of

(i) exposing imagewise a silver halide color photographic light sensitive material based on a halftone image information comprised of color-separated yellow image information, magenta image information, cyan image information and black image information and
(ii) processing the exposed photographic material, wherein at least a part of the halftone image information comprises a halftone image having the number of halftone dots of not less than $200x10^3/inch^2$ with a dot percentage of 40%;

said photographic material comprising a support having thereon a first layer containing a yellow image forming silver halide emulsion (Y-emulsion), a second layer containing a magenta image forming silver halide emulsion (M-emulsion) and a third layer containing a cyan image forming silver halide emulsion (C-emulsion), and a silver halide S-emulsion being contained in at least one of the first, second and third layers or another fourth layer to thereby form a black image upon exposure and processing, said Y-, M-, C-and S- emulsions having spectral sensitivity wavelength regions respectively different from one another and each of said Y, M, C and S emulsions having a spectral sensitivity region with a sensitivity at least six times higher than that of other three emulsions.

9. The method of claim 8, wherein said halftone image information is one prepared by means of frequency modulation.

10. The method of claim 8 or 9 wherein imagewise exposure is conducted by bringing a film having said halftone image

information into contact with said silver halide photographic material and causing a light source to scan.